# EUROPEAN PATENT APPLICATION

(11) **EP 4 575 640 A2**
(43) Date of publication of application: **25.06.2025**
(21) Application number: 24219289.6
(22) Date of filing: 12.12.2024
(51) Int. Cl.: G03F 7/09, G03F 7/40

(54) **COMPOUND FOR FORMING METAL-CONTAINING FILM, COMPOSITION FOR FORMING METAL-CONTAINING FILM, AND PATTERNING PROCESS**

(30) Priority: 22.12.2023 JP 2023216867
(71) Applicant: Shin-Etsu Chemical Co., Ltd., Tokyo 100-0005 (JP)
(72) Inventor: Iwamori, Shohei, Niigata (JP); Kobayashi, Naoki, Niigata (JP); Kori, Daisuke, Niigata (JP); Ishiwata, Kenta, Niigata (JP); Nagamachi, Nobuhiro, Niigata, Niigata (JP)
(74) Representative: Sonnenhauser, Thomas Martin

(57) **Abstract**

The present invention is a compound for forming a metal-containing film, represented by the following general formula (M), where T independently represents the following general formula (T-1) or (T-2); P independently represents *OCOR, "*" representing an attachment point to the Sn atom and R representing a monovalent organic group; Q independently represents an alkyl group, cycloalkyl group, aliphatic unsaturated hydrocarbon group, or alkoxy group of C1 to 20, an aryl group of C6 to 30, an arylalkyl group of C7 to 31, or a halogen atom; and "n₁", "n₂", and "n₃" represent an integer satisfying n₁≥1, n₂≥0, n₃≥1, and n₁+n₂+n₃=4. This can provide: a metal compound having excellent dry etching resistance and also having both high film-formability and a high tin content; a composition for forming a metal-containing film containing the compound; and a patterning process in which the composition is used as a resist underlayer film material.

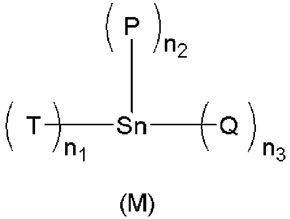

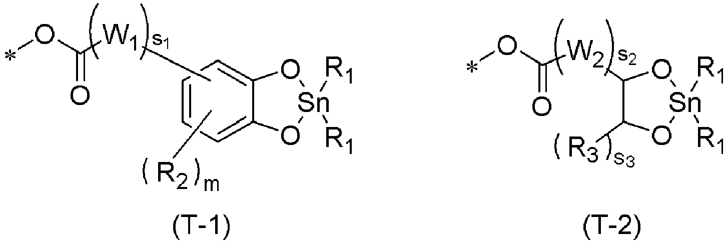

## Description

### TECHNICAL FIELD

The present invention relates to: a compound for forming a metal-containing film that can be used for fine patterning according to a multilayer resist method in a semiconductor device manufacturing process; a composition for forming a metal-containing film, containing the compound; and a patterning process using the composition.

### BACKGROUND ART

As LSIs advance toward higher integration and higher processing speed, miniaturization of pattern rule is progressing rapidly. As a cutting-edge technology for miniaturization, ArF immersion lithography has been adopted for mass-producing 45-nm node devices and smaller. In addition to ArF immersion exposure, double exposure (double patterning) processes have been put to practical use in generations of 28-nm node devices and smaller, so that the formation of narrow-pitch patterns that exceed the optical limit has also become possible.

Furthermore, in the production of 20-nm node and smaller devices, studies have been carried out on multiple exposure (multi-patterning) processes for forming a pattern with a narrower pitch by repeating exposure and etching three or more times. However, multiple exposure processes have an increased number of steps, and are faced with the situation that costs rise considerably due to degradation in productivity caused by longer time spent in manufacturing and more frequent generation of defects.

In recent years, extreme ultraviolet ray (EUV) lithography with a wavelength of 13.5 nm is attracting attention as an effective technology to replace a combination of ArF immersion lithography and multiple exposure process. By using this technology, it has become possible to form a fine pattern with a half pitch of 25 nm or less in one exposure.

Meanwhile, in EUV lithography, resist materials are strongly required to have higher sensitivity to compensate for insufficient output of a light source. However, increase in shot noise accompanying higher sensitization leads to increase in edge roughness (LER and LWR) of line patterns, and compatibility of higher sensitization and low edge roughness is given as an important problem in EUV lithography.

As an attempt to achieve higher sensitivity of a resist or to lower the influence of shot noise, it has been considered in recent years to use a metal material in a resist material. A compound that contains a metallic element, such as barium, titanium, hafnium, zirconium, or tin, has a higher absorbance of EUV light compared to an organic material that does not contain metal, and improvement of photosensitivity of resists and suppression of the influence of shot noise can be expected. Furthermore, a metal-containing resist pattern is expected to achieve a high-selectivity etching process by combining with an underlayer film made from a non-metal material.

For example, resist materials with added metal salt or organometallic complex disclosed in Patent Documents 1 and 2 or non-chemically amplified resist materials that use nanoparticles of metal oxide disclosed in Patent Documents 3 and 4 are considered.

In particular, molecules containing tin are excellent in the absorption of an electron beam and an extreme ultraviolet ray, and are actively researched. In the case of an organotin polymer, which is one such molecule, alkyl ligand is dissociated by light absorption or secondary electrons produced thereby and a resultant is crosslinked with adjacent chains through an oxo bond, and thus this enables the negative tone patterning which may not be removed by an organic developing solution. This organic tin polymer can improve sensitivity while maintaining a resolution and line edge roughness, but has not yet reached the standards for commercial availability (Patent Document 5). In addition, many problems still remain, such as insufficient storage stability regarding change in resist sensitivity.

To solve the problems, there is also consideration of development of the use of a material containing a metal element, such as titanium, hafnium, zirconium, and tin, for a resist underlayer film. There is no need for the improvement for performance, such as the enhancement of exposure sensitivity and the suppression of change in sensitivity in storage environment, which is an issue in resist materials containing metal. In addition, it may be possible to provide a resist underlayer film excellent in dry etching resistance when the metal element is contained. Patent Document 7 reports that a material containing a Ti compound exhibits excellent dry etching resistance to CHF₃/CF₄-based gas and CO₂/N₂-based gas.

On the other hand, film-formability and filling property are problems when using a metal compound for a resist underlayer film. For example, in compounds expected to be used in photoresists as in Patent Document 6, there is no mention of heat resistance, but since baking at a high temperature is not expected, there is a risk of insufficient heat resistance, causing filling and film-formability failure. Although there is no mention of film-formability or filling property in Patent Document 7, a metal oxide compound generally undergoes great thermal shrinkage during baking and induces remarkable degradation of filling after baking at a high temperature. Therefore, there is a concern that such a compound is insufficient as a resist underlayer film material for which heat resistance, such as film-formability and filling property, is required. Patent Document 8 reports that a metal compound modified with a particular ligand has excellent filling property. However, the baking temperature in the performed filling property evaluation is a low temperature of 150°C, and there is a concern that the compound is insufficient as a resist underlayer film, which requires heat resistance (for example, resistance to a heat treatment that is performed after the formation of a resist underlayer film in some cases). Patent Document 9 provides a resist underlayer film material excellent in filling property after baking at 400°C by mixing the metal compound reported in Patent Document 8 and an organic polymer having a particular structure. However, since the material is a mixed composition of a metal compound which is inorganic and a polymer which is organic, there are concerns for film formation defects, degradation of storage stability, degradation of dry etching resistance, etc. caused by compatibility failure.

### CITATION LIST

### PATENT LITERATURE

Patent Document 1: JP5708521B2
Patent Document 2: JP5708522B2
Patent Document 3: US9310684B2
Patent Document 4: US2017/0102612A1
Patent Document 5: JP2021-162865A
Patent Document 6: JP7028940B2
Patent Document 7: JP6189758B2
Patent Document 8: JP7050137B2
Patent Document 9: JP2022-521531A

### SUMMARY OF INVENTION

### TECHNICAL PROBLEM

The present invention has been made in view of the above-described circumstances. An object of the present invention is to provide: a compound for forming a metal-containing film having better dry etching resistance than conventional organic underlayer film materials and also having both high film-formability and a high tin content; a composition for forming a metal-containing film containing the compound; and a patterning process in which the composition is used as a resist underlayer film material.

### SOLUTION TO PROBLEM

To achieve the object, the present invention provides a compound for forming a metal-containing film, represented by the following general formula (M), 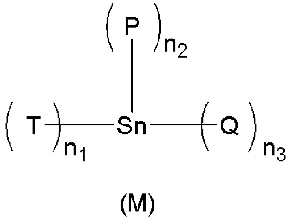 wherein T independently represents the following general formula (T-1) or (T-2); P independently represents *OCOR, "*" representing an attachment point to the Sn atom and R representing a monovalent organic group; Q independently represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, a halogen atom, or an alkoxy group having 1 to 20 carbon atoms; and "n₁", "n₂", and "n₃" each represent an integer that satisfy n₁ ≥ 1, n₂ ≥ 0, n₃ ≥ 1, and n₁ + n₂ + n₃ = 4, when n₁ ≥ 2, the Ts being identical to or different from each other, when n₂ = 2, the Ps being identical to or different from each other, and when n₃ ≥ 2, the Qs being identical to or different from each other, 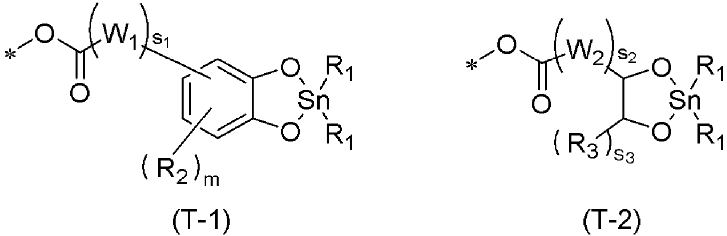 wherein R₁ represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, or a substituted or unsubstituted arylalkyl group having 7 to 31 carbon atoms; "*" represents an attachment point to the Sn atom in the general formula (M); W₁ represents a substituted or unsubstituted, linear, branched, or cyclic, saturated or unsaturated hydrocarbon group, optionally including an aromatic ring group, having 1 to 40 carbon atoms, the hydrocarbon group optionally containing any heteroatom of an oxygen atom, a nitrogen atom, or a sulfur atom, and forming an ether bond, a carbonyl group, an ester group, or an amide group, and optionally forming a heterocyclic structure via the heteroatom; R₂ represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a hydroxy group, an amino group, or a halogen atom; "s₁" represents an integer of 0 or 1; "m" represents an integer of 0 or 1; W₂ represents a substituted or unsubstituted, linear, branched, or cyclic, saturated or unsaturated hydrocarbon group, optionally including an aromatic ring group, having 1 to 40 carbon atoms, the hydrocarbon group optionally containing any heteroatom of an oxygen atom, a nitrogen atom, or a sulfur atom, and forming an ether bond, a carbonyl group, an ester group, or an amide group, and optionally forming a heterocyclic structure via the heteroatom; "s₂" represents an integer of 0 or 1; "s₃" represents 1 or 2, when "s₃" is 1, R₃ being a hydrogen atom or a hydrocarbon group having 1 to 10 carbon atoms and having a hydroxy group, and when "s₃" is 2, the R₃ being an oxygen atom forming a carbonyl group together with the carbon atom bonded thereto; and the W₂ and the R₃ are optionally bonded to each other to form a cyclic structure.

Such a compound containing tin generates radicals due to radical cleavage of Sn-alkyl bonds, and therefore, a crosslinking reaction caused by the radicals occurs. In addition, since tin is bonded to the unit (T), having a catechol or a diol, multiple tin atoms can be introduced per molecule, and therefore, the tin content can be increased. Furthermore, in the general formula (M), when "n₂" is 1 or when "n₁" is 2 and the Ts are different, the symmetry of the molecule is broken, and thus, solvent solubility can be enhanced. Therefore, the inventive compound is excellent in solvent solubility, is suitable for a composition for forming a metal film, and makes it possible to form a film having a high tin content when used for a resist underlayer film.

In the above-described compound, it is preferable that (i) the W₁ in the general formula (T-1) is: a linear, branched, or cyclic, saturated or unsaturated hydrocarbon group having 1 to 10 carbon atoms and optionally containing a hydroxy group or an amino group, optionally the hydrocarbon group including an aromatic ring group, the hydrocarbon group optionally containing an oxygen atom, a nitrogen atom, or a sulfur atom and forming an ether bond, a carbonyl group, or an ester group; or any one of groups represented by the following general formulae (W₁-1) to (W₁-4), 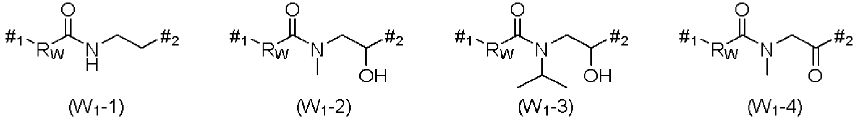 wherein R_{W} represents a divalent organic group having 1 to 23 carbon atoms, "#₁" represents an attachment point to the ester group, and "#₂" represents an attachment point to the benzene ring.

In the above-described compound, it is also preferable that (ii) the W₂ in the general formula (T-2) is: a linear, branched, or cyclic, saturated or unsaturated hydrocarbon group having 1 to 10 carbon atoms and optionally containing a hydroxy group or an amino group, optionally the hydrocarbon group including an aromatic ring group, or a cyclic hydrocarbon group bonded to the R₃, the hydrocarbon group optionally containing an oxygen atom, a nitrogen atom, or a sulfur atom and forming an ether bond, a carbonyl group, or an ester group; or any one of groups represented by the following general formulae (W₂-1) to (W₂-4), 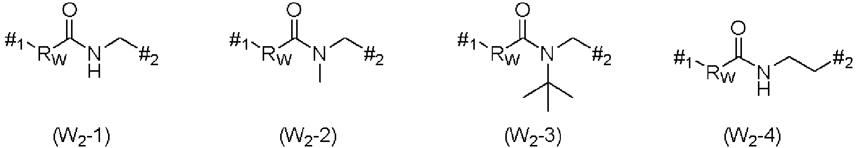 wherein R_{W} represents a divalent organic group having 1 to 23 carbon atoms, and "#₁" and "#₂" respectively represent an attachment point to the ester group and the carbon atom.

When the W₁ in the general formula (T-1) and/or the W₂ in (T-2) have the above-described structures, the proportion of organic groups can be suppressed, and the tin content can be increased.

Furthermore, it is preferable that the R_{W} in the general formulae (W₁-1) to (W₁-4) of the above (i) and/or the general formulae (W₂-1) to (W₂-4) of the above (ii) is an unsaturated hydrocarbon group having 2 to 23 carbon atoms.

When the R_{W} in the general formulae (W₁-1) to (W₁-4) and (W₂-1) to (W₂-4) is an unsaturated hydrocarbon group having 2 to 23 carbon atoms, the thermosetting property of the compound can be further enhanced.

Furthermore, in the present invention, the R_{W} in the general formulae (W₁-1) to (W₁-4) of the above (i) and/or the general formulae (W₂-1) to (W₂-4) of the above (ii) can be a group represented by any one of the following general formulae (1), 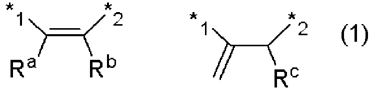 wherein R^{a}, R^{b}, and R^{C} each represent a hydrogen atom or a monovalent organic group having 1 to 20 carbon atoms, R^{a} and R^{b} optionally being bonded to each other to form a cyclic substituent; and "*1" and "*2" each represent an attachment point to the carbonyl group, "*1" and "*2" optionally being reversed.

When the R_{W} in the general formulae (W₁-1) to (W₁-4) and (W₂-1) to (W₂-4) is a group represented by one of the general formulae (1), it is possible to achieve both thermosetting property and a high tin content, and when this is adopted for a composition for forming a metal-containing film, it is possible to provide a resist underlayer film material that exhibits better film-formability and a high tin content.

Furthermore, in the general formula (M), it is preferable that "n₂" is 1 and the R in the *OCOR of the P is any one of groups represented by the following general formulae (A-1) to (A-4), the following general formula (3), and the following general formula (4), 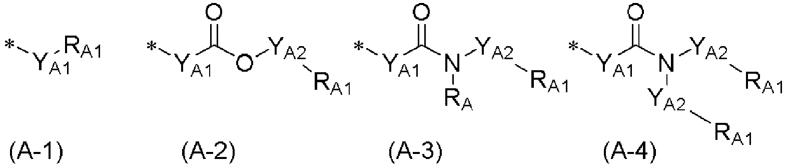 wherein Y_{A1} and Y_{A2} are each identical to or different from each other and represent a substituted or unsubstituted saturated divalent organic group having 1 to 23 carbon atoms, a substituted or unsubstituted unsaturated divalent organic group having 2 to 23 carbon atoms, a substituted or unsubstituted arylene group having 6 to 30 carbon atoms, or a substituted or unsubstituted arylalkylene group having 7 to 31 carbon atoms; R_{A} represents a hydrogen atom, a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms; R_{A1} represents an organic group whose protecting group is to be removed by an action of an acid, heat, or both to generate one or more hydroxy groups or carboxy groups, R_{A1} being represented by one of the following general formulae (2); and "*" represents an attachment point to the carbonyl group, 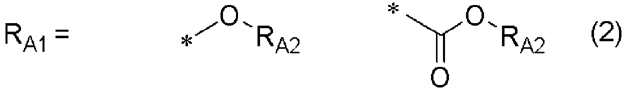 wherein R_{A2} represents an organic group whose protecting group is to be removed by an action of an acid, heat, or both; and "*" represents an attachment point to Y_{A1} or Y_{A2}, 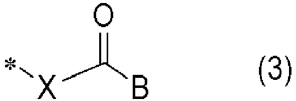 wherein X represents a divalent organic group having 1 to 31 carbon atoms; B represents the following general formula (B); and "*" represents an attachment point to the carbonyl group, 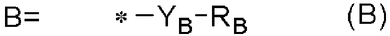 wherein Y_{B} represents a substituted or unsubstituted saturated divalent organic group having 1 to 20 carbon atoms, a substituted or unsubstituted unsaturated divalent organic group having 2 to 20 carbon atoms, a substituted or unsubstituted divalent arylene group having 6 to 30 carbon atoms, or a substituted or unsubstituted divalent arylalkylene group having 7 to 31 carbon atoms; R_{B} represents a hydroxy group or any one of structures represented by the following general formulae (B-1) to (B-3), 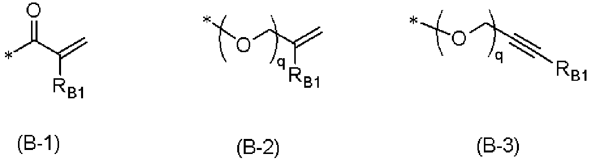 wherein R_{B1} represents a hydrogen atom or a monovalent organic group having 1 to 10 carbon atoms; "q" represents 0 or 1; and "*" represents an attachment point to Y_{B}, 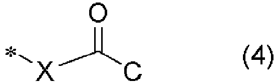 wherein X represents a divalent organic group having 1 to 31 carbon atoms; C represents any one of groups represented by the following general formulae (C-1) to (C-4); and "*" represents an attachment point to the carbonyl group, 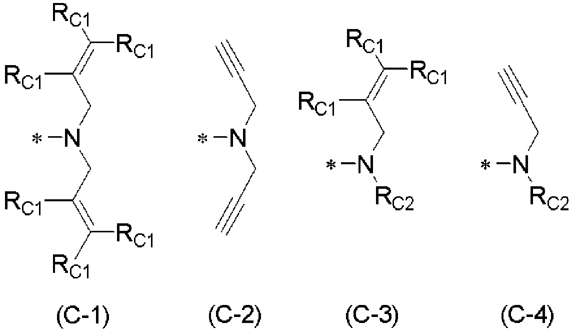 wherein R_{C1} s independently each represent a hydrogen atom or a methyl group and are identical to or different from each other in a single formula; R_{C2} represents a hydrogen atom, a substituted or unsubstituted, saturated or unsaturated monovalent organic group, such as an aliphatic hydrocarbon group, having 1 to 20 carbon atoms, a substituted or unsubstituted aryl group having 6 to 30 carbon atoms, a substituted or unsubstituted arylalkyl group having 7 to 31 carbon atoms; and "*" represents an attachment point to the carbonyl group.

When the R has a structure represented by one of the general formulae (A-1) to (A-4), an organic group whose bulky protecting group is to be removed by the action of an acid, heat, or both is contained in the structure, and therefore, the solvent solubility of the compound can be enhanced. Furthermore, when the compound is contained in a composition for forming a metal-containing film, the protecting groups are eliminated during baking, so that hydroxy groups and carboxy groups are generated. The OH or the α-hydrogen of a carboxylic acid generated in this manner react easily with radicals that are generated by the cleavage of tin-carbon bonds when baking is performed, and causes a crosslinking reaction. Therefore, the inventive compound has excellent thermosetting property, and can suppress volume shrinkage, which causes degradation of film-formability and filling property. Furthermore, it is possible to provide a resist underlayer film material excellent in film-formability and filling property even in high-temperature baking.

Meanwhile, when the R has the structure represented by the general formula (3), a hydroxy group or a crosslinking group of one of the structures represented by the general formulae (B-1) to (B-3) is included at an end. Therefore, when the compound is contained in a composition for forming a metal-containing film, not only a crosslinking reaction between radicals and radicals generated by the cleavage of tin-carbon bonds but also a reaction between radicals and crosslinking groups and a reaction between crosslinking groups occurs when baking is performed, and a further crosslinking reaction occurs. Thus, it is possible to provide a resist underlayer film material that has excellent thermosetting property, can suppress volume shrinkage, which causes the degradation of film-formability and filling property, and has excellent film-formability and filling property even after high-temperature baking.

Meanwhile, when the R has the structure represented by the general formula (4), one of the structures represented by (C-1) to (C-4) is included on an end, and the structure has a high crosslinking-group density and excellent thermosetting property. Therefore, when the compound is contained in a composition for forming a metal-containing film, volume shrinkage at the time of baking is low, and it is possible to provide a resist underlayer film material excellent in film-formability and filling property even after high-temperature baking.

It is preferable that the Y_{A1} in the general formulae (A-1) to (A-4), the X in the general formula (3), or the X in the general formula (4) is an unsaturated hydrocarbon group having 2 to 23 carbon atoms.

When the Y_{A1} in the general formulae (A-1) to (A-4), the X in the general formula (3), or the X in the general formula (4) is an unsaturated hydrocarbon group having 2 to 23 carbon atoms, the thermosetting property of the compound for forming a metal-containing film can be further improved.

In this case, the Y_{A1} in the general formulae (A-1) to (A-4), the X in the general formula (3), or the X in the general formula (4) may be a group represented by one of the following general formulae (1), 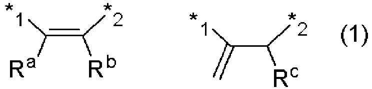 wherein R^{a}, R^{b}, and R^{C} each represent a hydrogen atom or a monovalent organic group having 1 to 20 carbon atoms, R^{a} and R^{b} optionally being bonded to each other to form a cyclic substituent; and "*1" and "*2" each represent an attachment point to the carbonyl group, "*1" and "*2" optionally being reversed.

When the Y_{A1} in the general formulae (A-1) to (A-4), the X in the general formula (3), or the X in the general formula (4) is a group represented by one of the following general formulae (1), it is possible to enhance the thermosetting property, and when the compound is contained in a composition for forming a metal-containing film, it is possible to provide a resist underlayer film material that exhibits better film-formability.

Furthermore, the present invention can provide a composition for forming a metal-containing film, the composition functioning as a resist underlayer film material used in manufacturing a semiconductor, the composition comprising: (a) the above-described compound for forming a metal-containing film; and (b) an organic solvent.

Such a composition for forming a metal-containing film contains an organotin compound excellent in solvent solubility and heat resistance, and therefore, makes it possible to provide a resist underlayer film material that has better dry etching resistance than conventional organic underlayer film materials and also has high film-formability.

The composition is usable as a resist underlayer film used in a multilayer resist method, and the composition can further comprise one or more of (c) a crosslinking agent, (d) a surfactant, (e) a flowability accelerator, and (f) an acid generator.

Furthermore, the organic solvent (b) is preferably a mixture of one or more kinds of organic solvent having a boiling point of lower than 180°C and one or more kinds of organic solvent having a boiling point of 180°C or higher.

When the above-described compound for forming a metal-containing film is provided with thermal flowability by the high-boiling-point solvent being contained, the planarizing property of a composition for forming a resist underlayer film can be further improved.

In addition, the present invention provides a patterning process for forming a pattern in a substrate to be processed, comprising the steps of:
(I-1) applying the inventive composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The patterning process by way of the two-layer resist process makes it possible to form fine patterns on the body to be processed (substrate to be processed).

The present invention also provides a patterning process for forming a pattern in a substrate to be processed, comprising the steps of:
(II-1) applying the inventive composition for forming a metal-containing film onto a substrate to be processed, followed by heating to form a metal-containing film;
(II-2) forming a resist middle layer film on the metal-containing film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal-containing film by dry etching while using the resist middle layer film having the transferred pattern as a mask; and
(II-7) processing the substrate to be processed while using the metal-containing film having the formed pattern as a mask to form the pattern in the substrate to be processed.

The patterning process by way of the three-layer resist process makes it possible to form fine patterns on the body to be processed with high accuracy.

The present invention also provides a patterning process for forming a pattern in a substrate to be processed, comprising the steps of:
(III-1) applying the inventive composition for forming a metal-containing film onto a substrate to be processed, followed by heating to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

The patterning process by way of the four-layer resist process makes it possible to form fine patterns on the body to be processed with high accuracy.

In this case, the inorganic hard mask middle layer film is preferably formed by a CVD method or an ALD method.

When the inorganic hard mask is formed by a CVD method or an ALD method, a fine pattern can be formed on a body to be processed with higher accuracy.

The present invention also provides a patterning process for forming a pattern in a substrate to be processed, comprising the steps of:
(IV-1) forming a resist underlayer film on a substrate to be processed;
(IV-2) applying the inventive composition for forming a metal-containing film onto the resist underlayer film, followed by heating to form a metal-containing film;
(IV-3) forming a resist upper layer film on the metal-containing film by using a photoresist material or forming an organic adhesive film on the metal-containing film by spin-coating and forming a resist upper layer film on the organic adhesive film by using a photoresist material;
(IV-4) subjecting the resist upper layer film to pattern exposure and then development with a developer to form a pattern in the resist upper layer film;
(IV-5) transferring the pattern to the metal-containing film or the organic adhesive film and the metal-containing film by dry etching while using the resist upper layer film having the formed pattern as a mask;
(IV-6) transferring the pattern to the resist underlayer film by dry etching while using the metal-containing film having the transferred pattern as a mask; and
(IV-7) processing the substrate to be processed while using the resist underlayer film having the formed pattern as a mask to form the pattern in the substrate to be processed.

The patterning process by way of the multilayer resist process makes it possible to form fine patterns on the body to be processed with high accuracy.

The present invention also provides a patterning process for forming a pattern in a substrate to be processed, comprising the steps of:
(V-1) forming a resist underlayer film on a substrate to be processed;
(V-2) forming a resist middle layer film or a combination of an organic thin film and an inorganic hard mask middle layer film selected from a silicon oxide film, a silicon nitride film, and a silicon oxynitride film on the resist underlayer film;
(V-3) forming a resist upper layer film on the resist middle layer film or the combination of the organic thin film and the inorganic hard mask middle layer film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the inventive composition for forming a metal-containing film onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing, by dry etching, the resist underlayer film having the formed pattern with an exposed surface to form a reverse pattern of an original pattern on the metal-containing film; and
(V-11) processing the substrate to be processed while using the metal-containing film having the formed reverse pattern as a mask to form the reverse pattern in the substrate to be processed.

The patterning process by way of the reverse process makes it possible to form fine patterns on the body to be processed with even higher accuracy.

In this case, too, the inorganic hard mask middle layer film is preferably formed by a CVD method or an ALD method.

When the inorganic hard mask is formed by a CVD method or an ALD method, a fine pattern can be formed on a body to be processed with higher accuracy.

### ADVANTAGEOUS EFFECTS OF INVENTION

As described above, the inventive compound for forming a metal-containing film is a compound represented by the general formula (M), and therefore, radicals are generated by radical cleavage of Sn-alkyl bonds during baking, and a crosslinking reaction caused by the radicals occurs. In addition, since a tin atom is bonded to the unit having a catechol or a diol, multiple tin atoms can be introduced to one molecule, and therefore, the proportion of tin contained can be enhanced. Furthermore, in the general formula (M), when "n₂" is 1 or when "n₁" is 2 and the Ts are different from each other, the symmetry of the molecule is broken, and thus, solvent solubility can be enhanced. Therefore, a composition containing the inventive compound is excellent in solvent solubility and makes it possible to provide a resist underlayer film material having a high tin content.

In particular, in a fine patterning process using a multilayer resist method in a semiconductor device manufacturing process, filling is possible without causing defects such as voids and peeling even on a substrate to be processed having a portion that is difficult to fill and planarize, such as a dense portion of a fine pattern structure having a high aspect ratio exemplified by increasingly miniaturized DRAM. In addition, the inventive compound has better dry etching resistance than conventional coating-type organic resist underlayer film materials, and therefore, a fine pattern can be formed on a body to be processed with even higher precision compared with an organic resist underlayer film.

A composition for forming a metal-containing film containing the inventive compound for forming a metal-containing film contains a tin atom, which has high EUV light absorbance, and therefore, has a sensitizing effect caused by secondary electrons generated from the tin atom during exposure. Furthermore, tin atoms have a great atomic weight, and therefore, have a high effect of suppressing the diffusion of acid from an upper layer resist to a resist underlayer film, and have a characteristic that higher sensitivity can be achieved while sustaining the LWR performance that the resist upper layer film originally has.

### BRIEF DESCRIPTION OF DRAWINGS

FIG. 1 is an explanatory view of an example (three-layer resist process) of the patterning process of the present invention.
FIG. 2 is an explanatory view of an example (forming reverse SOC pattern of a three-layer resist process) of the tone-reversal patterning process of the present invention.
FIG. 3 is an explanatory view of a method for evaluating filling property.

### DESCRIPTION OF EMBODIMENTS

As stated above, there have been demands for the development of: a composition for forming a metal-containing film, excellent in film-formability, used for forming a resist underlayer film that makes it possible to transfer a resist pattern to a substrate to be processed with higher precision in a fine patterning process according to a multilayer resist method; and a compound for forming a metal-containing film useful for the composition.

The present inventors have focused on organotin compounds, which are expected to play an active role in the EUV-exposure generation, and studied earnestly. As stated above, tin atoms, which greatly absorb EUV light, have a sensitizing effect due to secondary electrons generated from the atoms during exposure, and have a characteristic that higher sensitivity can be achieved while maintaining the LWR performance that a resist upper layer film originally has. On the other hand, organotin compounds, which are considered as resist upper layer films, have poor heat resistance, and undergo rapid volume shrinkage during baking. Therefore, it is difficult to achieve a uniform film and fill the steps of a substrate to be processed at the time of high-temperature baking. The present inventors have considered that when a reaction is allowed to take place between a tin compound and an organic molecule having a diol structure (including a catechol) and a carboxylate in a molecule, the molecular weight can be increased while introducing multiple tin atoms into a molecule, so that it is highly probable that a sufficient molecular weight can be sustained even if bonds are cleaved during baking, sublimation products can be suppressed, heat resistance can be improved, and excellent film-formability can be exhibited. Furthermore, the present inventors have considered that, since multiple tin atoms can be introduced per molecule, it is possible to enhance not only heat resistance but also tin content, and a composition for forming a metal-containing film that exhibits excellent etching resistance can be achieved.

Accordingly, the present inventors have further studied earnestly and found out that a compound for forming a metal-containing film represented by the general formula (M) has excellent film-formability and also has an increased tin content, and therefore, has excellent etching resistance. Thus, the present invention has been completed.

That is, the present invention is a compound for forming a metal-containing film that can be contained in a composition for forming a metal-containing film that serves as a resist underlayer film material used in semiconductor manufacture, the compound being represented by the following general formula (M), 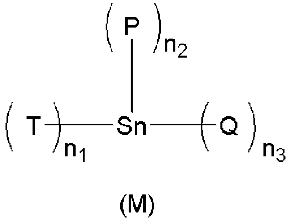 wherein T independently represents the following general formula (T-1) or (T-2); P independently represents *OCOR, "*" representing an attachment point to the Sn atom and R representing a monovalent organic group; Q independently represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, a halogen atom, or an alkoxy group having 1 to 20 carbon atoms; and "n₁", "n₂", and "n₃" each represent an integer that satisfy n₁ ≥ 1, n₂ ≥ 0, n₃ ≥ 1, and n₁ + n₂ + n₃ = 4, when n₁ ≥ 2, the Ts being identical to or different from each other, when n₂ = 2, the Ps being identical to or different from each other, and when n₃ ≥ 2, the Qs being identical to or different from each other, 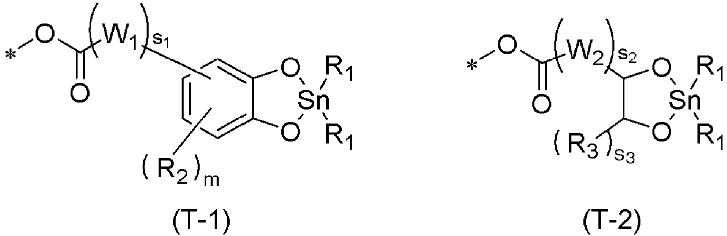 wherein R₁ represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, or a substituted or unsubstituted arylalkyl group having 7 to 31 carbon atoms; "*" represents an attachment point to the Sn atom in the general formula (M); W₁ represents a substituted or unsubstituted, linear, branched, or cyclic, saturated or unsaturated hydrocarbon group, optionally including an aromatic ring group, having 1 to 40 carbon atoms, the hydrocarbon group optionally containing any heteroatom of an oxygen atom, a nitrogen atom, or a sulfur atom, and forming an ether bond, a carbonyl group, an ester group, or an amide group, and optionally forming a heterocyclic structure via the heteroatom; R₂ represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a hydroxy group, an amino group, or a halogen atom; "s₁" represents an integer of 0 or 1; "m" represents an integer of 0 or 1; W₂ represents a substituted or unsubstituted, linear, branched, or cyclic, saturated or unsaturated hydrocarbon group, optionally including an aromatic ring group, having 1 to 40 carbon atoms, the hydrocarbon group optionally containing any heteroatom of an oxygen atom, a nitrogen atom, or a sulfur atom, and forming an ether bond, a carbonyl group, an ester group, or an amide group, and optionally forming a heterocyclic structure via the heteroatom; "s₂" represents an integer of 0 or 1; "s₃" represents 1 or 2, when "s₃" is 1, R₃ being a hydrogen atom or a hydrocarbon group having 1 to 10 carbon atoms and having a hydroxy group, and when "s₃" is 2, the R₃ being an oxygen atom forming a carbonyl group together with the carbon atom bonded thereto; and the W₂ and the R₃ are optionally bonded to each other to form a cyclic structure.

Hereinafter, the present invention will be described in detail, but the present invention is not limited thereto. Note that, although catechol (1,2-benzenediol) is included in diols, in the present description, compounds having a 1,2-benzenediol structure are called catechols, and other diols are simply called "diols" in some cases. The recitations of numerical ranges by endpoints include all numbers subsumed within that range.

### <Compound for Forming Metal-Containing Film>

The inventive compound for forming a metal-containing film is represented by the following general formula (M). The compound can be contained in a composition for forming a metal-containing film that serves as a resist underlayer film material used in semiconductor manufacture.

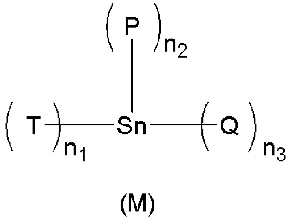

In the general formula (M), T independently represents the following general formula (T-1) or (T-2); P independently represents *OCOR, "*" representing an attachment point to the Sn atom and R representing a monovalent organic group; Q independently represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, a halogen atom, or an alkoxy group having 1 to 20 carbon atoms; and "n₁", "n₂", and "n₃" each represent an integer that satisfy n₁ ≥ 1, n₂ ≥ 0, n₃ ≥ 1, and n₁ + n₂ + n₃ = 4, when n₁ ≥ 2, the Ts being identical to or different from each other, when n₂ = 2, the Ps being identical to or different from each other, and when n₃ ≥ 2, the Qs being identical to or different from each other.

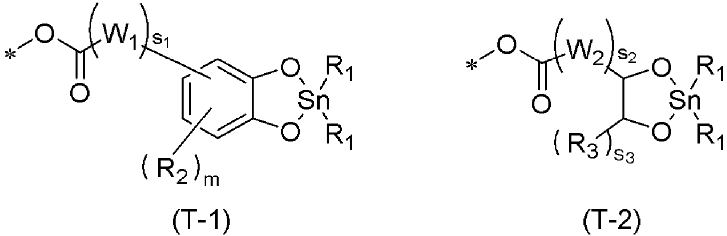

In the general formulae (T-1) and (T-2), R₁ represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, or a substituted or unsubstituted arylalkyl group having 7 to 31 carbon atoms; "*" represents an attachment point to the Sn atom in the general formula (M); W₁ represents a substituted or unsubstituted, linear, branched, or cyclic, saturated or unsaturated hydrocarbon group, optionally including an aromatic ring group, having 1 to 40 carbon atoms, the hydrocarbon group optionally containing any heteroatom of an oxygen atom, a nitrogen atom, or a sulfur atom, and forming an ether bond, a carbonyl group, an ester group, or an amide group, and optionally forming a heterocyclic structure via the heteroatom; R₂ represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a hydroxy group, an amino group, or a halogen atom; "s₁" represents an integer of 0 or 1; "m" represents an integer of 0 or 1; W₂ represents a substituted or unsubstituted, linear, branched, or cyclic, saturated or unsaturated hydrocarbon group, optionally including an aromatic ring group, having 1 to 40 carbon atoms, the hydrocarbon group optionally containing any heteroatom of an oxygen atom, a nitrogen atom, or a sulfur atom, and forming an ether bond, a carbonyl group, an ester group, or an amide group, and optionally forming a heterocyclic structure via the heteroatom; "s₂" represents an integer of 0 or 1; "s₃" represents 1 or 2, when "s₃" is 1, R₃ being a hydrogen atom or a hydrocarbon group having 1 to 10 carbon atoms and having a hydroxy group, and when "s₃" is 2, the R₃ being an oxygen atom forming a carbonyl group together with the carbon atom bonded thereto; and the W₂ and the R₃ are optionally bonded to each other to form a cyclic structure.

In the general formula (M), P independently represents *OCOR, "*" representing an attachment point to the Sn atom and R representing a monovalent organic group. Examples of R include linear hydrocarbon groups, such as a methyl group, an ethyl group, and an n-butyl group, branched hydrocarbon groups, such as an isopropyl group and a tert-butyl group, cyclic hydrocarbon groups, such as cyclohexane and cyclopropane, and besides these, ether groups, ester groups, amide groups, aryl groups, arylalkyl groups, groups containing an unsaturated bond, etc. These groups may be substituted or unsubstituted, and are not particularly limited as long as they are groups derived from a monovalent carboxylic acid. From the viewpoint of crosslinking property, R preferably contains an unsaturated bond, a hydroxy group, or a structure from which a protecting group is to be removed by heat or an acid to generate a hydroxy group or a carboxy group.

Note that, in the following, alkyl group names may be given with "n" to indicate a primary group, with "s" or "sec-" to indicate a secondary group, with "t" or "tert-" to indicate a tertiary group, and the like respectively.

In the general formula (M), Q independently represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, a halogen atom, or an alkoxy group having 1 to 20 carbon atoms. From the viewpoint of the availability of raw materials, Q is preferably an n-butyl group, a t-butyl group, an n-octyl group, a benzyl group, a halogen atom, or an alkoxy group, more preferably an n-butyl group. In view of the radical cleavage of Sn-alkyl bonds easily occurring, a t-butyl group and a benzyl group are also favorable.

In the general formula (M), T independently represents the general formula (T-1) or (T-2). In the general formulae (T-1) and (T-2), R₁ represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, or a substituted or unsubstituted arylalkyl group having 7 to 31 carbon atoms, preferably a combination of the above groups. From the viewpoint of the availability of raw materials, R₁ is preferably an n-butyl group, a t-butyl group, an n-octyl group, or a benzyl group, more preferably an n-butyl group. In view of the radical cleavage of Sn-alkyl bonds easily occurring, a t-butyl group and a benzyl group are also favorable.

In the general formula (M), "n₁", "n₂", and "n₃" each represent an integer that satisfy n₁ ≥ 1, n₂ ≥ 0, n₃ ≥ 1, and n₁ + n₂ + n₃ = 4, when n₁ ≥ 2, the Ts being identical to or different from each other, when n₂ = 2, the Ps being identical to or different from each other, and when n₃ ≥ 2, the Qs being identical to or different from each other. From the viewpoint of increasing the tin content, it is preferable that n₁ = 3 and n₃ = 1, and from the viewpoint of breaking the symmetry of the molecule and enhancing the solubility, it is preferable that n₁ = 2, n₂ = 1, and n₃ = 1.

In the general formula (T-1), W₁ represents a substituted or unsubstituted, linear, branched, or cyclic, saturated or unsaturated hydrocarbon group having 1 to 40 carbon atoms, the hydrocarbon group including an aromatic group, optionally containing any heteroatom of an oxygen atom, a nitrogen atom, or a sulfur atom, and forming an ether bond, a carbonyl group, an ester group, or an amide group, and optionally forming a heterocyclic structure via the heteroatom, for example, via an amide group, an ester group, etc. From the viewpoints of heat resistance and increasing the Sn content, W₁ is preferably a linear, branched, or cyclic, saturated or unsaturated hydrocarbon group having 1 to 20 carbon atoms and optionally containing a hydroxy group or an amino group, the hydrocarbon group optionally containing any heteroatom of an oxygen atom, a nitrogen atom, or a sulfur atom, and forming an ether bond, a carbonyl group, or an ester group. "s₁" represents an integer of 0 or 1. From the viewpoint of increasing the tin content, "s₁" is preferably 0, and from the viewpoints of thermal flowability or filling property, "s₁" is preferably 1, since an organic chain is preferably contained. Incidentally, when "s₁" is 0, it means that the carbonyl group is bonded via a single bond.

More specifically, W₁ is preferably: a linear, branched, or cyclic, saturated or unsaturated hydrocarbon group having 1 to 10 carbon atoms and optionally containing a hydroxy group or an amino group, the hydrocarbon group optionally containing any heteroatom of an oxygen atom, a nitrogen atom, or a sulfur atom, and forming an ether bond, a carbonyl group, or an ester group; or any one of the groups represented by the following general formulae (W₁-1) to (W₁-4). 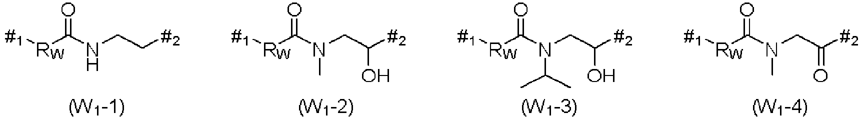 In the general formulae (W₁-1) to (W₂-4), R_{W} represents a divalent organic group having 1 to 23 carbon atoms, and "#₁" and "#₂" respectively represent an attachment point to the ester and the benzene ring.

In the general formula (T-1), R₂ represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a hydroxy group, an amino group, or a halogen atom, and from the viewpoint of thermosetting property, preferably a hydroxy group.

More specific examples of the formula (T-1) include the following formulae, but are not limited thereto. In the following formulae, R₁ and R_{w} represent the same groups as described above.

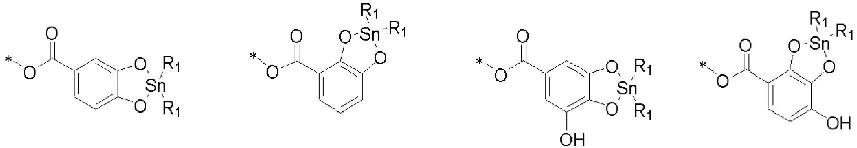

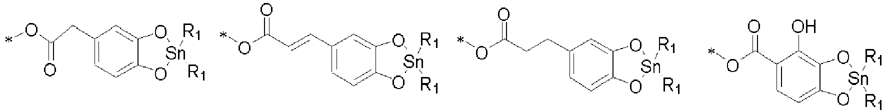

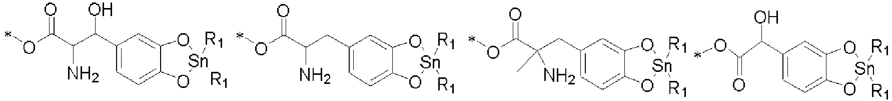

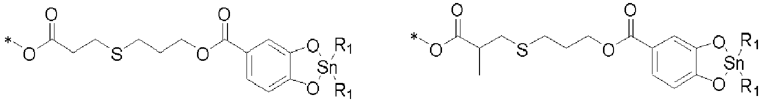

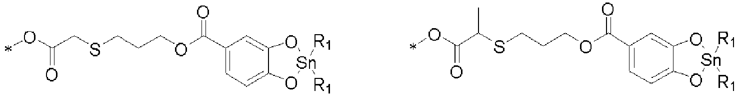

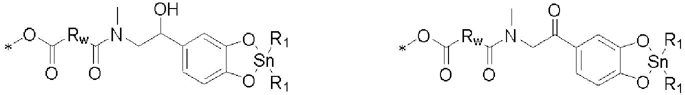

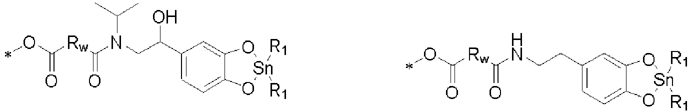

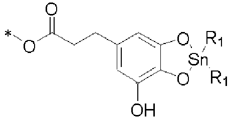

In the general formula (T-2), W₂ represents a substituted or unsubstituted, linear, branched, or cyclic, saturated or unsaturated hydrocarbon group having 1 to 40 carbon atoms and optionally including an aromatic group, the hydrocarbon group optionally containing an oxygen atom, a nitrogen atom, or a sulfur atom, forming an ether bond, a carbonyl group, an ester group, or an amide group, and forming a heterocyclic structure via an amide group, an ester group, etc. From the viewpoints of heat resistance and increasing the Sn content, W₂ is preferably a linear, branched, or cyclic, saturated or unsaturated hydrocarbon group having 1 to 20 carbon atoms, the hydrocarbon group optionally containing a hydroxy group or an amino group, optionally including an aromatic group, optionally including an oxygen atom, a nitrogen atom, or a sulfur atom, and optionally forming an ether bond, a carbonyl group, or an ester group.

More specifically, W₂ is preferably any of: a linear, branched, or cyclic, saturated or unsaturated hydrocarbon group having 1 to 10 carbon atoms, the hydrocarbon group optionally containing a hydroxy group or an amino group and optionally including an aromatic ring group; a cyclic hydrocarbon group bonded to R₃, the hydrocarbon group optionally containing an oxygen atom, a nitrogen atom, or a sulfur atom and forming an ether bond, a carbonyl group, or an ester group; or any one of groups represented by the following general formulae (W₂-1) to (W₂-4).

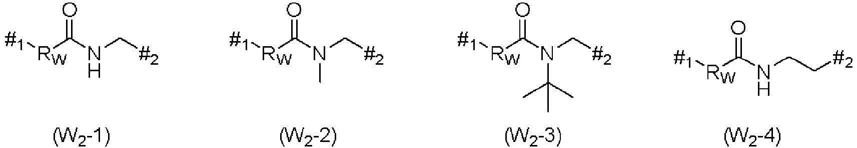

In the general formulae (W₂-1) to (W₂-4), R_{W} represents a divalent organic group having 1 to 23 carbon atoms, and "#₁" and "#₂" respectively represent an attachment point to the ester group and the carbon atom.

In the general formula (T-2), "s₃" represents 1 or 2, when "s₃" is 1, R₃ being a hydrogen atom or a hydrocarbon group having 1 to 10 carbon atoms and having a hydroxy group, and when "s₃" is 2, the R₃ being an oxygen atom forming a carbonyl group together with the carbon atom bonded thereto; and the W₂ and the R₃ are optionally bonded to each other to form a cyclic structure. "s₂" is an integer of 0 or 1, and from the viewpoint of increasing the tin content, "s₂" is preferably 0, and from the viewpoints of thermal flowability and filling property, "s₂" is preferably 1, since an organic chain is preferably contained. Incidentally, when "s₂" is 0, it means that the carbonyl group is bonded via a single bond.

Specific examples of (T-2) including W₂ include the following formulae, but are not limited thereto. In the following formulae, R₁ and R_{w} represent the same groups as described above.

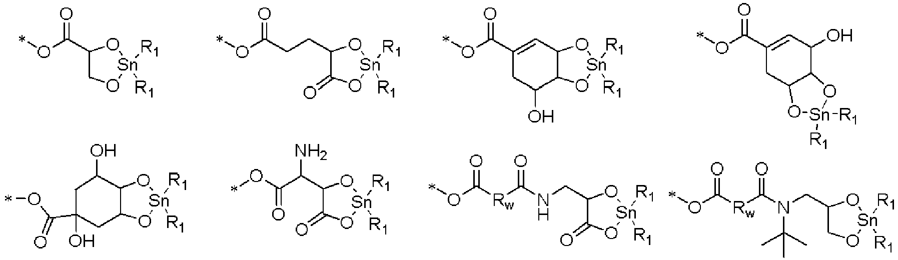

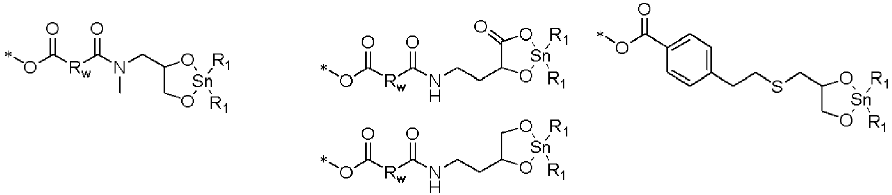

The R_{W} in the general formulae (W₁-1) to (W₁-4) and (W₂-1) to (W₂-4) represents a divalent organic group having 1 to 23 carbon atoms. Examples of preferable structures of R_{W} include the following structures, but are not limited thereto. Each "*" represents an attachment point to the carbon atom of the carbonyl group.

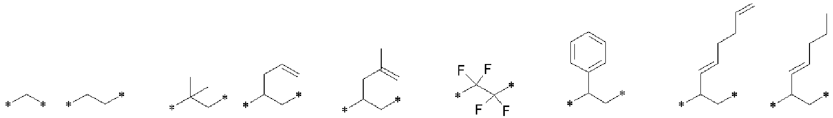

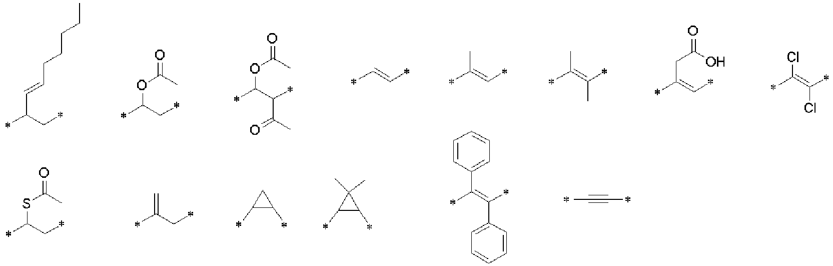

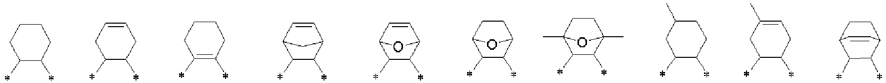

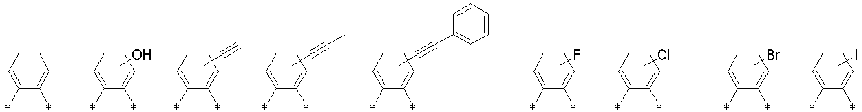

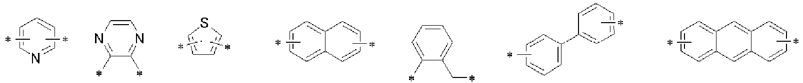

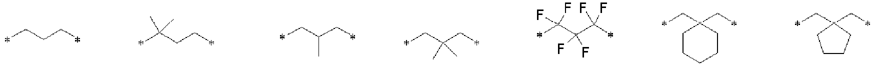

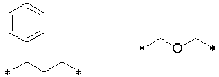

Furthermore, the R_{W} in the general formulae (W₁-1) to (W₁-4) and (W₂-1) to (W₂-4) is preferably an unsaturated hydrocarbon having 2 to 23 carbon atoms.

A compound for forming a metal-containing film having such a structure can further improve thermosetting property.

Furthermore, the R_{W} in the general formulae (W₁-1) to (W₁-4) and (W₂-1) to (W₂-4) more preferably has a structure represented by either of the following general formulae (1) from the viewpoints of thermosetting property and increasing the tin content.

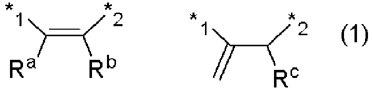

In the general formulae (1), R^{a}, R^{b}, and R^{C} each represent a hydrogen atom or a monovalent organic group having 1 to 20 carbon atoms, R^{a} and R^{b} optionally being bonded to each other to form a cyclic substituent; and "*1" and "*2" each represent an attachment point to the carbonyl group, the substitution positions of "*1" and "*2" optionally being reversed.

A carboxylic acid raw material containing one of the general formulae (1) can be synthesized by ring-opening a cyclic acid anhydride, and in this event, when an asymmetrical cyclic carboxylic anhydride is ring-opened, a mixture of two types is obtained, and therefore, the above-described bonding form is obtained. By such isomers being present, crystallinity can be suppressed, and improvement in filling property, achieved by improvement in solvent solubility and improvement in thermal flowability, can be expected. For example, in the ring-opening reaction between an itaconic anhydride derivative and a 4-(2-aminoethyl)pyrocatechol shown below, the product differs depending on whether the nucleophilic reaction of the amine occurs at the carbonyl next to the unsaturated methylene group (>C=CH₂) or occurs at the carbonyl next to the saturated methylene group (>CH₂), and a mixture of two isomers is obtained.

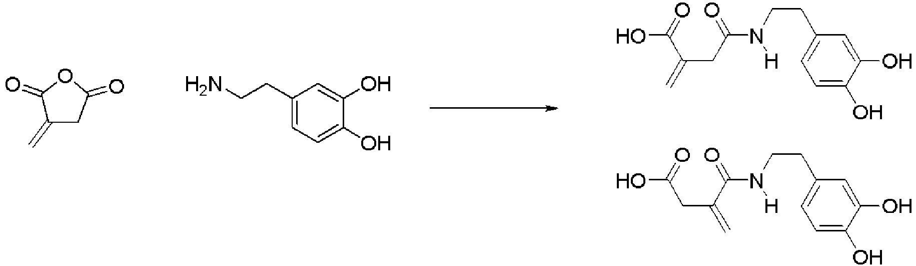

The compound represented by the general formula (M) can be synthesized by the condensation of: a carboxylic acid unit (T) containing tin; alkyl tin trichloride, dialkyl tin dichloride, or dialkyl tin oxide (Z); and, when contained, a monovalent carboxylic acid (P) (reactions 1 to 4). R, R₁, R₂, R₃, "m", "s₁", "s₂", W₁, and W₂ are as defined above.

### (Reaction 1) A case where 3 equivalents of (T) is added to alkyl tin trichloride (Z) for condensation.

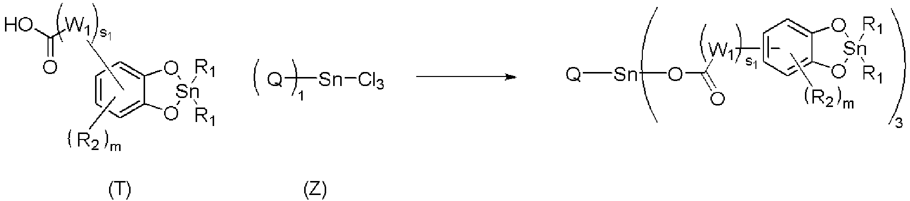

### (Reaction 2) A case where 2 equivalents of (T) is added to dialkyl tin dichloride (Z) for condensation.

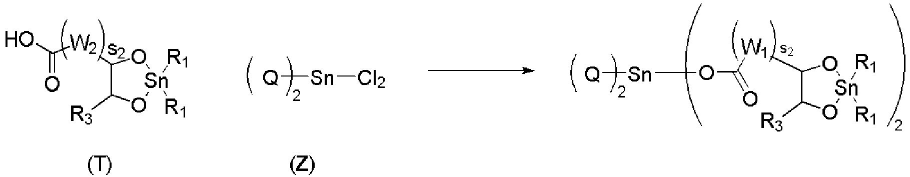

### (Reaction 3) A case where 1 equivalent of each of (T) and (P) is added to dialkyl tin oxide (Z) for condensation.

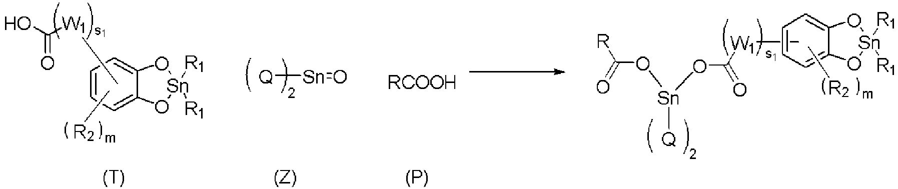

### (Reaction 4) A case where 2 equivalents of (T) and 1 equivalent of (P) are added to alkyl tin trichloride (Z) for condensation.

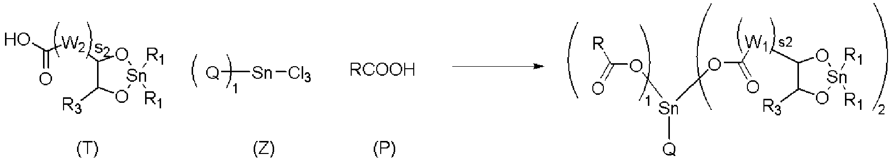

When synthesis is carried out using multiple (T)s or when not only (T) but (P) is also used for the reaction, there are instances of (M) in which all the (T)s in a molecule are the same kind of (T) and instances of (M) in which all the (T)s are different from each other. Accordingly, "n₁" and "n₂" indicate the proportion at which the substituents are present in the reaction system. For example, when alkyl tin trichloride (1 equivalent) is used as (Z), acrylic acid (1 equivalent) is used as (P), and the following starting material (2 equivalents) is used as (T), there are some molecules in which all the substituents are derived from (T) and some molecules in which the ratio (T):(P) = 2:1 is obtained, and overall, there is an abundance ratio similar to the used ratio.

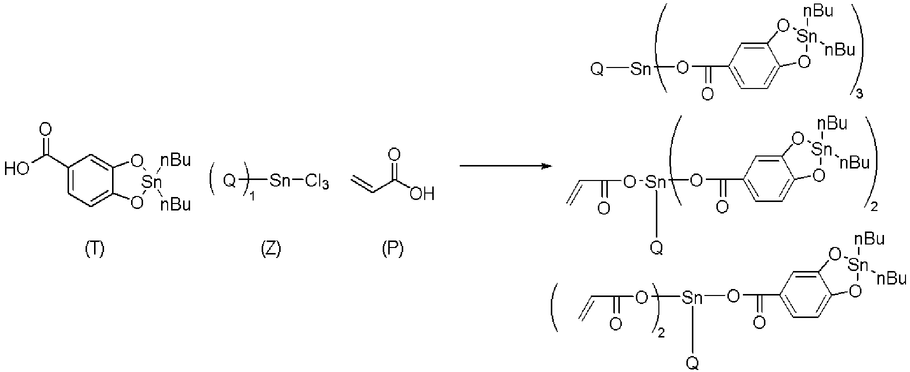

The compound of the unit represented by (T) in the general formula (M) can be synthesized by condensation using 1 equivalent each of a tin compound, such as dialkyl tin dichloride and dialkyl tin oxide (Z), and a compound (X) containing both adjacent hydroxy groups (two hydroxy groups adjoining each other via two carbon atoms) and a carboxylic acid group (reaction A1 and A2). R₁, R₂, R₃, "m", "s₁", "s₂", W₁, and W₂ are as defined above.

### (Reaction A1) General formula of condensation of dialkyl tin oxide (Z) and catechol derivative (X)

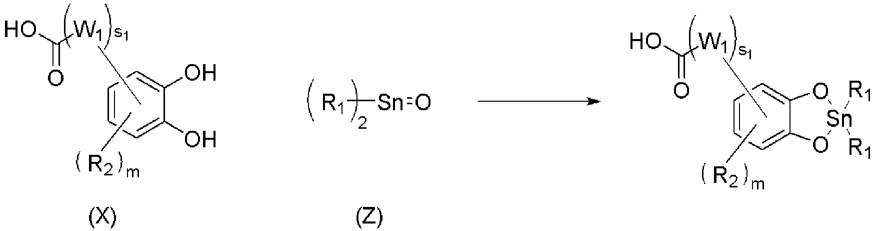

### (Reaction A2) General formula of condensation of dialkyl tin dichloride (Z) and diol derivative (X) (s₃ = 1)

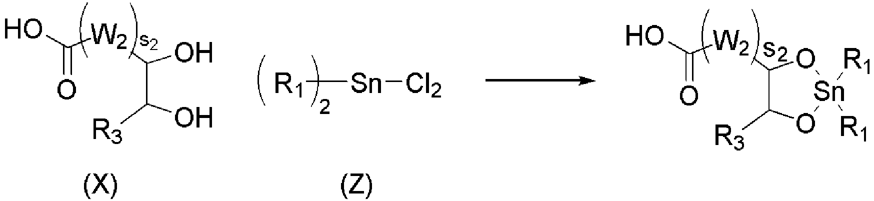

The above-described condensation reaction using (T), (Z), and (P) (reaction 1 to 4) and condensation reaction using (X) and (Z) (reaction A (reaction A1 and A2)) can usually be performed without a solvent or in a solvent at room temperature or, as necessary, under cooling or heating. Examples of the solvent used include: ethers, such as diethyl ether, dibutyl ether, diethylene glycol diethyl ether, diethylene glycol dimethyl ether, tetrahydrofuran, and 1,4-dioxane; chlorine-based solvents, such as methylene chloride, chloroform, dichloroethane, and trichloroethylene; hydrocarbons, such as hexane, heptane, benzene, toluene, xylene, and cumene; nitriles, such as acetonitrile; ketones, such as acetone, ethyl methyl ketone, and isobutyl methyl ketone; esters, such as ethyl acetate, n-butyl acetate, and propylene glycol methyl ether acetate; lactones, such as γ-butyrolactone; and aprotic polar solvents, such as dimethyl sulfoxide, N,N-dimethylformamide, N-methyl-2-pyrrolidone, and hexamethylphosphoric triamide. One of these solvents may be used, or two or more kinds thereof may be used in mixture. These solvents can be used in an amount of 0 to 3000 parts by mass based on 100 parts by mass of the reaction raw materials. In addition, the reaction temperature is preferably -50°C to approximately the boiling point of the solvent, further preferably room temperature to 130°C.

In a case where a chloro compound is used as (Z), a basic catalyst may also be added as a catalyst. As the basic catalyst to be used, it is possible to use an inorganic base, such as potassium carbonate and sodium hydroxide, but since it is difficult to remove these bases, it is preferable to use an organic base, such as triethylamine, diisopropylethylamine, N,N-dimethylaniline, pyridine, and 4-dimethylaminopyridine. The amount of the catalyst to be used is preferably 1.0 to 1.2 equivalents, more preferably 1.0 to 1.1 equivalents based on the amount of chloro groups contained. Here, "1 equivalent based on the amount of chloro groups contained" means that, for example, in a case where dialkyl tin dichloride is used as (Z), 2.0 mol of the catalyst is added relative to 1 mol of the dialkyl tin dichloride.

Examples of condensation reaction methods for the reaction A include: a method in which (X), (Z), a solvent, and a catalyst are charged at once; a method in which (Z) is dropped in in the presence of (X), a solvent, and a catalyst; a method in which a catalyst is dropped in in the presence of (X), (Z), and a solvent; etc. In this event, the amount of the (Z) to be used is preferably 0.95 to 1.05 equivalents, more preferably 1.0 equivalent based on (X). After completion of the condensation reaction of the reaction A, in order to remove unreacted raw materials, the catalyst, etc., it is possible to add a step of performing: a method of raising the temperature of the reaction vessel to 130 to 230°C to remove the volatile content at the pressure about 1 to 50 mmHg; a method of fractionating impurities and the obtained compound by using an appropriate poor solvent or a good solvent; etc. In addition, after completion of the reaction A, the reaction 3 or 4 can be performed subsequently by adding subsequently additional (Z) or (P) to the reaction system. After completion of the condensation reaction of the reaction 3 or 4, it is possible to add a step of removing impurities etc. in the same manner as the above-described purification method.

In the general formula (M), P represents *-OC(=O)R, R representing a monovalent organic group and "*" representing an attachment point to the Sn atom. When P is contained, R can be changed freely, and therefore, when a bulky structure is incorporated, improvement in solubility and thermal flowability can be expected, and since a crosslinking structure can further be provided, sublimation products can be suppressed, and suppression of volume shrinkage, which induces degradation in filling property, can also be expected. Carboxylic acid starting materials containing R are not particularly limited as long as they are monofunctional carboxylic acids, which have preferably, for example, linear substituted or unsubstituted hydrocarbon groups of acetic acid, propionic acid, glycine, etc., branched substituted or unsubstituted hydrocarbon groups of pivalic acid, 2-aminoisobutyric acid, etc., and cyclic substituted or unsubstituted hydrocarbon groups of cyclopropanecarboxylic acid, 3,3-difluorocyclobutanecarboxylic acid, etc. However, from the viewpoint of thermosetting property, more preferable are groups containing an unsaturated hydrocarbon group, groups containing a hydroxy group, and groups whose protecting group is to be removed by heat or an acid to generate a hydroxy group or a carboxy group.

Furthermore, the R is preferably any one of groups represented by the following general formulae (A-1) to (A-4), the following general formula (3), and the following general formula (4).

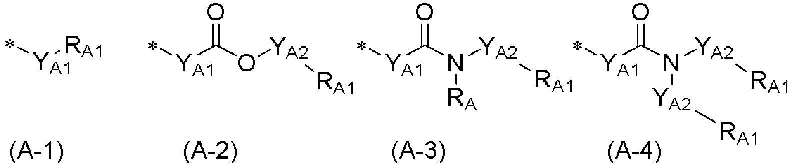

In the general formulae (A-1) to (A-4), Y_{A1} and Y_{A2} are each identical to or different from each other and represent a substituted or unsubstituted saturated divalent organic group (such as an aliphatic hydrocarbon group) having 1 to 23 carbon atoms, a substituted or unsubstituted unsaturated divalent organic group (such as an aliphatic hydrocarbon group) having 2 to 23 carbon atoms, a substituted or unsubstituted arylene group having 6 to 30 carbon atoms, or a substituted or unsubstituted arylalkylene group having 7 to 31 carbon atoms; R_{A} represents a hydrogen atom, a substituted or unsubstituted saturated monovalent organic group (such as an aliphatic hydrocarbon group) having 1 to 20 carbon atoms, a substituted or unsubstituted unsaturated monovalent organic group (such as an aliphatic hydrocarbon group) having 2 to 20 carbon atoms, a substituted or unsubstituted aryl group having 6 to 30 carbon atoms, or a substituted or unsubstituted arylalkyl group having 7 to 31 carbon atoms; R_{A1} represents an organic group whose protecting group is to be removed by an action of an acid, heat, or both to generate one or more hydroxy groups or carboxy groups, R_{A1} being represented by one of the following general formulae (2); and "*" represents an attachment point to the carbonyl group.

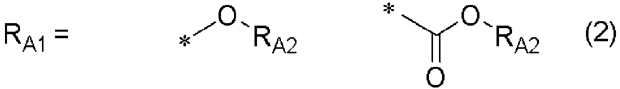

In the general formulae (2), R_{A2} represents an organic group whose protecting group is to be removed by an action of an acid, heat, or both; and "*" represents an attachment point to Y_{A1} or Y_{A2}.

In the general formulae (A-1) to (A-4), Y_{A1} and Y_{A2} are each identical to or different from each other and represent a substituted or unsubstituted saturated divalent organic group (preferably a hydrocarbon group) having 1 to 23 carbon atoms, a substituted or unsubstituted unsaturated divalent organic group (preferably a hydrocarbon group) having 2 to 23 carbon atoms, a substituted or unsubstituted arylene group having 6 to 30 carbon atoms, or a substituted or unsubstituted arylalkylene group having 7 to 31 carbon atoms; R_{A} represents a hydrogen atom, a substituted or unsubstituted saturated monovalent organic group (such as an aliphatic hydrocarbon group) having 1 to 20 carbon atoms, a substituted or unsubstituted unsaturated monovalent organic group (such as an aliphatic hydrocarbon group) having 2 to 20 carbon atoms, a substituted or unsubstituted aryl group having 6 to 30 carbon atoms, or a substituted or unsubstituted arylalkyl group having 7 to 31 carbon atoms; R_{A1} represents an organic group whose protecting group is to be removed by an action of an acid, heat, or both to generate one or more hydroxy groups or carboxy groups, R_{A1} being represented by one of the general formulae (2). Considering thermal flowability and solubility, (A-4) is preferable, and from the viewpoint of suppressing sublimation due to organic content decomposition for raising the tin content, (A-1) is preferable.

Examples of favorable structures of the Y_{A1} and Y_{A2} in the general formulae (A-1) to (A-4) include the following structures, but are not limited thereto. In the following formulae, "*ₐ" represents an attachment point to R_{A1}, and "*_{b}" represents the other attachment point.

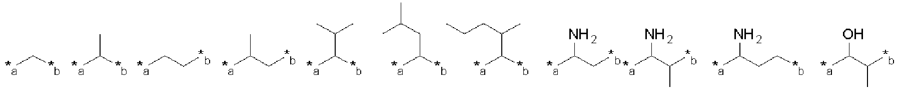

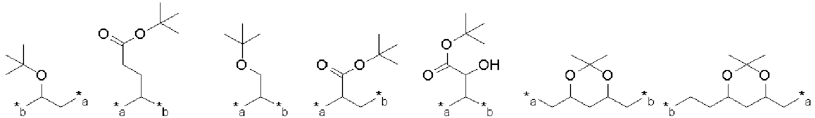

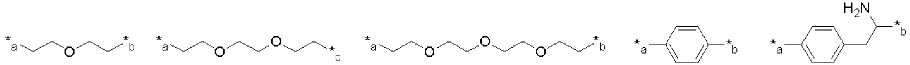

The R_{A} in the general formula (A-3) represents a hydrogen atom, a substituted or unsubstituted saturated monovalent organic group, such as an aliphatic hydrocarbon group, having 1 to 20 carbon atoms, a substituted or unsubstituted unsaturated monovalent organic group, such as an aliphatic hydrocarbon group, having 2 to 20 carbon atoms, a substituted or unsubstituted aryl group having 6 to 30 carbon atoms, or a substituted or unsubstituted arylalkyl group having 7 to 31 carbon atoms, and from the viewpoints of suppressing sublimation products and increasing the Sn content, preferably a hydrogen atom.

The R_{A2} in the general formula (2) represents an organic group whose protecting group (heat/acid-labile group) is to be removed by an action of an acid, heat, or both, preferably a tertiary hydrocarbyl group or a group that forms an acetal structure together with the adjacent oxygen atom, particularly preferably a tertiary hydrocarbyl group.

As the tertiary hydrocarbyl group, those having 4 to 20 carbon atoms are preferable, and from the viewpoints of suppressing sublimation products due to thermal decomposition products and the ease of acquiring raw materials, a tert-butyl group is particularly preferable. Specific examples include those shown below, but are not limited thereto. Incidentally, in the following formulae, "*" represents an attachment point to the oxygen atom.

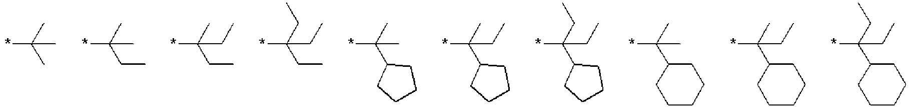

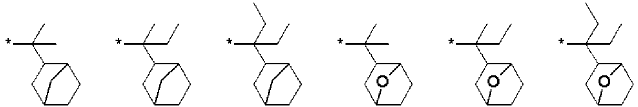

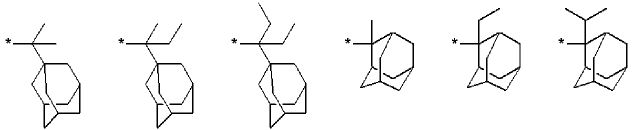

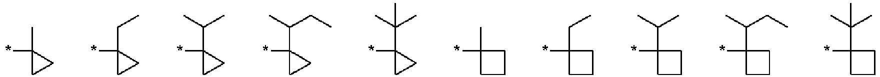

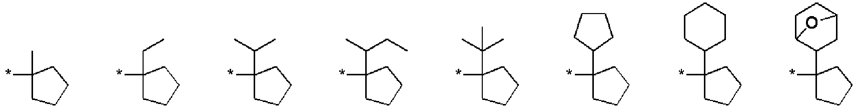

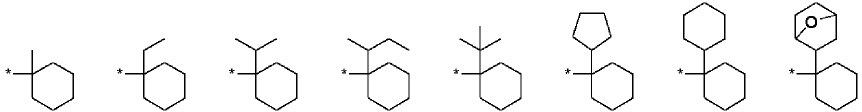

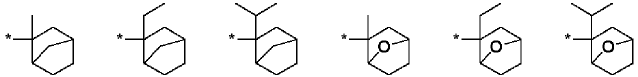

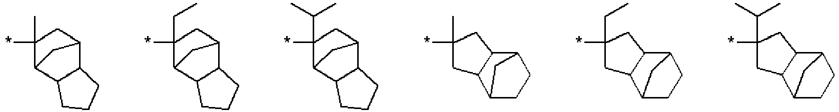

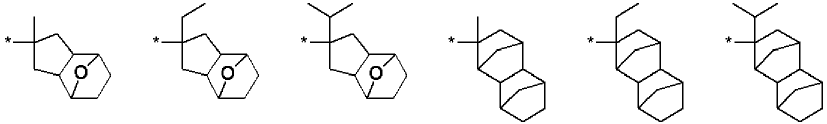

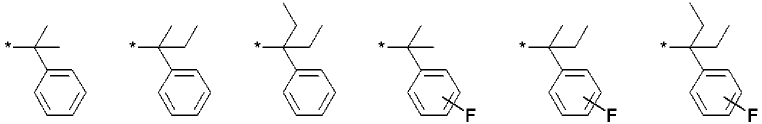

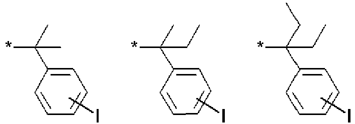

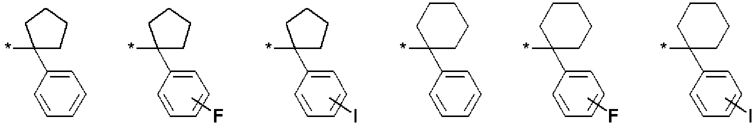

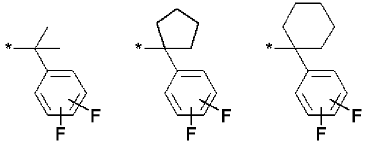

Specific examples of the group forming the acetal structure include those shown below, but are not limited thereto. Incidentally, in the following formulae, "*" represents an attachment point to the oxygen atom.

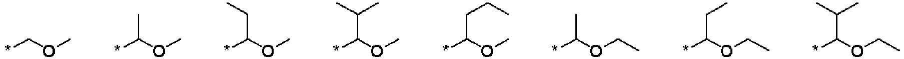

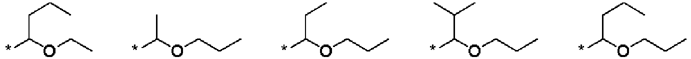

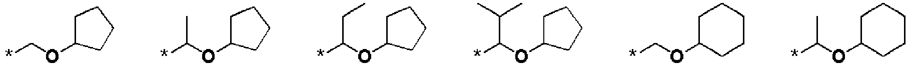

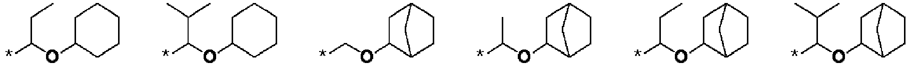

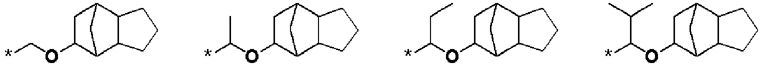

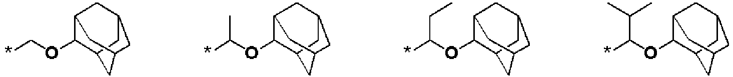

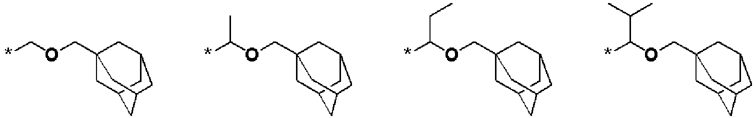

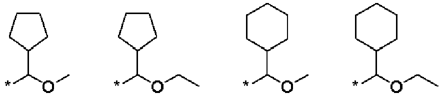

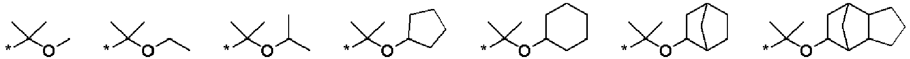

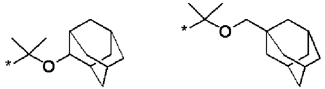

Such a compound for forming a metal-containing film is excellent in solvent solubility and thermal flowability. In addition, R_{A1} contains in the structure an organic group from which a bulky protecting group is to be removed by the action of an acid, heat, or both, and therefore, when such a compound is contained in a composition for forming a metal-containing film, the groups are removed during baking, so that the tin content increases, and a compound for forming a metal-containing film excellent in dry etching resistance can be achieved. Furthermore, due to the presence of terminal OH groups and α-hydrogen, the hydroxy groups and carboxy groups generated by the elimination react easily with radicals generated by the cleavage of tin-carbon bonds at the time of baking, so that a crosslinking reaction occurs and excellent thermosetting property can be achieved. Thus, volume shrinkage can be suppressed, and it is possible to provide a composition for forming a metal-containing film, such as a resist underlayer film material, that is excellent in film-formability and filling property even after high-temperature baking.

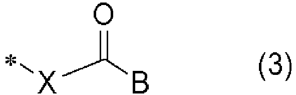

In the general formula (3), X represents a divalent organic group having 1 to 31 carbon atoms; B represents the following general formula (B); and "*" represents an attachment point to the carbonyl group.

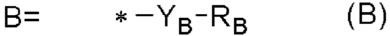

In the general formula (B), Y_{B} represents a substituted or unsubstituted saturated divalent organic group (such as an aliphatic hydrocarbon group) having 1 to 20 carbon atoms, a substituted or unsubstituted unsaturated divalent organic group (such as an aliphatic hydrocarbon group) having 2 to 20 carbon atoms, a substituted or unsubstituted divalent arylene group having 6 to 30 carbon atoms, or a substituted or unsubstituted divalent arylalkylene group having 7 to 31 carbon atoms; R_{B} represents a hydroxy group or any one of structures represented by the following general formulae (B-1) to (B-3).

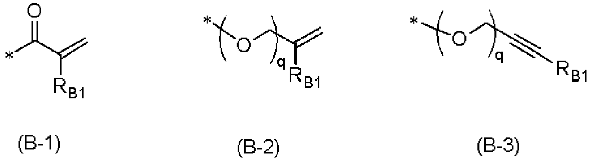

In the general formulae (B-1) to (B-3), R_{B1} represents a hydrogen atom or a monovalent organic group having 1 to 10 carbon atoms; "q" represents 0 or 1; and "*" represents an attachment point to Y_{B}.

In the general formula (3), X represents a divalent organic group having 1 to 31 carbon atoms; B represents the general formula (B); and "*" represents an attachment point to the carbonyl group. In the general formula (B), it is preferable that Y_{B} represents a substituted or unsubstituted saturated divalent organic group (such as an aliphatic hydrocarbon group) having 1 to 20 carbon atoms, a substituted or unsubstituted unsaturated divalent organic group (such as an aliphatic hydrocarbon group) having 2 to 20 carbon atoms, a substituted or unsubstituted divalent arylene group having 6 to 30 carbon atoms, or a substituted or unsubstituted divalent arylalkylene group having 7 to 31 carbon atoms; R_{B} represents a hydroxy group or any one of structures represented by the general formulae (B-1) to (B-3). Furthermore, in the general formulae (B-1) (B-3), R_{B1} represents a hydrogen atom or a monovalent organic group having 1 to 10 carbon atoms, and from the viewpoint of suppressing sublimation products, preferably a hydrogen atom.

Examples of preferable structures of the general formula (B) include the following structures, but are not limited thereto. Incidentally, in the following formulae, "*" represents an attachment point to the carbonyl group.

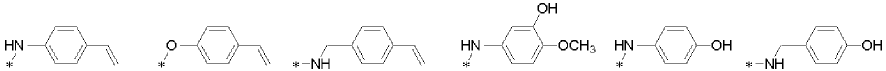

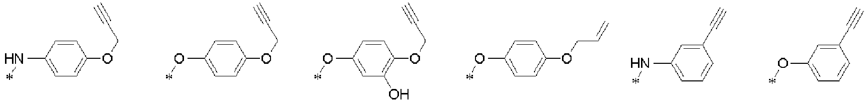

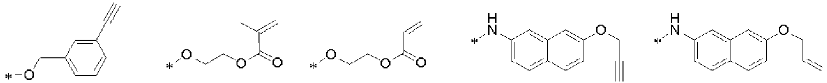

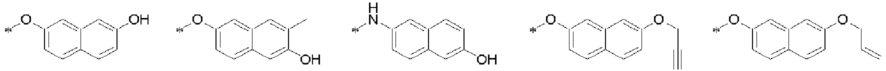

Such a compound for forming a metal-containing film is excellent in solvent solubility and thermal flowability. Furthermore, since a hydroxy group or an unsaturated bond is contained in the R_{B}, when the compound is contained in a composition for forming a metal-containing film, the hydroxy group or unsaturated bond causes a crosslinking reaction during baking, so that excellent thermosetting property is provided, and furthermore, by the hydroxy group or unsaturated bond also reacting with the radicals generated by the cleavage of the tin-carbon bonds, the crosslinking reaction is promoted, and excellent thermosetting property is provided. Thus, volume shrinkage can be suppressed, and it is possible to provide a composition for forming a metal-containing film excellent in film-formability and filling property even after high-temperature baking.

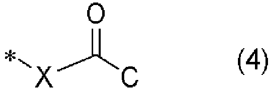

In the general formula (4), X represents a divalent organic group having 1 to 31 carbon atoms; C represents any of the following general formulae (C-1) to (C-4); and "*" represents an attachment point to the carbonyl group.

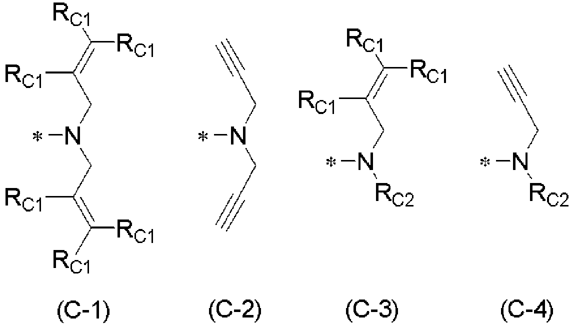

In the general formulae (C-1) and (C-3), R_{C1S} each represent a hydrogen atom or a methyl group and are identical to or different from each other in a single formula. In (C-3) and (C-4), R_{C2} represents a hydrogen atom, a substituted or unsubstituted, saturated or unsaturated monovalent organic group (such as an aliphatic hydrocarbon group) having 1 to 20 carbon atoms, a substituted or unsubstituted aryl group having 6 to 30 carbon atoms, a substituted or unsubstituted arylalkyl group having 7 to 31 carbon atoms; and "*" represents an attachment point to the carbonyl group.

In the general formula (4), X represents a divalent organic group having 1 to 31 carbon atoms, and specific examples include substituted or unsubstituted saturated divalent hydrocarbon groups having 1 to 20 carbon atoms, substituted or unsubstituted unsaturated divalent hydrocarbon groups having 2 to 20 carbon atoms, substituted or unsubstituted aryl groups having 6 to 30 carbon atoms, substituted or unsubstituted arylalkyl groups having 7 to 31 carbon atoms, etc. C is a group represented by one of the general formulae (C-1) to (C-4). In (C-1) and (C-3), R_{C1} is preferably a methyl group from the viewpoint of thermal flowability, and is preferably a hydrogen atom from the viewpoint of curability. In addition, the R_{C2} in (C-3) and (C-4) is preferably one of the above-described structures other than a hydrogen atom from the viewpoint of thermal flowability.

Examples of favorable structures of the R_{C2} in the general formulae (C-1) to (C-4) include the following structures, but are not limited thereto. Incidentally, in the following formulae, "*" represents an attachment point to the nitrogen atom.

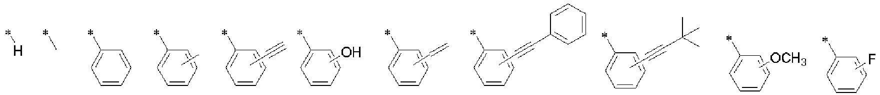

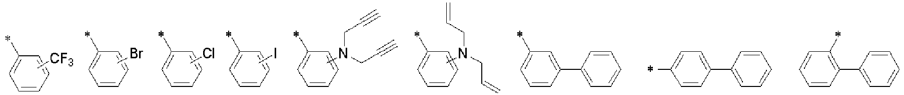

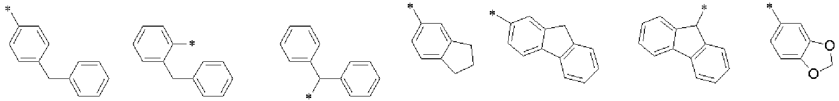

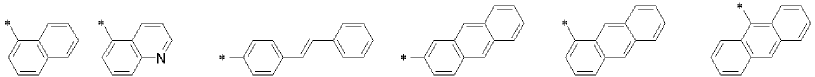

A compound for forming a metal-containing film having such a structure contains an organic group represented by the general formula (3), and therefore, is excellent in solvent solubility and heat resistance, and furthermore, contains one of the structures represented by the general formulae (C-1) to (C-4) on an end, and therefore, has a high density of crosslinking groups, so that rapid volume shrinkage during baking can be reduced. Therefore, it is possible to provide a composition for forming a metal-containing film excellent in film-formability and filling property.

In a metal-containing film formed using a composition containing the compound (M) for forming a metal-containing film, Sn-C bonds are cleaved to generate radicals during baking, and the generated radicals cause the curing reaction to proceed (formula 1). Therefore, since re-bonding between radicals is necessary for the promotion of the curing reaction, time is required for curing and it is necessary to raise the generation efficiency of radicals at a high temperature. The inventive compound contains multiple tin atoms per molecule, and therefore, many activated species are present, and the generation and re-bonding of radicals occur efficiently, so that the inventive compound is excellent in heat resistance and thermosetting property. Thus, it is possible to provide a resist underlayer film excellent in film-formability. In addition, when a group containing an unsaturated bond or a hydroxy group is present in P, not only such groups react with the radicals, also the groups by themselves make a crosslinking reaction proceed (formula 2), and therefore, a film having better heat resistance and excellent thermosetting property is achieved.

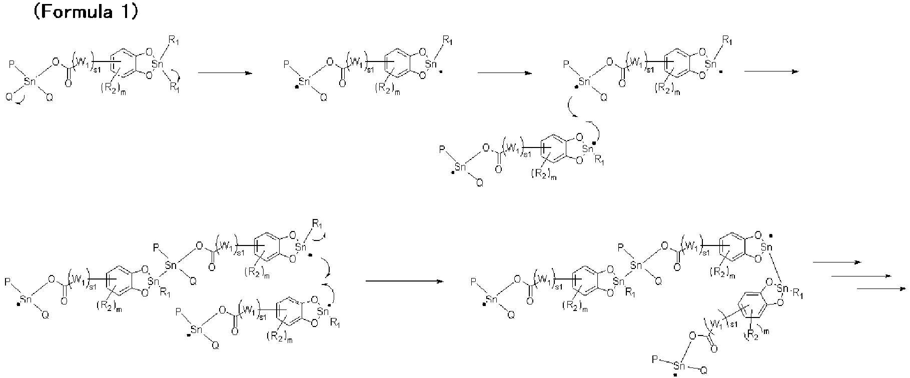

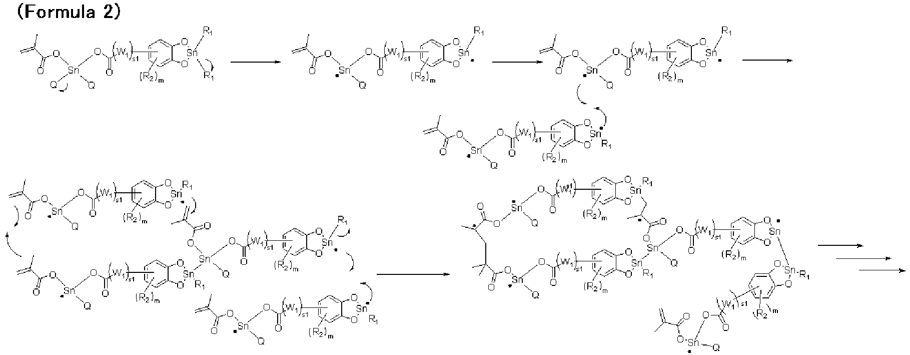

Examples of favorable structures of the Y_{A1} in the general formulae (A-1) to (A-4), the X in the general formula (2), or the X in the general formula (3) include the following structures, but are not limited thereto. Incidentally, in the following formulae, "*" represents an attachment point to the carbon atom of the carbonyl group or the "*" in the formulae (A-1) to (A-4), (3), or (4) .

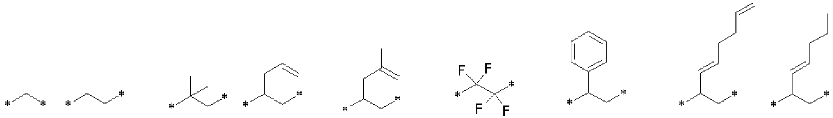

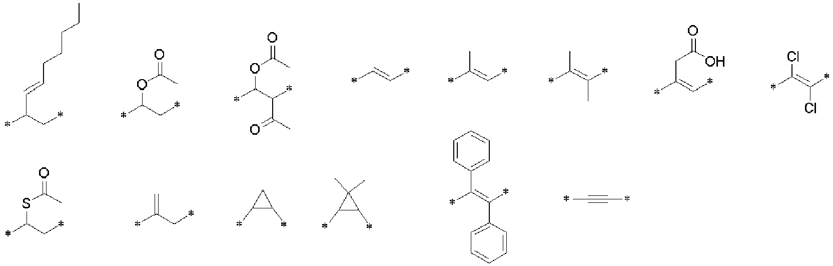

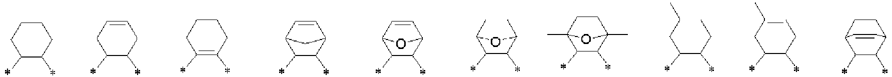

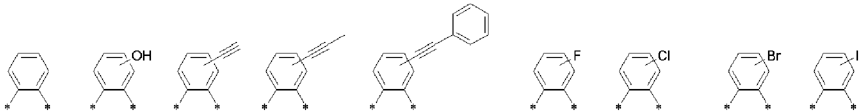

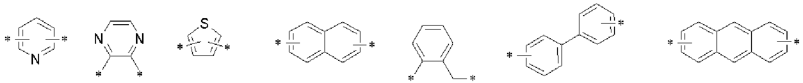

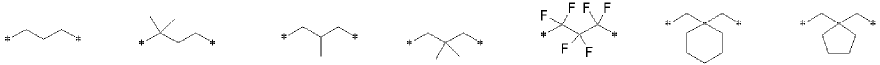

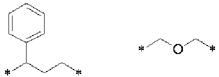

In the compound for forming a metal-containing film, it is preferable that the Y_{A1} in the general formulae (A-1) to (A-4), the X in the general formula (3), or the X in the general formula (4) is an unsaturated hydrocarbon group having 2 to 23 carbon atoms.

When the Y_{A1} in the general formulae (A-1) to (A-4), the X in the general formula (3), or the X in the general formula (4) is an unsaturated hydrocarbon group having 2 to 23 carbon atoms, the thermosetting property of the compound for forming a metal-containing film can be further improved.

It is also possible to provide a compound for forming a metal-containing film in which the Y_{A1} in the general formulae (A-1) to (A-4), the X in the general formula (3), or the X in the general formula (4) is represented by one of the following general formulae (1).

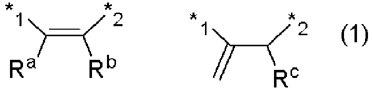

In the general formulae (1), R^{a}, R^{b}, and R^{c} each represent a hydrogen atom or a monovalent organic group having 1 to 20 carbon atoms, R^{a} and R^{b} optionally being bonded to each other to form a cyclic substituent; and "*1" and "*2" each represent an attachment point to the carbonyl group, the substitution positions of "*1" and "*2" optionally being reversed.

A carboxylic acid raw material containing one of the general formulae (1) can be synthesized by ring-opening an acid anhydride, and in this event, when an asymmetrical carboxylic anhydride is ring-opened, a mixture of two types is obtained, and therefore, the above-described bonding form is obtained. By such isomers being present, crystallinity can be suppressed, and improvement in planarizing property, achieved by improvement in solvent solubility and improvement in thermal flowability, can be expected.

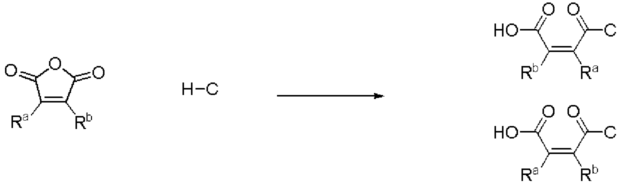

In the general formulae (1), R^{a}, R^{b}, and R^{c} each represent a hydrogen atom or a monovalent organic group having 1 to 20 carbon atoms, R^{a} and R^{b} optionally being bonded to each other to form a cyclic substituent. From the viewpoint of suppressing sublimation products, a hydrogen atom is particularly preferable.

The Mw/Mn (i.e. dispersity) of the compound for forming a metal-containing film preferably satisfies 1.00 ≤ Mw/Mn ≤ 1.80, further preferably 1.00 ≤ Mw/Mn ≤ 1.50, where Mw is a weight-average molecular weight and Mn is a number-average molecular weight measured by gel permeation chromatography (GPC) using tetrahydrofuran in terms of standard polystyrene. From the definition, Mw/Mn is 1.00 when the compound is a monomolecular compound. However, for reasons of separability in GPC, the measured value exceeds 1.00 in some cases. Generally, it is extremely difficult to bring Mw/Mn close to 1.00 in a polymer having a repeating unit unless a special polymerization method is used, there is a molecular weight distribution, and Mw/Mn becomes a value greater than 1. In the present invention, 1.00 ≤ Mw/Mn ≤ 1.50 has been defined as an index indicating monomerism in order to distinguish between a monomolecular compound and a polymer. This index can also be applied to a mixture of two or more kinds of the compound for forming a metal-containing film.

### <Composition for Forming Metal-Containing Film>

Furthermore, the present invention can provide a composition for forming a metal-containing film, the composition functioning as a resist underlayer film material used in manufacturing a semiconductor, the composition containing: (a) the above-described compound for forming a metal-containing film; and (b) an organic solvent.

Such a composition for forming a metal-containing film contains an organotin compound having excellent heat resistance and thermal flowability, and therefore, makes it possible to form a metal-containing film, such as a resist underlayer film, having better dry etching resistance than conventional organic underlayer film materials and also having both high filling property and high planarizing property.

In the following, the components contained in the inventive composition for forming a metal-containing film other than the compound (a) for forming a metal-containing film will be described.

### <(b) Organic Solvent>

The organic solvent (b) usable in the inventive composition for forming a metal-containing film is not particularly limited as long as the solvent can dissolve or disperse the compound (a) for forming a metal-containing film, (c) a crosslinking agent, (d) a surfactant, (e) a flowability accelerator, (f) an acid generator, other additives, etc.

Specifically, an organic solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

### (High-Boiling-Point Solvent)

In the above-described composition for forming a metal-containing film (resist underlayer film), the organic solvent (b) may be a mixture of one or more kinds of organic solvent having a boiling point (the value at 1 atmosphere (1013 hPa)) of lower than 180°C and one or more kinds of organic solvent having a boiling point of 180°C or higher (a high-boiling-point solvent).

The high-boiling-point solvent is not particularly limited to hydrocarbons, alcohols, ketones, esters, ethers, or chlorine-based solvents as long as the solvent is capable of dissolving the components of the inventive composition for forming a metal-containing film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent may be selected suitably from the solvents above, for example, depending on the temperature at which the above-described composition for forming a resist underlayer film is heat-treated, etc. The boiling point of the high-boiling-point solvent is preferably 180°C to 300°C, further preferably 200°C to 300°C. It is considered that when the boiling point is as described, sufficient thermal flowability can be achieved at the time of film formation, since there is no risk of excessive evaporation rate at the baking (heating). Thus, it is possible to form a resist underlayer film excellent in filling and planarizing properties. Moreover, a solvent having such a boiling point does not remain in the film without evaporating even after the baking. Therefore, there is no risk of the solvent adversely affecting the physical properties, such as etching resistance, of the film.

The organic solvent is preferably contained in an amount of 200 to 10,000 parts by mass, more preferably 250 to 5,000 parts by mass based on 100 parts by mass of the compound (a) for forming a metal-containing film.

Furthermore, when the high-boiling-point solvent is used, the contained amount is preferably 1 to 30 parts by mass per 100 parts by mass of the organic solvent having a boiling point lower than 180°C. When the contained amount is as described, sufficient thermal flowability can be imparted at the time of baking, so that the solvent does not remain in the film and cause degradation in the physical properties, such as etching resistance, of the film. Therefore, such an amount is preferable.

<Composition for Forming Resist Underlayer Film>

The above-described composition is a composition for forming a metal-containing film that is usable as a resist underlayer film used in multilayer resist methods, and can be a composition for forming a resist underlayer film, further containing one or more of (c) a crosslinking agent, (d) a surfactant, (e) a flowability accelerator, and (f) an acid generator.

In the following, the components contained in the composition for forming a resist underlayer film other than the compound (a) for forming a metal-containing film and the organic solvent (b) will be described.

### [(c) Crosslinking Agent]

To increase the denseness of the film and further inhibit intermixing with the resist upper layer film, the above-described composition for forming a resist underlayer film may also contain a crosslinking agent (c). The crosslinking agent is not particularly limited, and various known crosslinking agents can be widely used. Examples include melamine-based crosslinking agents, acrylate-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, phenol-based crosslinking agents (e.g. polynuclear phenol-based crosslinking agents as methylol- or alkoxymethyl-modified) epoxy-based crosslinking agents, and oxetane-based crosslinking agents. The crosslinking agent (c) is preferably contained in an amount of 5 to 50 parts by mass, more preferably 10 to 40 parts by mass relative to 100 parts by mass of the compound (a) for forming a metal-containing film.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the acrylate-based crosslinking agents include dipentaerythritol hexaacrylate.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the polynuclear phenol-based crosslinking agents include compounds represented by the following general formula (XL-1).

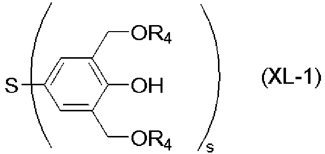

In the formula, S represents a single bond or an s-valent hydrocarbon group having 1 to 20 carbon atoms. R₄ represents a hydrogen atom or an alkyl group having 1 to 20 carbon atoms. "s" represents an integer of 1 to 5.

S represents a single bond or a hydrocarbon group having a valency of "s" and having 1 to 20 carbon atoms. "s" represents an integer of 1 to 5, more preferably 2 or 3. Specific examples of S include groups obtained by removing "s" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R₄ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. Among these, a hydrogen atom or a methyl group is preferable.

Specific examples of the compounds represented by the general formula (XL-1) include the following compounds. Among these, triphenolmethane, triphenolethane, 1,1,1,-tris(4-hydroxyphenyl)ethane, and a hexamethoxymethylated derivative of tris(4-hydroxyphenyl)-1-ethyl-4-isopropylbenzene are preferable from the viewpoint of improving the curability and film thickness uniformity of the organic film. The R₆ below is identical to the R₄ above.

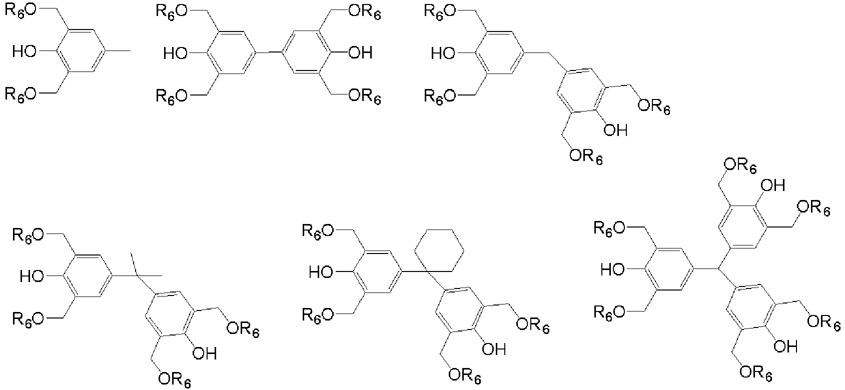

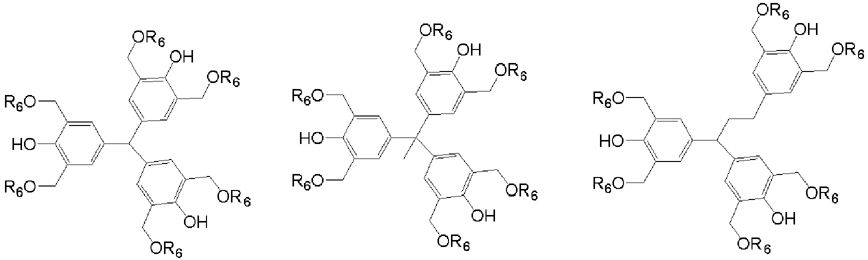

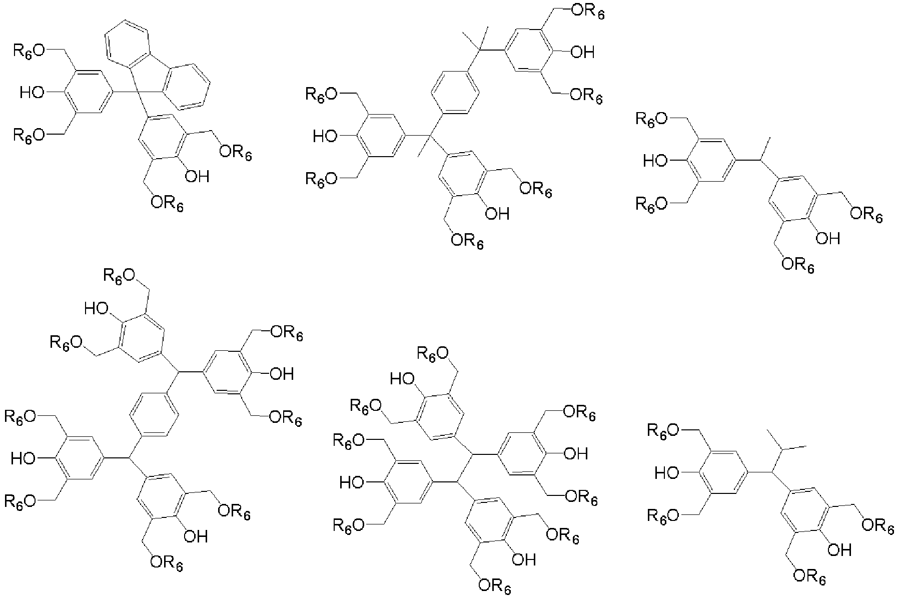

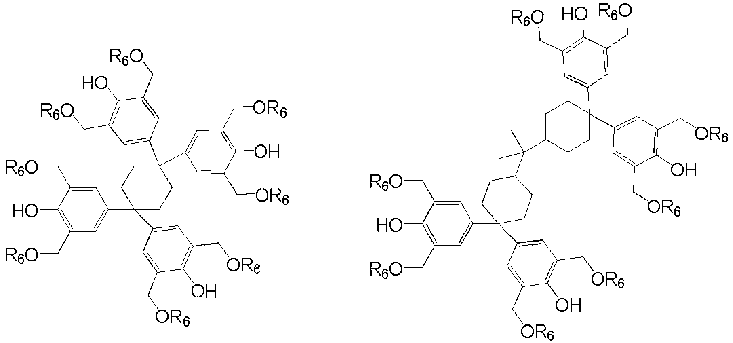

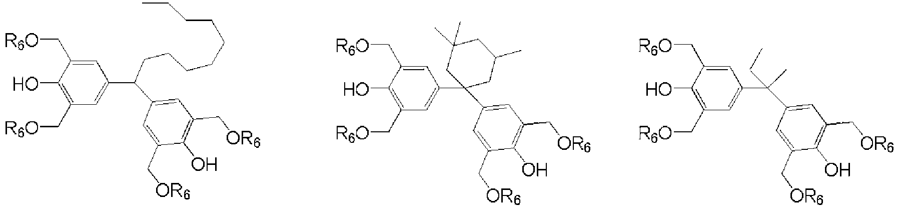

Examples of epoxy-based crosslinking agents and oxetane-based crosslinking agents include monomer types and polymer types, and specific examples of monomer types include the following, but are not limited thereto.

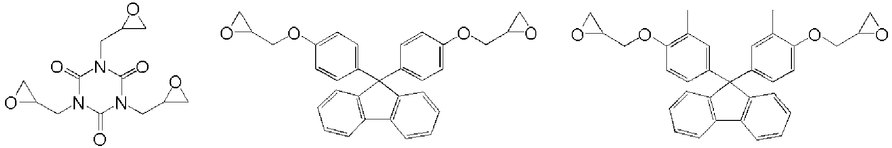

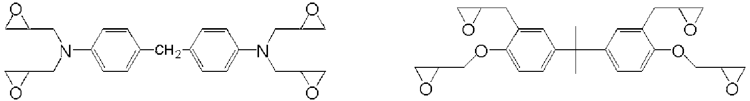

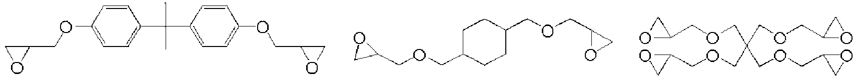

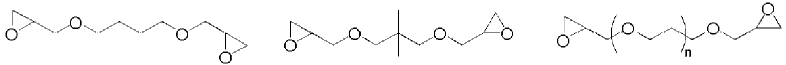

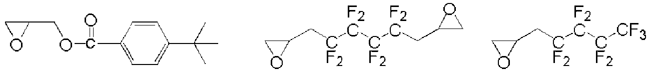

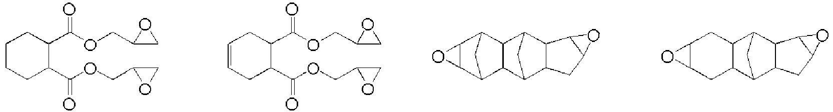

The above compounds can be purchased, but an epoxy-based crosslinking agent or an oxetane-based crosslinking agent can also be obtained by allowing a reaction between a hydroxy group and epibromohydrin, 3-bromomethyloxetane, or the like as in the following formula. In the following formula, R₅ represents a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms. In addition, it is also possible to leave some hydroxy groups and not allow all the hydroxy groups to react. In this event, the sum of the number of epoxy groups and the number of oxetane groups is preferably greater than the number of hydroxy groups, and more preferably, the sum of the epoxy groups and the oxetane groups is greater than twice the number of hydroxy groups. Furthermore, these compounds are preferably contained in an amount of 5 to 50 parts by mass, more preferably 10 to 40 parts by mass based on 100 parts by mass of the compound (a) for forming a metal-containing film.

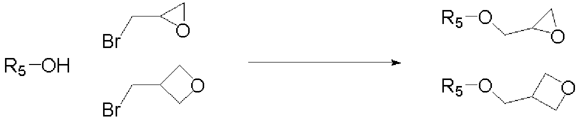

Specific examples of compounds having a hydroxy group usable in the above-described reaction include the following, but are not limited thereto.

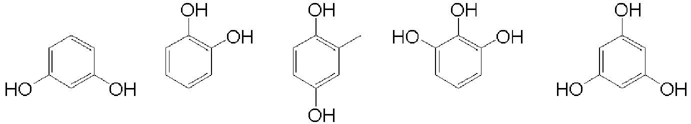

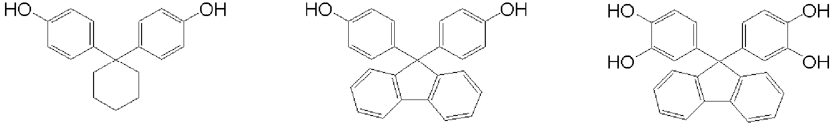

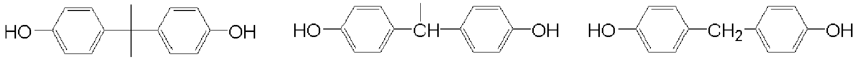

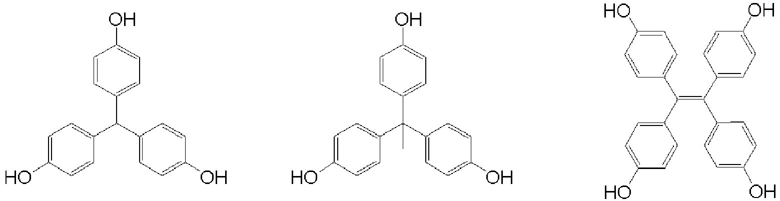

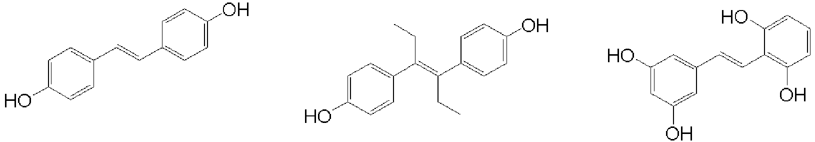

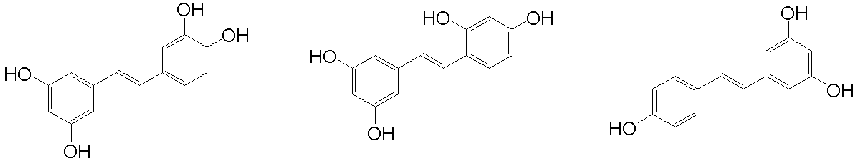

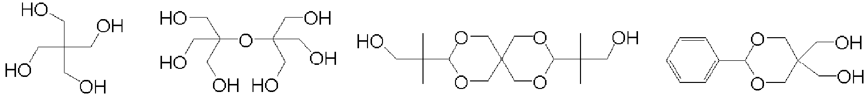

Meanwhile, specific examples of polymer types include polymers having a repeating unit represented by the following general formula (XL-2) and (XL-3) at a molar fraction of 20% or more. When the total of the molar fractions of the structural units represented by the general formulae (XL-2) and (XL-3) does not reach 100%, as the other structural units, it is possible to use a combination of any structural units derived from α,β-unsaturated carboxylic esters, such as other acrylates, other methacrylates, other acrylamides, other methacrylamides, crotonates, maleates, and itaconates; α,β-unsaturated carboxylic acids, such as methacrylic acid, acrylic acid, maleic acid, and itaconic acid; acrylonitrile; methacrylonitrile; α,β-unsaturated lactones, such as 5,5-dimethyl-3-methylene-2-oxotetrahydrofuran; cyclic olefins, such as norbornene derivatives and tetracyclo[4.4.0.1^{2,5}.1^{7,10}]dodecene derivatives; α,β-unsaturated carboxylic anhydrides, such as maleic anhydride and itaconic anhydride; allyl ethers; vinyl ethers; vinyl esters; and vinyl silanes. It is preferable that these polymers have a weight-average molecular weight of 1,000 to 20,000 and have a GPC dispersity (Mw/Mn) of 2.0 or less. Furthermore, these compounds are preferably contained in an amount of 5 to 50 parts by mass, more preferably 10 to 40 parts by mass based on 100 parts by mass of the compound (a) for forming a metal-containing film. Note that, as the molecular weight and the dispersity, the weight-average molecular weight (Mw) and the number-average molecular weight (Mn) can be determined in terms of polystyrene by GPC using tetrahydrofuran as an eluent, and the dispersity (Mw/Mn) can be calculated therefrom.

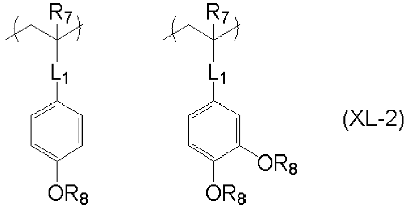

In the formulae, R₇ represents a hydrogen atom or a methyl group; R₈ represents a hydrogen atom or a group selected from the following formulae (2-1) to (2-3); L₁ represents a single bond or a divalent organic group containing -C(=O)O-, -C(=O)NH-, or -C(=O)NCH₃-.

In the R₈ in the general formulae (XL-2), the number of groups of (2-1) to (2-3) is preferably greater than the number of hydrogen atoms, more preferably, the number of groups of (2-1) to (2-3) is greater than twice the number of hydrogen atoms from the viewpoint of curability.

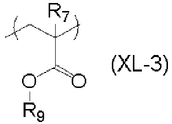

In the formula, R₇ represents a hydrogen atom or a methyl group; and R₉ represents a group selected from the following formulae (2-1) to (2-3).

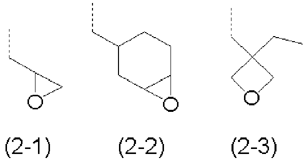

In the formulae, a broken line represents an attachment point.

<(d) Surfactant>

A surfactant (d) may be contained in the above-described composition for forming a resist underlayer film in order to improve coating property in spin-coating. Examples of the surfactant include those disclosed in paragraphs [0142] to [0147] of JP2009-269953A. When the surfactant is contained, the contained amount is preferably 0.01 to 10 parts by mass, more preferably 0.05 to 5 parts by mass per 100 parts by mass of the compound (a) for forming a metal-containing film.

### <(e) Flowability Accelerator>

Another compound or polymer may be further blended in the above-described composition for forming a resist underlayer film. The flowability accelerator is mixed with the inventive compound for forming a metal-containing film and serves to improve the film-formability by spin-coating and the filling property for a stepped substrate. Furthermore, as the flowability accelerator, a material having a high density of carbon atoms and high etching resistance is preferable.

Examples of such a material include novolak resins of phenol, o-cresol, m-cresol, p-cresol, 2,3-dimethyl phenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-butylphenol, 3-tert-butylphenol, 4-tert-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-butyl-5-methylphenol, pyrogallol, thymol, isothymol, 4,4'-(9H-fluorene-9-ylidene)bisphenol, 2,2'-dimethyl-4,4'-(9H-fluorene-9-ylidene)bisphenol, 2,2'-diallyl-4,4'-(9H-fluorene-9-ylidene)bisphenol, 2,2'-difluoro-4,4'-(9H-fluorene-9-ylidene)bisphenol, 2,2'-diphenyl-4,4'-(9H-fluorene-9-ylidene)bisphenol, 2,2'-dimethoxy-4,4'-(9H-fluorene-9-ylidene)bisphenol, 2,3,2',3'-tetrahydro-(1,1')-spirobiindene-6,6'-diol, 3,3,3',3'-tetramethyl-2,3,2',3'-tetrahydro-(1,1')-spirobiindene-6,6'-diol, 3,3,3',3',4,4'-hexamethyl-2,3,2',3'-tetrahydro-(1,1')-spirobiindene-6, 6'-diol, 2,3,2',3'-tetrahydro-(1,1')-spirobiindene-5,5'-diol, 5,5'-dimethyl-3,3,3',3'-tetramethyl-2,3,2',3'-tetrahydro-(1,1')-spirobiindene-6,6'-diol, 1-naphthol, 2-naphthol, 2-methyl-1-naphthol, 4-methoxy-1-naphthol, 7-methoxy-2-naphthol, dihydroxynaphthalene, such as 1,5-dihydroxynaphthalene, 1,7-dihydroxynaphthalene, and 2,6-dihydroxynaphthalene, methyl-3-hydroxynaphthalene-2-carboxylate, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, 5-vinylnorborna-2-ene, α-pinene, β-pinene, or limonene; polyhydroxystyrene, polystyrene, polyvinylnaphthalene, polyvinylanthracene, polyvinylcarbazole, polyindene, polyacenaphthylene, polynorbornene, polycyclodecene, polytetracyclododecene, polynortricyclene, poly(meth)acrylate, and copolymers thereof. In addition, the composition may contain a naphthol dicyclopentadiene copolymer disclosed in JP2004-205685A, a fluorene bisphenol novolak resin disclosed in JP2005-128509A, an acenaphthylene copolymer disclosed in JP2005-250434A, fullerene having a phenolic group disclosed in JP2006-227391A, a bisphenol compound and a novolak resin thereof disclosed in JP2006-293298A, a novolak resin of an adamantane phenol compound disclosed in JP2006-285095A, a bisnaphthol compound and a novolak resin thereof disclosed in JP2010-122656A, a fluorene compound disclosed in JP2017-119671A, a fullerene resin compound disclosed in JP2008-158002A, and the like. The flowability accelerator is preferably contained in an amount of 0.001 to 100 parts by mass, more preferably 0.01 to 50 parts by mass based on 100 parts by mass of the inventive compound for forming a metal-containing film.

In addition, in the above-described composition for forming a resist underlayer film, it is preferable to use, as an additive for imparting filling and planarizing properties, for example, a liquid additive having a polyethylene glycol or polypropylene glycol structure, or a thermo-decomposable polymer having a weight reduction rate of 40% by mass or more on heating from 30°C to 250°C and a weight-average molecular weight of 300 to 200,000. This thermo-decomposable polymer preferably contains a repeating unit having an acetal structure represented by the following general formula (DP1) or (DP1a). 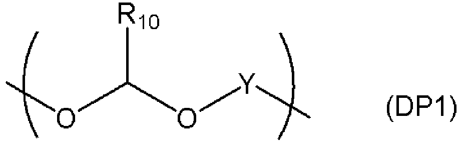 In the formula, R₁₀ represents a hydrogen atom or a substituted or unsubstituted, saturated or unsaturated monovalent organic group having 1 to 30 carbon atoms. Y represents a saturated or unsaturated divalent organic group having 2 to 30 carbon atoms. 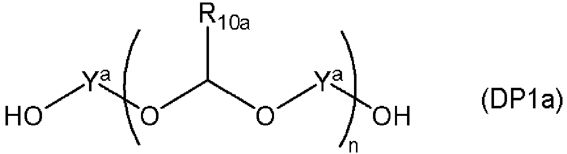 In the formula, R₁₀ₐ represents an alkyl group having 1 to 4 carbon atoms. Y^{a} represents a saturated or unsaturated divalent hydrocarbon group having 4 to 10 carbon atoms and optionally having an ether bond. "n" represents an average repeating unit number of 3 to 500.

### <(f) Acid Generator>

An acid generator (f) may be contained in the above-described composition for forming a resist underlayer film in order to promote the elimination reaction further. The acid generator (f) can be classified into those that generate an acid by thermal decomposition and those that generate an acid by optical irradiation; however, any acid generator can be added. Specific examples of the acid generator include the materials disclosed in paragraphs [0061] to [0085] of JP2007-199653A, but are not limited thereto.

One kind of the acid generator can be used, or two or more kinds can be used in combination. When an acid generator is contained, the contained amount is preferably 0.05 to 50 parts by mass, more preferably 0.1 to 10 parts by mass relative to 100 parts by mass of the compound (a) for forming a metal-containing film.

### <Method for Forming Resist Underlayer Film>

The present invention provides a method of forming, by using the above-described composition for forming a metal-containing film, a resist underlayer film of a multilayer resist film used in lithography or a filling film that serves as a planarizing film for the manufacture of semiconductor.

In the method for forming a resist underlayer film by using the inventive composition for forming a metal-containing film, the substrate to be processed is coated with the above-described composition for forming a metal-containing film by a spin-coating method or the like. Using the spin-coating method or the like ensures a desirable filling property. After spin-coating, baking (heating) is performed so as to evaporate the solvent and promote a crosslinking reaction to prevent mixing with the resist upper layer film and the resist middle layer film. The baking is preferably performed at a temperature of 100°C or higher and 600°C or lower for 10 to 600 seconds, more preferably at a temperature of 200°C or higher and 500°C or lower for 10 to 300 seconds. In consideration of influences on device damage, wafer deformation, and the like, the upper limit of the heating temperature in the wafer process of lithography is preferably not more than 600°C, and more preferably not more than 500°C.

In the method for forming a resist underlayer film where the inventive composition for forming a metal-containing film is used, a substrate to be processed may also be coated with the inventive composition for forming a metal-containing film by spin-coating or the like in the same manner as described above, and then the composition for forming a metal-containing film may be baked and cured under an atmosphere having an oxygen concentration of 0.1 volume % or more and 21 volume % or less to form a metal-containing film.

By baking the inventive composition for forming a metal-containing film in such an oxygen atmosphere, a sufficiently cured film can be obtained. The atmosphere during baking may be air; however, to prevent oxidation of the metal-containing film, it is preferable to enclose an inert gas, such as N₂, Ar, or He, therein to reduce the amount of oxygen. Control of oxygen concentration is necessary to prevent oxidation; the oxygen concentration is preferably 1000 ppm or less, more preferably 100 ppm or less (volumetric basis). By thus preventing oxidation of the metal-containing film during the baking, the absorption does not increase and the etching resistance does not decrease, which is preferable.

### <Patterning Process Using Composition for Forming Resist Underlayer Film>

The present invention provides, as a patterning process according to a two-layer resist process using the above-described composition for forming a metal-containing film, a patterning process including:
forming a metal-containing film on a substrate to be processed by using the composition for forming a metal-containing film;
forming a resist upper layer film on the metal-containing film by using a photoresist material;
subjecting the resist upper layer film to pattern exposure and then development with a developer to form a pattern in the resist upper layer film;
transferring the pattern to the metal-containing film by dry etching while using the resist upper layer film having the formed pattern as a mask; and
processing the substrate to be processed while using the metal-containing film having the formed pattern as a mask to form the pattern in the substrate to be processed.

The resist upper layer film in the two-layer resist process described above exhibits etching resistance with respect to chlorine-based gas. Therefore, the dry etching of the metal-containing film that is performed while using the resist upper layer film as a mask in the two-layer resist process is preferably performed using an etching gas mainly containing a chlorine-based gas.

The present invention provides, as a patterning process according to a three-layer resist process using the above-described composition for forming a metal-containing film, a patterning process including:
forming a metal-containing film on a substrate to be processed by using the composition for forming a metal-containing film;
forming a resist middle layer film (silicon-containing resist middle layer film) on the metal-containing film by using a material for a resist middle layer film such as a silicon-containing resist middle layer film;
forming a resist upper layer film on the resist middle layer film by using a photoresist material;
subjecting the resist upper layer film to pattern exposure and then development with a developer to form a pattern in the resist upper layer film;
transferring the pattern to the resist middle layer film by dry etching while using the resist upper layer film having the formed pattern as a mask;
transferring the pattern to the metal-containing film by dry etching while using the resist middle layer film having the transferred pattern as a mask; and
processing the substrate to be processed while using the metal-containing film having the formed pattern as a mask to form the pattern in the substrate to be processed. In the following, a case where a silicon-containing resist middle layer film is used as a resist middle layer film will be described as an example.

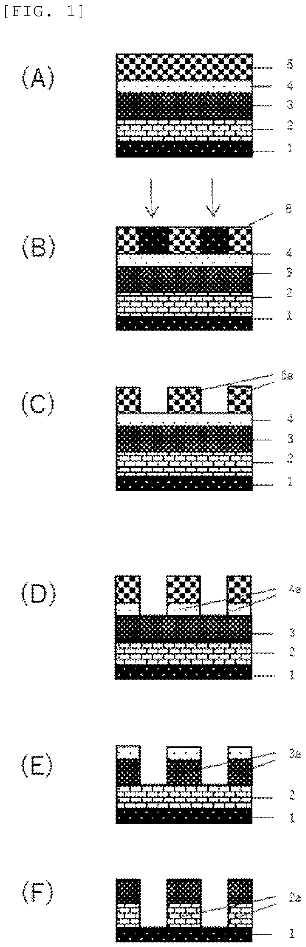

An example of a three-layer resist process specifically described with reference to FIG. 1 is as follows. In the case of a three-layer resist process, as shown in FIG. 1 (A), a metal-containing film (metal-containing resist underlayer film) 3 is formed on a layer 2 to be processed laminated on a substrate 1 to be processed by using the inventive composition for forming a metal-containing film; then, a silicon-containing resist middle layer film 4 is formed; and a resist upper layer film 5 is formed thereon.

Next, as shown in FIG. 1 (B), exposure is conducted for required portion (exposure portion) 6 of the resist upper layer film 5, followed by post-exposure baking (PEB) and development, to form a resist upper layer film pattern 5a (FIG. 1 (C)). The obtained resist upper layer film pattern 5a is then used as a mask to etch the silicon-containing resist middle layer film 4 by using a CF-based gas to form a silicon-containing resist middle layer film pattern 4a (FIG. 1 (D)). After removing the resist upper layer film pattern 5a, chlorine plasma etching of the metal-containing film 3 is performed while using the obtained silicon-containing resist middle layer film pattern 4a as a mask to form a metal-containing film pattern (metal-containing resist underlayer film pattern) 3a (FIG. 1 (E)). Further, after removing the silicon-containing resist middle layer film pattern 4a, the layer 2 to be processed is etched while using the metal-containing film pattern 3a as a mask to form a pattern 2a in the layer to be processed (FIG. 1 (F)).

The silicon-containing resist middle layer film in the three-layer resist process exhibits etching resistance with respect to a chlorine-based gas and a hydrogen-based gas. Therefore, the dry etching of the metal-containing film that is performed while using the silicon-containing resist middle layer film as a mask in the three-layer resist process is preferably performed using an etching gas mainly containing a chlorine-based gas or a hydrogen-based gas.

As the silicon-containing resist middle layer film in the three-layer resist process, a polysiloxane-based middle layer film is also favorably used. This allows the silicon-containing resist middle layer film to possess an effect as an antireflective film, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthracene for exposure at 248 nm or 157 nm, or a pendant phenyl group or a pendant light-absorbing group having a silicon-silicon bond for 193 nm exposure, and which is crosslinked by an acid or heat.

In addition, the present invention provides a patterning process by way of a four-layer resist process using such a composition for forming a metal-containing film, the patterning process including the steps of:
forming a metal-containing film on a substrate to be processed by using the above-described composition for forming a metal-containing film;
forming a silicon-containing resist middle layer film on the metal-containing film by using a silicon-containing resist middle layer film material;
forming an organic antireflective film (BARC) or an adhesive film on the silicon-containing resist middle layer film;
forming a resist upper layer film on the BARC or the adhesive film by using a photoresist material;
subjecting the resist upper layer film to pattern exposure and then development with a developer, thereby forming a pattern in the resist upper layer film;
transferring the pattern to the BARC or the adhesive film and the silicon-containing resist middle layer film by dry etching while using the resist upper layer film having the formed pattern as a mask;
transferring the pattern to the metal-containing film by dry etching while using the silicon-containing resist middle layer film having the transferred pattern as a mask; and
processing the substrate to be processed while using the metal-containing film having the formed pattern as a mask, thereby forming the pattern in the substrate to be processed.

Alternatively, an inorganic hard mask may be formed instead of the silicon-containing resist middle layer film. In this case, a semiconductor device circuit pattern can be formed on a substrate, at least, by:
forming a metal-containing film on a body to be processed by using the inventive composition for forming a metal-containing film;
forming an inorganic hard mask selected from a silicon oxide film, a silicon nitride film, and a silicon oxynitride film on the metal-containing film;
forming a resist upper layer film on the inorganic hard mask by using a photoresist composition;
forming a circuit pattern in the resist upper layer film;
etching the inorganic hard mask while using the resist upper layer film having the formed pattern as a mask;
etching the metal-containing film while using the inorganic hard mask having the formed pattern as a mask; and
furthermore, etching the body to be processed while using the metal-containing film having the formed pattern as a mask to form the pattern in the body to be processed.

As described above, when the inorganic hard mask is formed on the metal-containing film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask is preferably 5 to 200 nm, more preferably 10 to 100 nm. The SiON film, which has a high function as an antireflective film, is the most preferably used as the inorganic hard mask. Since the substrate temperature increases to 300 to 500°C when the SiON film is formed, the metal-containing film needs to withstand a temperature of 300 to 500°C. The composition for forming a metal-containing film used in the present invention has high heat resistance and can withstand a high temperature of 300 to 500°C. Thus, the metal-containing film formed by spin-coating and the inorganic hard mask formed by the CVD method or the ALD method can be combined.

A photoresist film may be formed on the inorganic hard mask as the resist upper layer film as described above. Alternatively, an organic antireflective film (BARC) or an adhesive film may be formed on the inorganic hard mask by spin-coating, and a photoresist film may be formed thereon. In particular, when a SiON film is used as the inorganic hard mask, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

In addition, the present invention provides a patterning process according to a multilayer resist process using such a composition for forming a metal-containing film. In this case, a semiconductor device circuit pattern can be formed on a substrate in the following manner:
forming a resist underlayer film on a substrate to be processed;
applying the inventive composition for forming a metal-containing film onto the resist underlayer film and then heating to form a metal-containing film;
forming a resist upper layer film on the metal-containing film by using a photoresist material;
subjecting the resist upper layer film to pattern exposure and then development with a developer to form a pattern in the resist upper layer film;
transferring the pattern to the metal-containing film by dry etching while using the resist upper layer film having the formed pattern as a mask;
transferring the pattern to the resist underlayer film by dry etching while using the metal-containing film having the transferred pattern as a mask; and
furthermore, processing the substrate to be processed while using the resist underlayer film having the formed pattern as a mask to form the pattern in the substrate to be processed.

A photoresist film may be formed on the metal-containing film as a resist upper layer film as described above. Alternatively, an organic adhesive film may be formed on the metal-containing film by spin-coating, and a photoresist film may be formed thereon. In this case, the pattern can be transferred to the organic adhesive film and the metal-containing film by dry etching.

As described above, when the resist underlayer film is formed on the substrate to be processed, the resist underlayer film can be formed by a method using a coating-type organic underlayer film material, a CVD method, an ALD method, or the like. Examples of the coating-type organic underlayer film material include resins and compositions disclosed in JP2012-001687A, JP2012-077295A, JP2004-264710A, JP2005-043471A, JP2005-250434A, JP2007-293294A, JP2008-065303A, JP2004-205685A, JP2007-171895A, JP2009-014816A, JP2007-199653A, JP2008-274250A, JP2010-122656A, JP2012-214720A, JP2014-029435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-044022A, etc.

The resist upper layer film in the multilayer resist process described above may be either a positive type or a negative type, and it is possible to use a film similar to the typically used photoresist composition. The prebaking, which is conducted after the spin-coating with the photoresist composition, is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 30 to 500 nm, particularly preferably 50 to 400 nm.

Furthermore, examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist pattern as a mask. The etching of a silicon-containing resist middle layer film or an inorganic hard mask in the three-layer resist process is performed while using the upper layer resist pattern as a mask by using a fluorocarbon-based gas. In this manner, a silicon-containing resist middle layer film pattern or an inorganic hard mask pattern is formed.

Next, the metal-containing film is etched while using the obtained silicon-containing resist middle layer film pattern or inorganic hard mask pattern as a mask. The etching of the metal-containing film is preferably performed using an etching gas mainly containing a chlorine-based gas.

The subsequent etching of the body to be processed may also be performed according to a usual manner. For example, in the case of a body to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The metal-containing film obtained by using the inventive composition for forming a metal-containing film is characterized by its excellent etching resistance at the time of etching of the body to be processed.

Examples of the body to be processed (substrate to be processed) include, but are not particularly limited to, substrates made of Si, α-Si, p-Si, SiO₂, SiN, SiON, W, TiN, Al, etc., those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

In the patterning process using the inventive composition for forming a metal-containing film, it is preferable to use a substrate to be processed having a structure or step having a height of 30 nm or more. As described above, the inventive composition for forming a metal-containing film has excellent filling and planarizing properties, so that a flat cured film can be formed even when the substrate to be processed has a step (irregularities) or structure having a height of 30 nm or more. The height of the structure or step of the substrate to be processed is preferably 30 nm or more, more preferably 50 nm or more, and more preferably 100 nm or more. In the method of processing a stepped substrate having a pattern of the above-described height, filling and planarizing by forming a film of the inventive composition for forming a metal-containing film makes it possible to achieve a uniform film thickness in the subsequently formed resist middle layer film and resist upper layer film. Therefore, it is easy to ensure the exposure depth margin (DOF) at the time of photolithography, which is very desirable.

### <Tone-Reversal Patterning Process Using Composition for Forming Metal-Containing Film>

The present invention also provides, as a tone-reversal patterning process using such a composition for forming a metal-containing film, a tone-reversal patterning process including the steps of:
forming a resist underlayer film on a substrate to be processed;
forming a resist middle layer film or a combination of an organic thin film and an inorganic hard mask middle layer film selected from a silicon oxide film, a silicon nitride film, and a silicon oxynitride film on the resist underlayer film;
forming a resist upper layer film on the resist middle layer film or the combination of the organic thin film and the inorganic hard mask middle layer film by using a photoresist material;
subjecting the resist upper layer film to pattern exposure and then development with a developer to form a pattern in the resist upper layer film;
transferring the pattern to the resist middle layer film or the organic thin film and the inorganic hard mask middle layer film by dry etching while using the resist upper layer film having the formed pattern as a mask;
transferring the pattern to the resist underlayer film by dry etching while using the resist middle layer film or the inorganic hard mask middle layer film having the transferred pattern as a mask;
covering the resist underlayer film having the formed pattern with a metal-containing film by using the above-described composition for forming a metal-containing film, thereby filling a space between the resist underlayer film patterns with the metal-containing film;
etching back the metal-containing film covering the resist underlayer film having the formed pattern by a chemical stripper or dry etching to expose an upper surface of the resist underlayer film having the formed pattern;
removing the resist middle layer film or the inorganic hard mask middle layer film remaining on the upper surface of the resist underlayer film by dry etching;
removing, by dry etching, the resist underlayer film having the formed pattern with an exposed surface to form a reverse pattern of an original pattern on the metal-containing film; and
processing the substrate to be processed while using the metal-containing film having the formed reverse pattern as a mask to form the reverse pattern in the substrate to be processed.

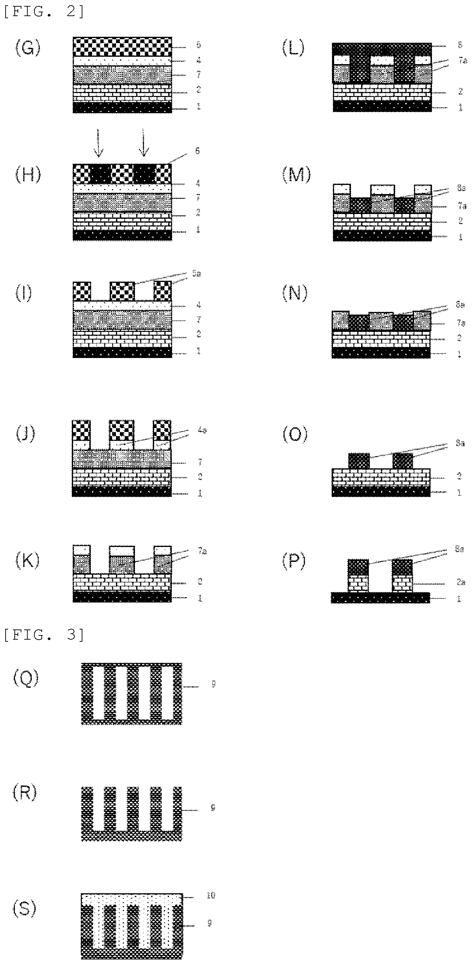

An example of formation of a tone-reversal pattern is specifically explained below by referring to FIG. 2. As shown in FIG. 2 (G), a resist underlayer film 7 formed from a coating-type organic underlayer film composition is formed on a layer 2 to be processed stacked on a substrate 1 to be processed; thereafter, a silicon-containing resist middle layer film 4 is formed, and a resist upper layer film 5 is further formed thereon.

Next, as shown in FIG. 2 (H), exposure is conducted for required portion (exposure portion) 6 of the resist upper layer film 5, followed by PEB and development, to form a resist upper layer film pattern 5a (FIG. 2 (I)). The obtained resist upper layer film pattern 5a is then used as a mask to etch the silicon-containing resist middle layer film 4 by using a CF-based gas to form a silicon-containing resist middle layer film pattern 4a (FIG. 2 (J)). After removing the resist upper layer film pattern 5a, oxygen plasma etching of the resist underlayer film 7 formed from the coating-type organic underlayer film composition is performed while using the obtained silicon-containing resist middle layer film pattern 4a as a mask to form a resist underlayer film pattern 7a formed of the coating-type organic underlayer film composition (FIG. 2 (K)).

After applying the inventive composition for forming a metal-containing film onto the resist underlayer film pattern 7a formed of the coating-type organic underlayer film composition, heating is performed to cover the resist underlayer film pattern with a metal-containing film 8, thereby filling a space between the resist underlayer film patterns 7a formed of the coating-type organic underlayer film composition with the metal-containing film (FIG. 2 (L)). Then, the metal-containing film 8 covering the resist underlayer film pattern 7a formed of the coating-type organic underlayer film composition is etched back by a chemical stripper or dry etching, thereby exposing an upper surface of the resist underlayer film pattern 7a formed of the coating-type organic underlayer film composition (FIG. 2 (M)). Further, the silicon-containing resist middle layer film pattern 4a remaining on the upper surface of the resist underlayer film pattern 7a formed of the coating-type organic underlayer film composition is removed by dry etching (FIG. 2 (N)). Subsequently, the resist underlayer film pattern 7a formed of the coating-type organic underlayer film composition is removed by dry etching to form a reverse pattern of the original pattern in the metal-containing film (form a metal-containing film pattern 8a as a reverse pattern of the resist underlayer film pattern) (FIG. 2 (O)); after this step, the substrate to be processed is processed while using the metal-containing film pattern 8a as a reverse pattern of the resist underlayer film pattern as a mask to form a tone-reversal pattern in the substrate to be processed (FIG. 2 (P)).

As described above, when the resist underlayer film is formed on the substrate to be processed, the resist underlayer film can be formed by a method using a coating-type organic underlayer film material, a CVD method, an ALD method, or the like. Examples of the coating-type organic underlayer film material include resins and compositions disclosed in JP2012-1687A, JP2012-77295A, JP2004-264710A, JP2005-043471A, JP2005-250434A, JP2007-293294A, JP2008-65303A, JP2004-205685A, JP2007-171895A, JP2009-14816A, JP2007-199653A, JP2008-274250A, JP2010-122656A, JP2012-214720A, JP2014-29435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-44022A, etc.

In the tone-reversal patterning process, after the obtained resist underlayer film pattern is coated with the composition for forming a metal-containing film, it is preferable to remove the metal-containing film by using a dry etching gas mainly containing a chlorine-based gas so as to expose the upper surface of the resist underlayer film pattern. Thereafter, the resist middle layer film or the hard mask middle layer film remaining on the resist underlayer film is removed by dry etching using a fluorocarbon-based gas, and the resist underlayer film pattern having an exposed surface is removed by dry etching using an oxygen-based gas to form a metal-containing film pattern.

In the tone-reversal patterning process described above, the resist underlayer film pattern preferably has a step or a structure with a height of 30 nm or more. As described above, the inventive composition for forming a metal-containing film has excellent filling and planarizing properties. Thus, even when the film to be processed has a step (irregularities) or a structure with a height of 30 nm or more, a flat cured film can be formed. The height of the structure or the step of the resist underlayer film pattern is preferably 30 nm or more, more preferably 50 nm or more, and still more preferably 100 nm or more. In the method of reversing the resist underlayer film pattern having a pattern with the above-described height, by performing filling and planarization by forming a film from the inventive composition for forming a metal-containing film, inversion/transfer of the pattern can be performed with a high degree of accuracy, which is very desirable. Reversing the resist underlayer film pattern by using the composition for forming a metal-containing film allows a desired resist pattern to be formed on a film to be processed with a high degree of accuracy due to the excellence in resistance in dry etching using a fluorocarbon-based gas relative to the resist underlayer film using a previously-known coating-type organic underlayer film material.

### EXAMPLES

The present invention is more specifically described below with reference to Synthesis Examples, Comparative Synthesis Examples, Examples, and Comparative Examples. However, the present invention is not limited to these Examples. To obtain molecular weight and dispersity, weight-average molecular weight (Mw) and number-average molecular weight (Mn) on standard polystyrene basis were measured by gel permeation chromatography (GPC) using tetrahydrofuran as an eluent, and dispersity (Mw/Mn) was calculated from these values.

### [Synthesis Example]

In the following Synthesis Examples and Comparative Examples, the tin compounds Sn ((Sn-1) to (Sn-5)), starting material group T ((TT1) to (TT14)), and starting material group P ((P-1) to (P-6)) shown below were used. The respective starting material groups are shown below. Note that, regarding the compounds of the following (TT2), (TT3), (TT5), and (P-3), isomers exist as explained above, but one structure is shown as a representative.

### Tin compounds Sn:

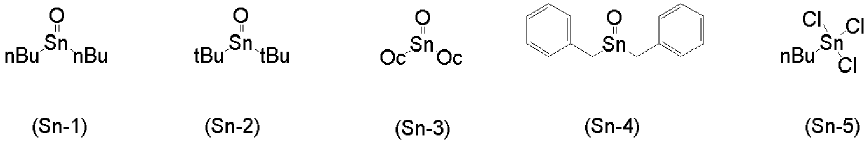

"nBu" represents an n-butyl group, "tBu" represents a tert-butyl group, and "Oc" represents an n-octyl group.

### Starting material group T:

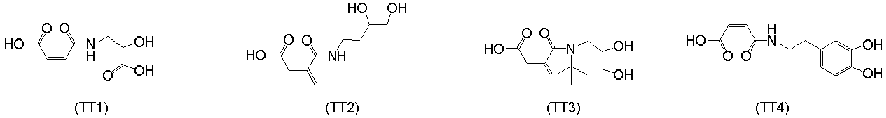

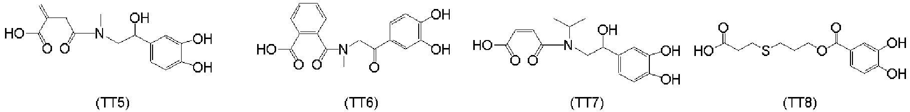

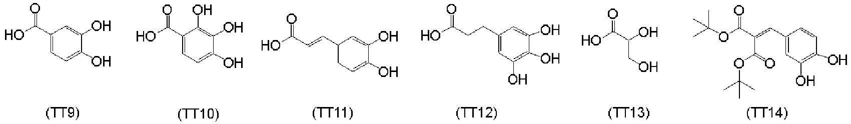

### Starting material group P:

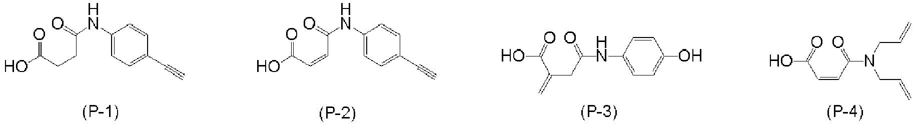

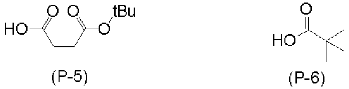

### [Synthesis Example 1] Synthesis of Compound (M-1) for Forming Metal-Containing Film

(Reaction 1) 5.0 g of the tin compound (Sn-1), 1.9 g of the starting material (TT1), and 100 g of toluene were added together, and a reaction was allowed to take place at 130°C for 5 hours while removing water.
(Reaction 2) The product was restored to room temperature, 2.5 g of (Sn-1) was additionally added, and a reaction was allowed to take place at 130°C for a further 5 hours while removing water. The toluene was removed under reduced pressure and suspension in methanol, filtration, and washing were performed to give a compound (M-1).

### [Synthesis Examples 2 to 8] Synthesis of Compounds (M-2) to (M-8) for Forming Metal-Containing Film

The tin compound and the starting material T were changed as shown in Table 1, and compounds (M-2) to (M-8) for forming a metal-containing film were obtained in the same manner as in Synthesis Example 1.

**[Table 1]**

| | Reaction 1 | | | | Reaction 2 | |
|---|---|---|---|---|---|---|
| Compound | Starting material Sn | Amount of starting material Sn used | Starting material T | Amount of starting material T used | Starting material Sn | Amount of starting material Sn used |
| (M-1) | (Sn-1) | 5.0 g | (TT1) | 1.9 g | (Sn-1) | 2.5 g |
| (M-2) | (Sn-2) | 5.0 g | (TT2) | 4.4 g | (Sn-2) | 2.5 g |
| (M-3) | (Sn-3) | 5.0 g | (TT3) | 3.6 g | (Sn-3) | 2.5 g |
| (M-4) | (Sn-4) | 5.0 g | (TT4) | 4.0 g | (Sn-1) | 2.0 g |
| (M-5) | (Sn-1) | 5.0 g | (TT5) | 5.9 g | (Sn-2) | 2.5 g |
| (M-6) | (Sn-1) | 5.0 g | (TT6) | 6.6 g | (Sn-2) | 2.5 g |
| (M-7) | (Sn-1) | 5.0 g | (TT7) | 6.2 g | (Sn-2) | 2.5 g |
| (M-8) | (Sn-1) | 5.0 g | (TT8) | 6.0 g | (Sn-1) | 2.5 g |

### [Synthesis Example 9] Synthesis of Compound (M-9) for Forming Metal-Containing Film

(Reaction 1) 5.0 g of the tin compound (Sn-1), 3.1 g of the starting material (TT9), and 100 g of toluene were added together, and a reaction was allowed to take place at 130°C for 5 hours while removing water.
(Reaction 2) The product was restored to room temperature, 2.8 g of (Sn-5) and 2.2 g of (P-1) were additionally added, and a reaction was allowed to take place at 130°C for 12 hours. The toluene was removed under reduced pressure and suspension in methanol, filtration, and washing were performed to give a compound (M-9).

### [Synthesis Examples 10 to 16] Synthesis of Compounds (M-10) to (M-16) for Forming Metal-Containing Film

The tin compound and the starting material T were changed as shown in Table 2, and compounds (M-10) to (M-16) for forming a metal-containing film were obtained in the same manner as in Synthesis Example 9.

**[Table 2]**

| | Reaction 1 | | | | Reaction 2 | | | |
|---|---|---|---|---|---|---|---|---|
| Compound | Starting material Sn | Amount of starting material Sn used | Starting material T | Amount of starting material T used | Starting material Sn | Amount of starting material Sn used | Starting material P | Amount of starting material P used |
| (M-9) | (Sn-1) | 5.0 g | (TT9) | 3.1 g | (Sn-5) | 2.8 g | (P-1) | 2.2 g |
| (M-10) | (Sn-1) | 5.0 g | (TT10) | 3.4 g | (Sn-5) | 2.8 g | (P-2) | 2.2 g |
| (M-11) | (Sn-1) | 5.0 g | (TT11) | 4.0 g | (Sn-5) | 2.8 g | (P-3) | 2.2 g |
| (M-12) | (Sn-1) | 5.0 g | (TT12) | 3.6 g | (Sn-5) | 2.8 g | (P-4) | 2.0 g |
| (M-13) | (Sn-1) | 5.0 g | (TT13) | 2.1 g | (Sn-5) | 2.8 g | (P-3) | 2.2 g |
| (M-14) | (Sn-1) | 5.0 g | (TT5) | 5.6 g | (Sn-5) | 2.8 g | (P-5) | 1.7 g |
| (M-15) | (Sn-1) | 5.0 g | (TT9) | 1.5 g | (Sn-5) | 2.8 g | (P-6) | 1.0 g |
| | | | (TT13) | 1.1 g | | | | |
| (M-16) | (Sn-1) | 5.0 g | (TT4) | 2.5 g | (Sn-5) | 2.8 g | - | - |
| | | | (TT11) | 2.0 g | | | | |

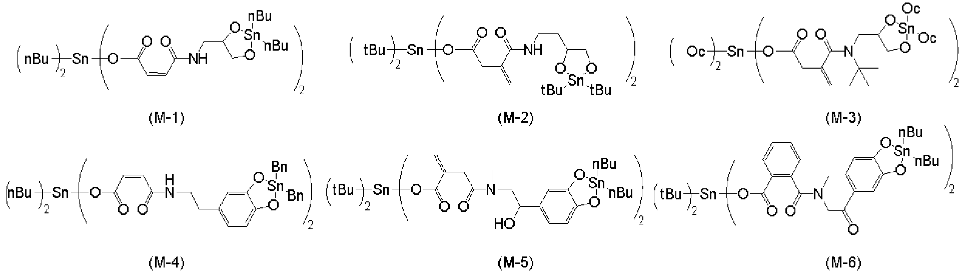

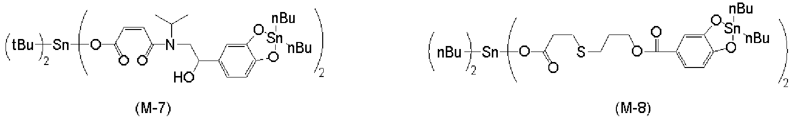

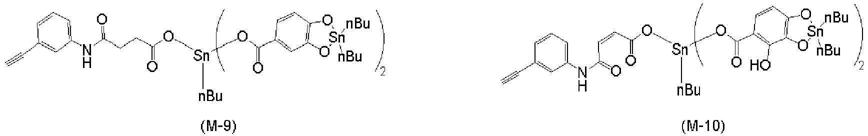

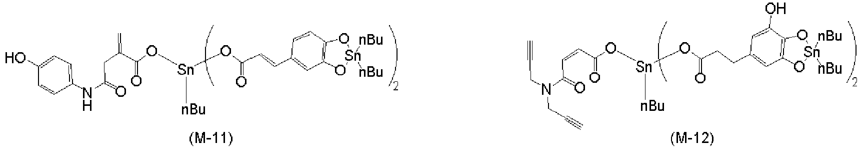

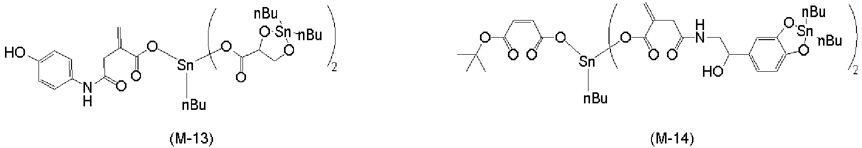

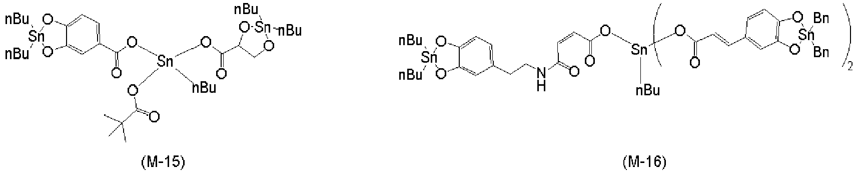

In the formulae, Bn represents a benzyl group.

### [Synthesis of Compound (R-1) for Forming Metal-Containing Film for Comparative Example]

5.0 g of the tin compound (Sn-1), 8.6 g of the starting material group P (P-2), and 100 g of toluene were added together, and a reaction was allowed to take place at 130°C for 7 hours while removing water. After the reaction, the solvent was removed under reduced pressure to give (R-1).

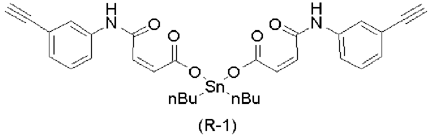

### [Synthesis of Compound (R-2) for Forming Metal-Containing Film for Comparative Example]

5.0 g of the tin compound (Sn-1), 6.8 g of the starting material group T (TT14), and 50 g of toluene were added together, and a reaction was allowed to take place at 130°C for 7 hours while removing water. After the reaction, the solvent was removed under reduced pressure to give (R-2).

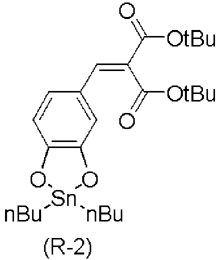

### [Weight-Average Molecular Weight and Dispersity]

The weight-average molecular weight (Mw) and the dispersity (Mw/Mn) of the compounds (M-1) to (M-16), (R-1), and (R-2) were determined. Table 3 shows the results. Incidentally, the weight-average molecular weight Mw and the number-average molecular weight Mn are values measured in terms of polystyrene by GPC using tetrahydrofuran, and the dispersity was calculated therefrom.

**[Table 3]**

| Compound | Mw | Mw/Mn |
|---|---|---|
| M-1 | 612 | 1.13 |
| M-2 | 579 | 1.19 |
| M-3 | 564 | 1.21 |
| M-4 | 658 | 1.16 |
| M-5 | 649 | 1.17 |
| M-6 | 708 | 1.09 |
| M-7 | 731 | 1.13 |
| M-8 | 747 | 1.11 |
| M-9 | 643 | 1.33 |
| M-10 | 629 | 1.28 |
| M-11 | 704 | 1.27 |
| M-12 | 753 | 1.55 |
| M-13 | 691 | 1.31 |
| M-14 | 801 | 1.32 |
| M-15 | 605 | 1.41 |
| M-16 | 762 | 1.33 |
| R-1 | 152 | 1.02 |
| R-2 | 356 | 1.07 |

### [Synthesis of Compound (R-3) for Forming Metal-Containing Film for Comparative Example]

As a metal-containing compound assumed to be used for a photoresist, the tin compound reported in [Synthesis Example 8] of JP7028940B2 was synthesized.

3 g of isopropyltriphenyltin and 1.4 g of succinic acid were dissolved in 20 ml of acetonitrile, and then refluxed for 24 hours. After the reaction, the solvent was removed under reduced pressure to give a tin-containing compound (R-3).

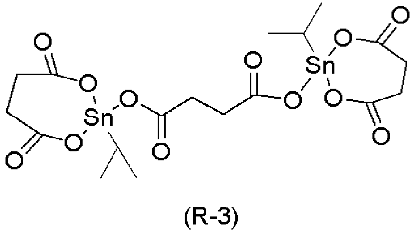

### [Synthesis of Compound (R-4) for Forming Metal-Containing Film for Comparative Example]

10 g of catechol, 6.6 g of formaldehyde, and 30 g of PGME (propylene glycol monomethyl ether) were added together, and homogenized at an internal temperature of 100°C. After that, a mixed solution of 0.2 g of p-toluenesulfonic acid monohydrate and 3.0 g of PGME that had been mixed and homogenized beforehand was slowly added dropwise thereto, and a reaction was allowed to take place at an internal temperature of 120°C for 8 hours. After the reaction was completed, the product was restored to room temperature, 150 g of ultrapure water was added thereto while stirring, the mixture was left to stand for 1 hours, and then the upper layer was fractionated. Furthermore, the resultant was dissolved in 30 g of PGME, and the same operation was repeated twice. After that, 300 ml of MIBK (methyl isobutyl ketone) was added thereto, the product was washed four times with 200 ml of pure water, and the organic layer was evaporated under reduced pressure to dryness. After that, 20 g of the tin material (Sn-1) and 300 g of toluene were added thereto, and the mixture was stirred at 130°C for 8 hours. After the reaction, the solvent was removed under reduced pressure to give (R-4).

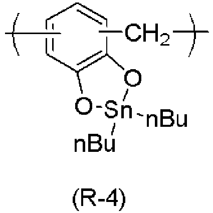

### [Synthesis of Compound (R-5) for Forming Metal-Containing Film for Comparative Example]

As a compound having a different metal from the inventive compound for forming a metal-containing film, a titanium compound reported in [Synthesis Example A-II] of JP6189758B2 was synthesized.

An isopropyl alcohol (IPA) solution (500 g) of deionized water (27 g) was dropped while stirring into an IPA solution (500 g) of a titanium tetraisopropoxide (manufactured by Tokyo Chemical Industry Co., Ltd.) (284 g) at room temperature for 2 hours. 2-methyl-2,4-pentanediol (120 g) was added to the obtained solution and agitated at room temperature for 30 minutes. After the solution was concentrated under reduced pressure at 30°C, it was heated to 60°C and heating was continued under reduced pressure to generate no distillate. Then, PGMEA (1,200 g) was added thereto and heated under reduced pressure at 40°C until no IPA was distilled to obtain a PGMEA solution of a titanium-containing compound (R-5) (1,000 g) (compound concentration: 20 mass%).

### [Synthesis of Resin (R-6) for Forming Organic Film for Comparative Example]

Under a nitrogen atmosphere, 160.2 g of 1,5-dihydroxynaphthalene, 56.8 g of formaldehyde, and 300 g of propylene glycol monomethyl ether (PGME) were added together, and homogenized at an internal temperature of 100°C. After that, a mixed solution of 8.0 g of p-toluenesulfonic acid monohydrate and 8.0 g of PGME that had been mixed and homogenized beforehand was added dropwise slowly, and a reaction was allowed to take place at an internal temperature of 80°C for 8 hours. After the reaction was completed, the product was cooled to room temperature, and 2,000 ml of MIBK was added thereto. The product was washed six times with 500 ml of pure water, and the organic layer was evaporated under reduced pressure to dryness. After adding 300 g of THF to the residue to yield a homogeneous solution, a crystal was precipitated in 2,000 g of hexane. The precipitated crystal was separated by filtration, washed twice with 500 g of hexane, and collected. The collected crystal was vacuum-dried at 70°C, thereby obtaining a resin (R-6).

The weight-average molecular weight (Mw) and the dispersity (Mw/Mn) were determined by GPC, and the following results were obtained.

### (R-6): Mw=3,300, Mw/Mn=2.54

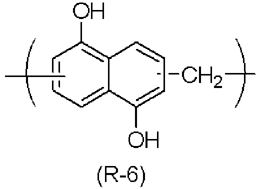

### [Solvent Solubility and Heat Resistance Evaluation]

The solvent solubility and heat resistance of the compounds containing metal were evaluated.

Each of the compounds (M-1) to (M-16), synthesized in Synthesis Examples 1 to 16, and the comparative compounds (R-1) to (R-5) was respectively prepared to obtain a 15.0 wt% solution in propylene glycol monomethyl ether acetate (PGMEA) and cyclohexanone (CyHO). After stirring for 24 hours, a compound that was completely dissolved was evaluated as "Good", a compound that was partly undissolved was evaluated as "Fair", and a compound that was completely suspended was evaluated as "Poor". In addition, for an evaluation of a weight reduction rate, 3.0 mg of each compound was weighed, and using Thermo plus EVO2 manufactured by Rigaku Corporation, the temperature was raised from 30°C to 300°C at 10°C/minute in the atmosphere. In this event, when the temperature was raised to 300°C, the weight reduction rate of the compound was 40% or less, the compound was evaluated as A, when the rate was 40 to 60%, as B, and when the weight was reduced by 60% or more, as C. These results are shown in Table 4.

**[Table 4]**

| Compound | Solvent solubility | | Weight reduction |
|---|---|---|---|
| | PGMEA | CyHO | |
| (M-1) | Fair | Good | A |
| (M-2) | Fair | Good | A |
| (M-3) | Fair | Good | A |
| (M-4) | Fair | Good | A |
| (M-5) | Fair | Good | A |
| (M-6) | Fair | Good | A |
| (M-7) | Fair | Good | A |
| (M-8) | Fair | Good | A |
| (M-9) | Good | Good | A |
| (M-10) | Good | Good | A |
| (M-11) | Good | Good | A |
| (M-12) | Good | Good | A |
| (M-13) | Good | Good | A |
| (M-14) | Good | Good | A |
| (M-15) | Good | Good | A |
| (M-16) | Good | Good | A |
| (R-1) | Fair | Good | A |
| (R-2) | Fair | Good | B |
| (R-3) | Fair | Good | C |
| (R-4) | Poor | Poor | A |
| (R-5) | Good | Good | B |

As shown in Table 4, it was observed that it was possible to prepare solutions of the inventive compounds (M-1) to (M-16) for forming a metal-containing film in cyclohexanone, and that solubility was also sufficient. In addition, it was observed that, regarding the compounds (M-9) to (M-16) for forming a metal-containing film, in which the symmetry of the compound was broken, it was also possible to prepare a solution in PGMEA, and that excellent solvent solubility was exhibited. Meanwhile, regarding the comparative compounds which were in the compound group similarly having an element of the present invention partially removed, equivalent solubility was exhibited, but (R-4), having a structure in which tin was introduced to all the repeating units of the polymer, had absolutely no solubility. Meanwhile, in the TG-DTA measurement, all the inventive compounds had a weight reduction rate of 40% or less when the temperature was raised to 300°C, but regarding the comparative compounds, (R-2) had a reduction rate of 49%, (R-3) had a reduction rate of 68%, and (R-5) had a reduction rate of 56%, and it was observed that the inventive compounds had better heat resistance than the comparative compounds.

### [Composition UDL-1 for Forming Metal-Containing Film]

The compound (M-1) for forming a metal-containing film was dissolved at a ratio shown in Table 5 in a solvent of cyclohexanone (CyHO) containing 0.5 mass% of a surfactant FC-4430 (manufactured by Sumitomo 3M Limited), and the solution was filtered through a 0.2-µm membrane filter to prepare a composition (UDL-1) for forming a metal-containing film.

### [Preparation of Compositions (UDL-2 to -23) for Forming Metal-Containing Film and Compositions (Comparative UDL-1 to -5) for Forming Metal-Containing Film for Comparative Examples]

Each chemical liquid was prepared in the same manner as UDL-1, except that the type and the contained amount of each component were as shown in Table 5. In Table 5, "-" indicates that the component was not used. The following formula (C-1) was used for the crosslinking agent, 1,6-diacetoxyhexane (boiling point: 260°C) was used as the high-boiling-point solvent (B2-1), a polymer (E-1) for a flowability accelerator was used, and the formula (F-1), shown later, was used for the thermal acid generator (TAG).

### [Crosslinking Agent]

The crosslinking agent (C-1) used in a composition for forming a metal-containing film is shown below.

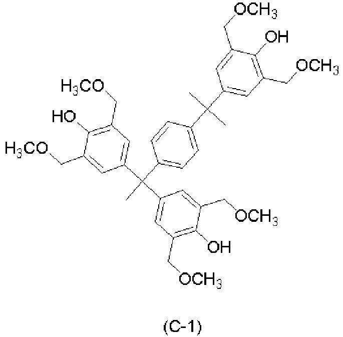

### [Synthesis Example of Polymer for Flowability Accelerator] Synthesis of Polymer (E-1) for Flowability Accelerator

Under a nitrogen atmosphere, 20.0 g of cresol novolak, 27.6 g of potassium carbonate, and 100 g of DMF were added together to form a homogeneous dispersion at an internal temperature of 50°C. 11.9 g of propargyl bromide was slowly added thereto, and a reaction was allowed to take place at an internal temperature of 50°C for 24 hours. To the reaction solution, 300 ml of methyl isobutyl ketone and 300 g of pure water were added to dissolve the precipitated salt, and then the separated aqueous layer was removed. Furthermore, the organic layer was washed six times with 100 g of a 3% aqueous nitric acid solution and 100 g of pure water, and then the organic layer was evaporated under reduced pressure to dryness to obtain a resin (E-1).

The weight-average molecular weight (Mw) and the dispersity (Mw/Mn) were determined by GPC, and the following results were obtained.

### (E-1): Mw=8,500, Mw/Mn=3.46

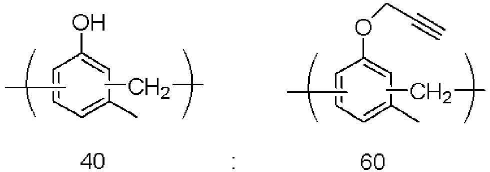

### [Thermal Acid Generator]

The thermal acid generator (F-1) used in a composition for forming a metal-containing film is shown below.

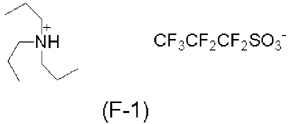

**[Table 5]**

| Composition for forming metal-containing film | Resin (parts by mass) | Additive (parts by mass) | Solvent (parts by mass) |
|---|---|---|---|
| UDL-1 | M-1 (15) | - | CyHO (85) |
| UDL-2 | M-2 (15) | - | CyHO (85) |
| UDL-3 | M-3 (15) | - | CyHO (85) |
| UDL-4 | M-4 (15) | - | CyHO (85) |
| UDL-5 | M-5 (15) | - | CyHO (85) |
| UDL-6 | M-6 (15) | - | CyHO (85) |
| UDL-7 | M-7 (15) | - | CyHO (85) |
| UDL-8 | M-8 (15) | - | CyHO (85) |
| UDL-9 | M-9 (15) | - | PGMEA (85) |
| UDL-10 | M-10 (15) | - | PGMEA (85) |
| UDL-11 | M-11 (15) | - | PGMEA (85) |
| UDL-12 | M-12 (15) | - | PGMEA (85) |
| UDL-13 | M-13 (15) | - | PGMEA (85) |
| UDL-14 | M-14 (15) | - | PGMEA (85) |
| UDL-15 | M-15 (15) | - | PGMEA (85) |
| UDL-16 | M-16 (15) | - | PGMEA (85) |
| UDL-17 | M-5 (13) | C-1 (2) | CyHO (85) |
| UDL-18 | M-6 (13) | C-1 (2) | CyHO (85) |
| UDL-19 | M-8 (13) | C-1 (2) | CyHO (85) |
| UDL-20 | M-10 (13) | C-1 (2) | PGMEA (85) |
| UDL-21 | M-5 (13) | E-1 (2) | CyHO (85) |
| UDL-22 | M-14 (15) | F-1 (1) | PGMEA (85) |
| UDL-23 | M-10 (15) | - | PGMEA (82.5)+ B2-1 (2.5) |
| Comparative UDL-1 | R-1 (15) | - | PGMEA (85) |
| Comparative UDL-2 | R-2 (15) | - | CyHO (85) |
| Comparative UDL-3 | R-3 (15) | - | CyHO (85) |
| Comparative UDL-4 | R-5 (15) | - | PGMEA (85) |
| Comparative UDL-5 | R-6 (10) | - | PGMEA (90) |

### [Film-Formability Test]

Each of the compositions (UDL-1 to -23 and comparative UDL-1 to -4) for forming a metal-containing film prepared as described above was respectively applied onto a silicon substrate, baked at 180°C for 60 seconds, then additionally baked at 250°C for 60 seconds, and then the film thickness (a [nm]) was measured. Furthermore, the film thickness was measured from the center of the substrate to the periphery, and the difference Range (b [nm]) between the maximum film thickness and the minimum film thickness out of the measured values was calculated, and the in-plane uniformity ((b/a) × 100) was determined.

Furthermore, a PGMEA solvent was dispensed thereon, left to stand for 30 seconds, spin-dried, and baked at 100°C for 60 seconds to evaporate the PGMEA (Rework), and then the film thickness (c [nm]) was measured. The difference between the film thicknesses (film remaining percentage: (c/a) × 100) before and after the PGMEA treatment was determined. The following Table 6 shows the results.

**[Table 6]**

| Example | Composition for forming metal-containing film | Film thickness (a) | Range (b) | In-plane uniformity | Film thickness (c) | Film remaining percentage |
|---|---|---|---|---|---|---|
| | | nm | nm | % | nm | % |
| Example 1-1 | UDL-1 | 135.3 | 3.5 | 2.6% | 135.2 | 99.9% |
| Example 1-2 | UDL-2 | 140.9 | 6.5 | 4.6% | 140.9 | 100.0% |
| Example 1-3 | UDL-3 | 115.0 | 5.1 | 4.4% | 115.0 | 100.0% |
| Example 1-4 | UDL-4 | 110.3 | 3.5 | 3.2% | 110.4 | 100.1% |
| Example 1-5 | UDL-5 | 134.9 | 5.4 | 4.0% | 134.8 | 99.9% |
| Example 1-6 | UDL-6 | 146.5 | 5.3 | 3.6% | 146.1 | 99.7% |
| Example 1-7 | UDL-7 | 159.8 | 4.1 | 2.6% | 159.8 | 100.0% |
| Example 1-8 | UDL-8 | 150.3 | 1.2 | 0.8% | 150.3 | 100.0% |
| Example 1-9 | UDL-9 | 128.1 | 2.4 | 1. 9% | 128.0 | 99.9% |
| Example 1-10 | UDL-10 | 134.1 | 3.0 | 2.2% | 134.1 | 100.0% |
| Example 1-11 | UDL-11 | 156.5 | 3.4 | 2.2% | 156.6 | 100.1% |
| Example 1-12 | UDL-12 | 127.7 | 2.4 | 1.9% | 127.6 | 99.9% |
| Example 1-13 | UDL-13 | 146.9 | 5.6 | 3.8% | 146.9 | 100.0% |
| Example 1-14 | UDL-14 | 136.2 | 6.1 | 4.5% | 136.1 | 99.9% |
| Example 1-15 | UDL-15 | 146.6 | 6.9 | 4.7% | 146.4 | 99.9% |
| Example 1-16 | UDL-16 | 160.1 | 5.8 | 3.6% | 160.1 | 100.0% |
| Example 1-17 | UDL-17 | 141.7 | 5.5 | 3.9% | 142.0 | 100.2% |
| Example 1-18 | UDL-18 | 156.8 | 5.2 | 3.3% | 156.9 | 100.1% |
| Example 1-19 | UDL-19 | 161.9 | 1.1 | 0.7% | 161.9 | 100.0% |
| Example 1-20 | UDL-20 | 150.9 | 2.8 | 1.9% | 150.9 | 100.0% |
| Example 1-21 | UDL-21 | 144.6 | 5.4 | 3.7% | 144.7 | 100.1% |
| Example 1-22 | UDL-22 | 133.4 | 6.2 | 4.6% | 133.4 | 100.0% |
| Example 1-23 | UDL-23 | 131.1 | 2.9 | 2.2% | 131.0 | 99.9% |
| Comparative Example 1-1 | Comparative UDL-1 | 104.1 | 5.5 | 5.3% | 104.1 | 100.0% |
| Comparative Example 1-2 | Comparative UDL-2 | 121.1 | 7.3 | 6.0% | 121.1 | 100.0% |
| Comparative Example 1-3 | Comparative UDL-3 | 69.1 | 29.0 | 42.0% | 69.0 | 99.9% |
| Comparative Example 1-4 | Comparative UDL-4 | 89.5 | 8.9 | 9.9% | 89.4 | 99.8% |

As shown in Table 6, the inventive compositions for forming a metal-containing film (Examples 1-1 to 1-23) had in-plane uniformity of 5.0% or less after the additional high-temperature baking at 250°C, and it was confirmed that it was possible to form a flat film with few irregularities, and that the film was excellent in film-formability. On the other hand, in Comparative Examples 1-1 and 1-2, using the comparative compound (R-1), not having the T unit of the present invention and only having one tin atom per molecule, and the comparative compound (R-2), consisting only of T units, in-plane uniformity was comparatively good, but was inferior to the in-plane uniformity in the Examples, using the compound group of the present invention. This is thought to be because there were few radical active units of Sn-alkyl bonds, so that crosslinking caused by radicals did not occur efficiently, and irregularities occurred in the film due to sublimation products and decomposed products. Meanwhile, in Comparative Example 1-3, using the comparative compound (R-3), having multiple tin atoms per molecule but having no diol unit and consisting only of an ester, significant irregularities occurred in the film due to the influence of insufficient molecular weight and sublimation products. In Comparative Example 1-4, using comparative UDL-4, containing the titanium compound (R-5) reported in [Synthesis Example A-II] of JP6189758B2, a film having many irregularities with an in-plane uniformity of over 5.0% after the baking was formed, and film-formability was poor. This is conjectured to be because a titanium compound has poor heat resistance and produces a large amount of sublimation products, and also undergoes significant volume shrinkage and so forth.

Meanwhile, in Examples 1-17 to 1-20, using UDL-17 to -20, containing the crosslinking agent (C-1), in-plane uniformity was improved compared to Examples 1-5, -6, -8, and -10, using UDL-5, -6, -8, and -10, not containing the crosslinking agent. This is thought to be because the crosslinking reaction progressed more efficiently by virtue of the crosslinking agent, and the generation of sublimation products and decomposition products was successfully suppressed. Meanwhile, in Example 1-22, using UDL-22, containing the acid generator (F-1), the film remaining percentage after the reworking was higher than in Example 1-14, where the acid generator was not contained, and it was indicated that the crosslinking reaction progressed further. Besides the above, comparing the Examples in which the flowability accelerator or the high-boiling-point solvent was contained and the Examples in which the additives were not contained, it was also observed that there was no great difference in in-plane uniformity or the film remaining percentage after the reworking.

### [Filling Property Evaluation]

Each of the compositions (UDL-1 to -23) for forming a metal-containing film and the comparative UDL-3 and -4 was respectively applied onto an SiO₂ wafer substrate having a dense line-and-space pattern (line width = 40 nm, line depth = 120 nm, distance between the centers of two adjacent lines = 80 nm), followed by heating at 250°C for 60 seconds by using a hot plate to form a metal-containing film having a film thickness of 100 nm. The substrate used was a base substrate 9 (SiO₂ wafer substrate) having a dense line-and-space pattern shown in FIG. 3 (Q) (downward view) and (R) (cross-sectional view). The cross-sectional shape of each of the obtained wafer substrates was observed using an electron microscope (S-4700: manufactured by Hitachi, Ltd.), and it was confirmed whether or not it was possible to fill a stepped substrate. Table 7 shows the results. In this evaluation, when a composition for forming a metal-containing film having a poor filling property is used, it is not possible to fill a stepped substrate well. In this evaluation, when a composition for forming a metal-containing film having a desirable filling property is used, as shown in FIG. 3 (S), the space between the lines of the base substrate 9 having the dense line-and-space pattern can be filled without voids. "Good" means filling was possible without large voids, "Fair" means filling was possible but large voids occurred, and "Poor" means filling was not possible.

**[Table 7]**

| Example | Composition for forming metal-containing film | Filling property |
|---|---|---|
| Example 2-1 | UDL-1 | Good |
| Example 2-2 | UDL-2 | Good |
| Example 2-3 | UDL-3 | Good |
| Example 2-4 | UDL-4 | Good |
| Example 2-5 | UDL-5 | Good |
| Example 2-6 | UDL-6 | Good |
| Example 2-7 | UDL-7 | Good |
| Example 2-8 | UDL-8 | Good |
| Example 2-9 | UDL-9 | Good |
| Example 2-10 | UDL-10 | Good |
| Example 2-11 | UDL-11 | Good |
| Example 2-12 | UDL-12 | Good |
| Example 2-13 | UDL-13 | Good |
| Example 2-14 | UDL-14 | Good |
| Example 2-15 | UDL-15 | Good |
| Example 2-16 | UDL-16 | Good |
| Example 2-17 | UDL-17 | Good |
| Example 2-18 | UDL-18 | Good |
| Example 2-19 | UDL-19 | Good |
| Example 2-20 | UDL-20 | Good |
| Example 2-21 | UDL-21 | Good |
| Example 2-22 | UDL-22 | Good |
| Example 2-23 | UDL-23 | Good |
| Comparative Example 2-1 | Comparative UDL-3 | Poor |
| Comparative Example 2-2 | Comparative UDL-4 | Fair |

As shown in Table 7, it was confirmed that in Examples 2-1 to 2-23, using the compositions of the present invention for forming a resist metal-containing film, it was possible to fill the dense line-and-space pattern without the generation of voids when the baking at 250°C was performed, and excellent filling property was provided. On the other hand, in Comparative Example 2-1, using comparative UDL-3, which had poor film-formability, it was not possible to perform the filling, and in Comparative Example 2-2, using comparative UDL-4, containing the titanium compound (R-5) reported in [Synthesis Example A-II] of JP6189758B2, voids were observed at the bottom of the pattern. It is conjectured that, as observed in the heat resistance evaluation and the film-formability evaluation, the inventive compounds generated little sublimation product caused by high-temperature baking, and underwent little volume shrinkage, so that it was possible to fill the steps without generating voids, whereas comparative UDL-3 and -4, having poor heat resistance, generated a large amount of sublimation product and underwent great volume shrinkage and so forth, so that voids were generated or it was not possible to perform the filling.

### [Tin Content/Etching Resistance Test]

Each of the compositions (UDL-1, -2, -5, -7, -13, -15 to -17, and -19) for forming a metal-containing film, comparative UDL-1 and -2, having comparatively good in-plane uniformity, and comparative UDL-5, being a composition for forming an organic film, prepared in the above was respectively applied onto a silicon substrate and heated using a hot plate at 250°C for 60 seconds, 120 seconds in the case of comparative UDL-5, to form a metal-containing films and an organic film. The element ratio on the surface was calculated using XPS K-ALPHA Surface Analysis (Thermo SCIENTIFIC), and the results were converted into % by mass. Furthermore, etching tests were conducted with a CF-based gas and an O₂-based gas under the following conditions, and the difference in the film thicknesses of the formed film before and after the etching was determined. The results are shown in Table 8. For the etching, a dry etching apparatus TE-8500, manufactured by Tokyo Electron Ltd., was used.

Conditions of etching with a CF₄-based gas were as follows.

| | |
|---|---|
| Chamber pressure: | 200 mT |
| RF power: | 300 W |
| CF₄ gas flow rate: | 100 sccm |
| Time: | 20 sec |

Conditions of etching with an O₂-based gas were as follows.

| | |
|---|---|
| Chamber pressure: | 500 mT |
| RF power: | 100 W |
| O₂ gas flow rate: | 30 sccm |
| N₂ gas flow rate: | 270 sccm |
| Time: | 20 sec |

**[Table 8]**

| Example | Composition for forming metal-containing film | Tin content | Difference in film thickness | |
|---|---|---|---|---|
| | | (wt%) | CF₄ gas | O₂-based gas |
| Example 3-1 | UDL-1 | 88.6 | 8 nm | 3 nm |
| Example 3-2 | UDL-2 | 88.1 | 8 nm | 3 nm |
| Example 3-3 | UDL-5 | 86.3 | 9 nm | 4 nm |
| Example 3-4 | UDL-7 | 83.2 | 9 nm | 4 nm |
| Example 3-5 | UDL-13 | 80.3 | 10 nm | 4 nm |
| Example 3-6 | UDL-15 | 79.1 | 12 nm | 5 nm |
| Example 3-7 | UDL-16 | 78.3 | 11 nm | 5 nm |
| Example 3-8 | UDL-17 | 71.2 | 14 nm | 6 nm |
| Example 3-9 | UDL-19 | 76.2 | 13 nm | 6 nm |
| Comparative Example 3-1 | Comparative UDL-1 | 53.2 | 25 nm | 11 nm |
| Comparative Example 3-2 | Comparative UDL-2 | 54.3 | 24 nm | 12 nm |
| Comparative Example 3-3 | Comparative UDL-5 | 0 | 35 nm | 39 nm |

As shown in Table 8, it was confirmed that in Examples 3-1 to 3-9, using the compositions of the present invention for forming a resist metal-containing film, the tin content in the film after the baking was over 70 wt% regardless of whether or not an additive was contained. On the other hand, in Comparative Examples 3-1 and 3-2, using comparative UDL-1 and -2, having only one tin atom per molecule, the tin content was a little less than 55 wt%, and it was confirmed that the tin content was poor. Furthermore, in Examples 3-1 to 3-5, using UDL-1, -2, -5, -7, and -13, containing no additives, the tin content was 80 wt% or more, and it was shown that the films after the baking had a high tin content, it was confirmed that a film having a high tin content can be achieved by multiple tin atoms being contained in one molecule, and it was shown that the release of secondary electrons caused by EUV light absorbance can be expected. Furthermore, in the etching resistance evaluation, the higher the tin content, the better the etching resistance to both the CF-based gas and the O₂-based gas, and in particular, regarding O₂ etching, etching resistance was greatly improved compared to Comparative Example 3-3, using the organic underlayer film not containing tin.

From the above, the compound of the present invention for forming a metal oxide film is an organotin compound having both high heat resistance and a high tin content, so that a composition for forming a metal-containing film containing the compound can provide a resist underlayer film material having better dry etching resistance than conventional organic underlayer film materials and also having both film-formability and filling property. Therefore, such a composition is extremely useful as a resist underlayer film material used in a multilayer resist method and an inverting agent used in a tone-reversal etching method.

The present description includes the following embodiments.
[1]: A compound for forming a metal-containing film, represented by the following general formula (M), 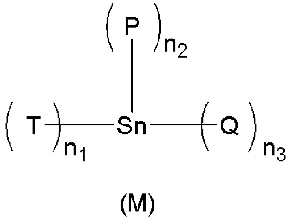 wherein T independently represents the following general formula (T-1) or (T-2); P independently represents *OCOR, "*" representing an attachment point to the Sn atom and R representing a monovalent organic group; Q independently represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, a halogen atom, or an alkoxy group having 1 to 20 carbon atoms; and "n₁", "n₂", and "n₃" each represent an integer that satisfy n₂ ≥ 1, n₂ ≥ 0, n₃ ≥ 1, and n₁ + n₂ + n₃ = 4, when n₁ ≥ 2, the Ts being identical to or different from each other, when n₂ = 2, the Ps being identical to or different from each other, and when n₃ ≥ 2, the Qs being identical to or different from each other, 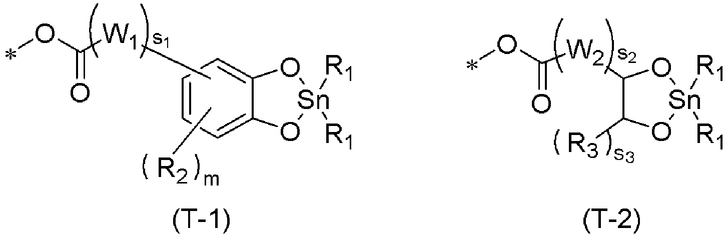 wherein R₁ represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, or a substituted or unsubstituted arylalkyl group having 7 to 31 carbon atoms; "*" represents an attachment point to the Sn atom in the general formula (M); W₁ represents a substituted or unsubstituted, linear, branched, or cyclic, saturated or unsaturated hydrocarbon group, optionally including an aromatic ring group, having 1 to 40 carbon atoms, the hydrocarbon group optionally containing any heteroatom of an oxygen atom, a nitrogen atom, or a sulfur atom, and forming an ether bond, a carbonyl group, an ester group, or an amide group, and optionally forming a heterocyclic structure via the heteroatom; R₂ represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a hydroxy group, an amino group, or a halogen atom; "s₁" represents an integer of 0 or 1; "m" represents an integer of 0 or 1; W₂ represents a substituted or unsubstituted, linear, branched, or cyclic, saturated or unsaturated hydrocarbon group, optionally including an aromatic ring group, having 1 to 40 carbon atoms, the hydrocarbon group optionally containing any heteroatom of an oxygen atom, a nitrogen atom, or a sulfur atom, and forming an ether bond, a carbonyl group, an ester group, or an amide group, and optionally forming a heterocyclic structure via the heteroatom; "s₂" represents an integer of 0 or 1; "s₃" represents 1 or 2, when "s₃" is 1, R₃ being a hydrogen atom or a hydrocarbon group having 1 to 10 carbon atoms and having a hydroxy group, and when "s₃" is 2, the R₃ being an oxygen atom forming a carbonyl group together with the carbon atom bonded thereto; and the W₂ and the R₃ are optionally bonded to each other to form a cyclic structure.
[2]: The compound for forming a metal-containing film of [1], wherein the W₁ in the general formula (T-1) is: a linear, branched, or cyclic, saturated or unsaturated hydrocarbon group having 1 to 10 carbon atoms and optionally containing a hydroxy group or an amino group, optionally the hydrocarbon group including an aromatic ring group, the hydrocarbon group optionally containing an oxygen atom, a nitrogen atom, or a sulfur atom and forming an ether bond, a carbonyl group, or an ester group; or any one of groups represented by the following general formulae (W₁-1) to (W₁-4), 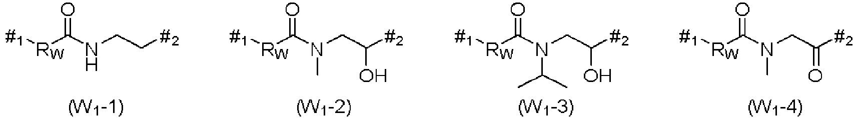 wherein R_{W} represents a divalent organic group having 1 to 23 carbon atoms, "#₁" represents an attachment point to the ester group, and "#₂" represents an attachment point to the benzene ring.
[3]: The compound for forming a metal-containing film of [1] or [2], wherein the W₂ in the general formula (T-2) is: a linear, branched, or cyclic, saturated or unsaturated hydrocarbon group having 1 to 10 carbon atoms and optionally containing a hydroxy group or an amino group, optionally the hydrocarbon group including an aromatic ring group, or a cyclic hydrocarbon group bonded to the R₃, the hydrocarbon group optionally containing an oxygen atom, a nitrogen atom, or a sulfur atom and forming an ether bond, a carbonyl group, or an ester group; or any one of groups represented by the following general formulae (W₂-1) to (W₂-4), 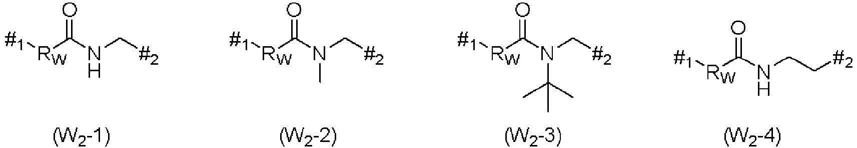 wherein R_{W} represents a divalent organic group having 1 to 23 carbon atoms, and "#₁" and "#₂" respectively represent an attachment point to the ester group and the carbon atom.
[4]: The compound for forming a metal-containing film of [2], wherein the R_{W} in the general formulae (W₁-1) to (W₂-4) is an unsaturated hydrocarbon group having 2 to 23 carbon atoms.
[5] : The compound for forming a metal-containing film of [4], wherein the R_{W} is a group represented by any one of the following general formulae (1), 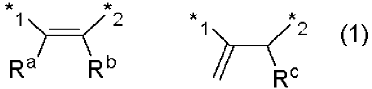 wherein R^{a}, R^{b}, and R^{c} each represent a hydrogen atom or a monovalent organic group having 1 to 20 carbon atoms, R^{a} and R^{b} optionally being bonded to each other to form a cyclic substituent; and "*1" and "*2" each represent an attachment point to the carbonyl group, "*1" and "*2" optionally being reversed.
[6]: The compound for forming a metal-containing film of [3], wherein the R_{W} in the general formulae (W₂-1) to (W₂-4) is an unsaturated hydrocarbon group having 2 to 23 carbon atoms.
[7]: The compound for forming a metal-containing film of [6], wherein the R_{W} is a group represented by one of the following general formulae (1), 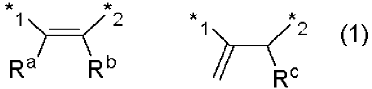 wherein R^{a}, R^{b}, and R^{c} each represent a hydrogen atom or a monovalent organic group having 1 to 20 carbon atoms, R^{a} and R^{b} optionally being bonded to each other to form a cyclic substituent; and "*1" and "*2" each represent an attachment point to the carbonyl group, "*1" and "*2" optionally being reversed.
[8]: The compound for forming a metal-containing film of any one of [1] to [7], wherein in the general formula (M), "n₂" is 1 and the R in the *OCOR of the P is any one of groups represented by the following general formulae (A-1) to (A-4), the following general formula (3), and the following general formula (4), 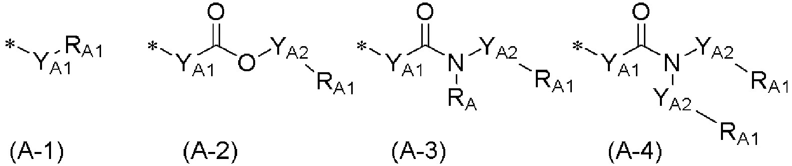 wherein Y_{A1} and Y_{A2} are each identical to or different from each other and represent a substituted or unsubstituted saturated divalent organic group having 1 to 23 carbon atoms, a substituted or unsubstituted unsaturated divalent organic group having 2 to 23 carbon atoms, a substituted or unsubstituted arylene group having 6 to 30 carbon atoms, or a substituted or unsubstituted arylalkylene group having 7 to 31 carbon atoms; R_{A} represents a hydrogen atom, a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms; R_{A1} represents an organic group whose protecting group is to be removed by an action of an acid, heat, or both to generate one or more hydroxy groups or carboxy groups, R_{A1} being represented by one of the following general formulae (2); and "*" represents an attachment point to the carbonyl group, 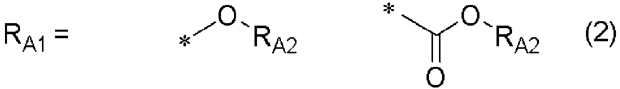 wherein R_{A2} represents an organic group whose protecting group is to be removed by an action of an acid, heat, or both; and "*" represents an attachment point to Y_{A1} or Y_{A2}, 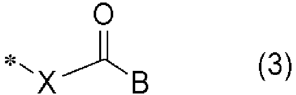 wherein X represents a divalent organic group having 1 to 31 carbon atoms; B represents the following general formula (B); and "*" represents an attachment point to the carbonyl group,

   B= *-YB-R_{B} (B)

   wherein Y_{B} represents a substituted or unsubstituted saturated divalent organic group having 1 to 20 carbon atoms, a substituted or unsubstituted unsaturated divalent organic group having 2 to 20 carbon atoms, a substituted or unsubstituted divalent arylene group having 6 to 30 carbon atoms, or a substituted or unsubstituted divalent arylalkylene group having 7 to 31 carbon atoms; R_{B} represents a hydroxy group or any one of structures represented by the following general formulae (B-1) to (B-3), 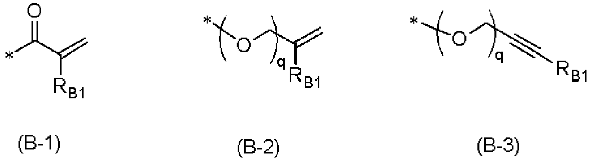 wherein R_{B1} represents a hydrogen atom or a monovalent organic group having 1 to 10 carbon atoms; "q" represents 0 or 1; and "*" represents an attachment point to Y_{B}, 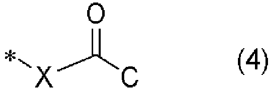 wherein X represents a divalent organic group having 1 to 31 carbon atoms; C represents any one of groups represented by the following general formulae (C-1) to (C-4); and "*" represents an attachment point to the carbonyl group, 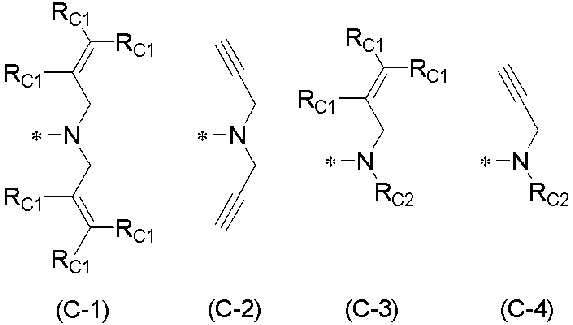 wherein R_{c1}s each represent a hydrogen atom or a methyl group and are identical to or different from each other in a single formula; R_{c2} represents a hydrogen atom, a substituted or unsubstituted, saturated or unsaturated monovalent organic group having 1 to 20 carbon atoms, a substituted or unsubstituted aryl group having 6 to 30 carbon atoms, a substituted or unsubstituted arylalkyl group having 7 to 31 carbon atoms; and "*" represents an attachment point to the carbonyl group.
[9]: The compound for forming a metal-containing film of [8], wherein the Y_{A1} in the general formulae (A-1) to (A-4), the X in the general formula (3), or the X in the general formula (4) is an unsaturated hydrocarbon group having 2 to 23 carbon atoms.
[10]: The compound for forming a metal-containing film of [9], wherein the Y_{A1} in the general formulae (A-1) to (A-4), the X in the general formula (3), or the X in the general formula (4) is a group represented by one of the following general formulae (1), 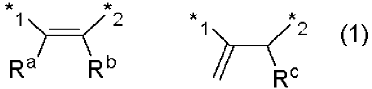 wherein R^{a}, R^{b}, and R^{c} each represent a hydrogen atom or a monovalent organic group having 1 to 20 carbon atoms, R^{a} and R^{b} optionally being bonded to each other to form a cyclic substituent; and "*1" and "*2" each represent an attachment point to the carbonyl group, "*1" and "*2" optionally being reversed.
[11]: A composition for forming a metal-containing film, the composition functioning as a resist underlayer film material used in manufacturing a semiconductor, the composition comprising: (a) the compound for forming a metal-containing film according to any one of [1] to [10]; and (b) an organic solvent.
[12]: The composition for forming a metal-containing film of [11], wherein the composition is usable as a resist underlayer film used in a multilayer resist method, the composition further comprising one or more of (c) a crosslinking agent, (d) a surfactant, (e) a flowability accelerator, and (f) an acid generator.
[13]: The composition for forming a metal-containing film of [11] or [12], wherein the organic solvent (b) is a mixture of one or more kinds of organic solvent having a boiling point of lower than 180°C and one or more kinds of organic solvent having a boiling point of 180°C or higher.
[14]: A patterning process for forming a pattern in a substrate to be processed, comprising the steps of:
   (I-1) applying the composition for forming a metal-containing film of any one of [11] to [13] onto a substrate to be processed, followed by heating to form a metal-containing film;
   (I-2) forming a resist upper layer film on the metal-containing film by using a photoresist material;
   (I-3) subjecting the resist upper layer film to pattern exposure and then development with a developer to form a pattern in the resist upper layer film;
   (I-4) transferring the pattern to the metal-containing film by dry etching while using the resist upper layer film having the formed pattern as a mask; and
   (I-5) processing the substrate to be processed while using the metal-containing film having the formed pattern as a mask to form the pattern in the substrate to be processed.
[15]: A patterning process for forming a pattern in a substrate to be processed, comprising the steps of:
   (II-1) applying the composition for forming a metal-containing film of any one of [11] to [13] onto a substrate to be processed, followed by heating to form a metal-containing film;
   (II-2) forming a resist middle layer film on the metal-containing film;
   (II-3) forming a resist upper layer film on the resist middle layer film by using a photoresist material;
   (II-4) subjecting the resist upper layer film to pattern exposure and then development with a developer to form a pattern in the resist upper layer film;
   (II-5) transferring the pattern to the resist middle layer film by dry etching while using the resist upper layer film having the formed pattern as a mask;
   (II-6) transferring the pattern to the metal-containing film by dry etching while using the resist middle layer film having the transferred pattern as a mask; and
   (II-7) processing the substrate to be processed while using the metal-containing film having the formed pattern as a mask to form the pattern in the substrate to be processed.
[16]: A patterning process for forming a pattern in a substrate to be processed, comprising the steps of:
   (III-1) applying the composition for forming a metal-containing film of any one of [11] to [13] onto a substrate to be processed, followed by heating to form a metal-containing film;
   (III-2) forming an inorganic hard mask middle layer film selected from a silicon oxide film, a silicon nitride film, and a silicon oxynitride film on the metal-containing film;
   (III-3) forming an organic thin film on the inorganic hard mask middle layer film;
   (III-4) forming a resist upper layer film on the organic thin film by using a photoresist material;
   (III-5) subjecting the resist upper layer film to pattern exposure and then development with a developer to form a pattern in the resist upper layer film;
   (III-6) transferring the pattern to the organic thin film and the inorganic hard mask middle layer film by dry etching while using the resist upper layer film having the formed pattern as a mask;
   (III-7) transferring the pattern to the metal-containing film by dry etching while using the inorganic hard mask middle layer film having the transferred pattern as a mask; and
   (III-8) processing the substrate to be processed while using the metal-containing film having the formed pattern as a mask to form the pattern in the substrate to be processed.
[17]: A patterning process for forming a pattern in a substrate to be processed, comprising the steps of:
   (IV-1) forming a resist underlayer film on a substrate to be processed;
   (IV-2) applying the composition for forming a metal-containing film of any one of [11] to [13] onto the resist underlayer film, followed by heating to form a metal-containing film;
   (IV-3) forming a resist upper layer film on the metal-containing film by using a photoresist material or forming an organic adhesive film on the metal-containing film by spin-coating and forming a resist upper layer film on the organic adhesive film by using a photoresist material;
   (IV-4) subjecting the resist upper layer film to pattern exposure and then development with a developer to form a pattern in the resist upper layer film;
   (IV-5) transferring the pattern to the metal-containing film or the organic adhesive film and the metal-containing film by dry etching while using the resist upper layer film having the formed pattern as a mask;
   (IV-6) transferring the pattern to the resist underlayer film by dry etching while using the metal-containing film having the transferred pattern as a mask; and
   (IV-7) processing the substrate to be processed while using the resist underlayer film having the formed pattern as a mask to form the pattern in the substrate to be processed.
[18]: A patterning process for forming a pattern in a substrate to be processed, comprising the steps of:
   (V-1) forming a resist underlayer film on a substrate to be processed;
   (V-2) forming a resist middle layer film or a combination of an organic thin film and an inorganic hard mask middle layer film selected from a silicon oxide film, a silicon nitride film, and a silicon oxynitride film on the resist underlayer film;
   (V-3) forming a resist upper layer film on the resist middle layer film or the combination of the organic thin film and the inorganic hard mask middle layer film by using a photoresist material;
   (V-4) subjecting the resist upper layer film to pattern exposure and then development with a developer to form a pattern in the resist upper layer film;
   (V-5) transferring the pattern to the resist middle layer film or the organic thin film and the inorganic hard mask middle layer film by dry etching while using the resist upper layer film having the formed pattern as a mask;
   (V-6) transferring the pattern to the resist underlayer film by dry etching while using the resist middle layer film or the inorganic hard mask middle layer film having the transferred pattern as a mask;
   (V-7) applying the composition for forming a metal-containing film of any one of [11] to [13] onto the resist underlayer film having the formed pattern, followed by heating to cover the resist underlayer film with a metal-containing film, thereby filling a space between the resist underlayer film patterns with the metal-containing film;
   (V-8) etching back the metal-containing film covering the resist underlayer film having the formed pattern by a chemical stripper or dry etching to expose an upper surface of the resist underlayer film having the formed pattern;
   (V-9) removing the resist middle layer film or the inorganic hard mask middle layer film remaining on the upper surface of the resist underlayer film by dry etching;
   (V-10) removing, by dry etching, the resist underlayer film having the formed pattern with an exposed surface to form a reverse pattern of an original pattern on the metal-containing film; and
   (V-11) processing the substrate to be processed while using the metal-containing film having the formed reverse pattern as a mask to form the reverse pattern in the substrate to be processed.
[19]: The patterning process of [16] or [18], wherein the inorganic hard mask middle layer film is formed by a CVD method or an ALD method.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A compound for forming a metal-containing film, represented by the following general formula (M), 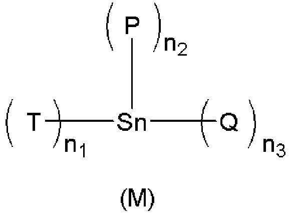 wherein T independently represents the following general formula (T-1) or (T-2); P independently represents *OCOR, "*" representing an attachment point to the Sn atom and R representing a monovalent organic group; Q independently represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, a halogen atom, or an alkoxy group having 1 to 20 carbon atoms; and "n₁", "n₂", and "n₃" each represent an integer that satisfy n₁ ≥ 1, n₂ ≥ 0, n₃ ≥ 1, and n₁ + n₂ + n₃ = 4, when n₁ ≥ 2, the Ts being identical to or different from each other, when n₂ = 2, the Ps being identical to or different from each other, and when n₃ ≥ 2, the Qs being identical to or different from each other, 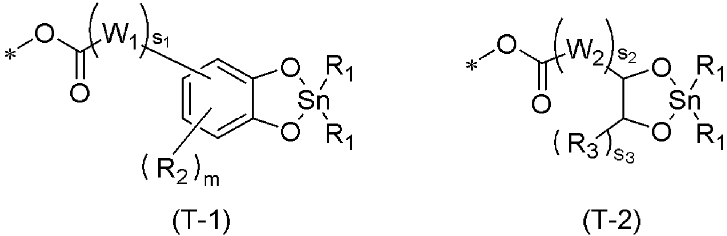 wherein R₁ represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, or a substituted or unsubstituted arylalkyl group having 7 to 31 carbon atoms; "*" represents an attachment point to the Sn atom in the general formula (M); W₁ represents a substituted or unsubstituted, linear, branched, or cyclic, saturated or unsaturated hydrocarbon group, optionally including an aromatic ring group, having 1 to 40 carbon atoms, the hydrocarbon group optionally containing any heteroatom of an oxygen atom, a nitrogen atom, or a sulfur atom, and forming an ether bond, a carbonyl group, an ester group, or an amide group, and optionally forming a heterocyclic structure via the heteroatom; R₂ represents a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a hydroxy group, an amino group, or a halogen atom; "s₁" represents an integer of 0 or 1; "m" represents an integer of 0 or 1; W₂ represents a substituted or unsubstituted, linear, branched, or cyclic, saturated or unsaturated hydrocarbon group, optionally including an aromatic ring group, having 1 to 40 carbon atoms, the hydrocarbon group optionally containing any heteroatom of an oxygen atom, a nitrogen atom, or a sulfur atom, and forming an ether bond, a carbonyl group, an ester group, or an amide group, and optionally forming a heterocyclic structure via the heteroatom; "s₂" represents an integer of 0 or 1; "s₃" represents 1 or 2, when "s₃" is 1, R₃ being a hydrogen atom or a hydrocarbon group having 1 to 10 carbon atoms and having a hydroxy group, and when "s₃" is 2, the R₃ being an oxygen atom forming a carbonyl group together with the carbon atom bonded thereto; and the W₂ and the R₃ are optionally bonded to each other to form a cyclic structure.

2. The compound for forming a metal-containing film according to claim 1, wherein the W₁ in the general formula (T-1) is: a linear, branched, or cyclic, saturated or unsaturated hydrocarbon group having 1 to 10 carbon atoms and optionally containing a hydroxy group or an amino group, optionally the hydrocarbon group including an aromatic ring group, the hydrocarbon group optionally containing an oxygen atom, a nitrogen atom, or a sulfur atom and forming an ether bond, a carbonyl group, or an ester group; or any one of groups represented by the following general formulae (W₁-1) to (W₁-4), 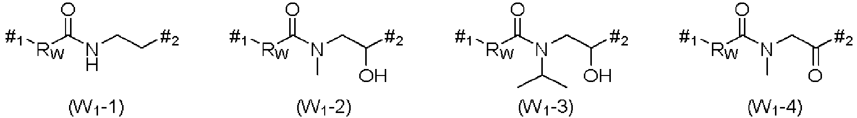 wherein R_{W} represents a divalent organic group having 1 to 23 carbon atoms, "#₁" represents an attachment point to the ester group, and "#₂" represents an attachment point to the benzene ring.

3. The compound for forming a metal-containing film according to claim 1 or claim 2, wherein the W₂ in the general formula (T-2) is: a linear, branched, or cyclic, saturated or unsaturated hydrocarbon group having 1 to 10 carbon atoms and optionally containing a hydroxy group or an amino group, optionally the hydrocarbon group including an aromatic ring group, or a cyclic hydrocarbon group bonded to the R₃, the hydrocarbon group optionally containing an oxygen atom, a nitrogen atom, or a sulfur atom and forming an ether bond, a carbonyl group, or an ester group; or any one of groups represented by the following general formulae (W₂-1) to (W₂-4), 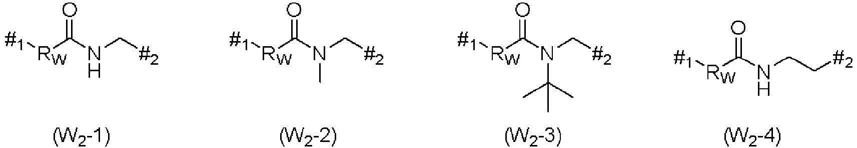 wherein R_{W} represents a divalent organic group having 1 to 23 carbon atoms, and "#₁" and "#₂" respectively represent an attachment point to the ester group and the carbon atom.

4. The compound for forming a metal-containing film according to claim 2, wherein the R_{W} in the general formulae (W₁-1) to (W₂-4) is an unsaturated hydrocarbon group having 2 to 23 carbon atoms.

5. The compound for forming a metal-containing film according to claim 4, wherein the R_{W} is a group represented by any one of the following general formulae (1), 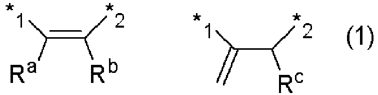 wherein R^{a}, R^{b}, and R^{c} each represent a hydrogen atom or a monovalent organic group having 1 to 20 carbon atoms, R^{a} and R^{b} optionally being bonded to each other to form a cyclic substituent; and "*1" and "*2" each represent an attachment point to the carbonyl group, "*1" and "*2" optionally being reversed.

6. The compound for forming a metal-containing film according to claim 3, wherein the R_{W} in the general formulae (W₂-1) to (W₂-4) is an unsaturated hydrocarbon group having 2 to 23 carbon atoms.

7. The compound for forming a metal-containing film according to claim 6, wherein the R_{W} is a group represented by one of the following general formulae (1), 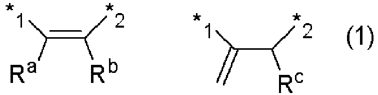 wherein R^{a}, R^{b}, and R^{c} each represent a hydrogen atom or a monovalent organic group having 1 to 20 carbon atoms, R^{a} and R^{b} optionally being bonded to each other to form a cyclic substituent; and "*1" and "*2" each represent an attachment point to the carbonyl group, "*1" and "*2" optionally being reversed.

8. The compound for forming a metal-containing film according to any one of claims 1 to 7, wherein in the general formula (M), "n₂" is 1 and the R in the *OCOR of the P is any one of groups represented by the following general formulae (A-1) to (A-4), the following general formula (3), and the following general formula (4), 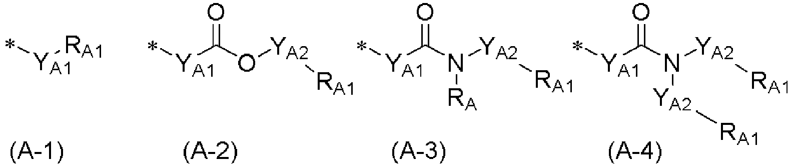 wherein Y_{A1} and Y_{A2} are each identical to or different from each other and represent a substituted or unsubstituted saturated divalent organic group having 1 to 23 carbon atoms, a substituted or unsubstituted unsaturated divalent organic group having 2 to 23 carbon atoms, a substituted or unsubstituted arylene group having 6 to 30 carbon atoms, or a substituted or unsubstituted arylalkylene group having 7 to 31 carbon atoms; R_{A} represents a hydrogen atom, a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms; R_{A1} represents an organic group whose protecting group is to be removed by an action of an acid, heat, or both to generate one or more hydroxy groups or carboxy groups, R_{A1} being represented by one of the following general formulae (2); and "*" represents an attachment point to the carbonyl group, 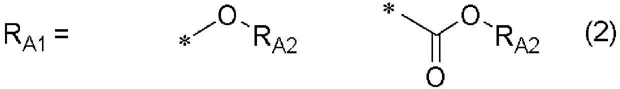 wherein R_{A2} represents an organic group whose protecting group is to be removed by an action of an acid, heat, or both; and "*" represents an attachment point to Y_{A1} or Y_{A2}, 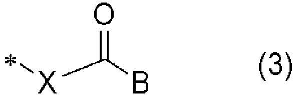 wherein X represents a divalent organic group having 1 to 31 carbon atoms; B represents the following general formula (B); and "*" represents an attachment point to the carbonyl group,
B= *-Y_{B}-R_{B} (B)
wherein Y_{B} represents a substituted or unsubstituted saturated divalent organic group having 1 to 20 carbon atoms, a substituted or unsubstituted unsaturated divalent organic group having 2 to 20 carbon atoms, a substituted or unsubstituted divalent arylene group having 6 to 30 carbon atoms, or a substituted or unsubstituted divalent arylalkylene group having 7 to 31 carbon atoms; R_{B} represents a hydroxy group or any one of structures represented by the following general formulae (B-1) to (B-3), 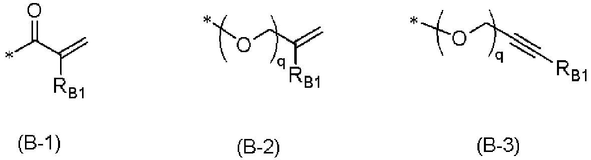 wherein R_{B1} represents a hydrogen atom or a monovalent organic group having 1 to 10 carbon atoms; "q" represents 0 or 1; and "*" represents an attachment point to Y_{B}, 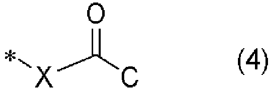 wherein X represents a divalent organic group having 1 to 31 carbon atoms; C represents any one of groups represented by the following general formulae (C-1) to (C-4); and "*" represents an attachment point to the carbonyl group, 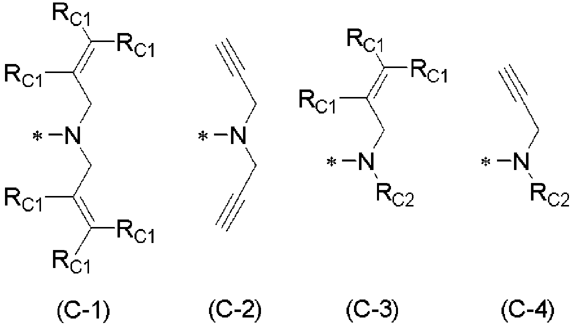 wherein R_{c1}s each represent a hydrogen atom or a methyl group and are identical to or different from each other in a single formula; R_{c2} represents a hydrogen atom, a substituted or unsubstituted, saturated or unsaturated monovalent organic group having 1 to 20 carbon atoms, a substituted or unsubstituted aryl group having 6 to 30 carbon atoms, a substituted or unsubstituted arylalkyl group having 7 to 31 carbon atoms; and "*" represents an attachment point to the carbonyl group.

9. The compound for forming a metal-containing film according to claim 8, wherein the Y_{A1} in the general formulae (A-1) to (A-4), the X in the general formula (3), or the X in the general formula (4) is an unsaturated hydrocarbon group having 2 to 23 carbon atoms.

10. The compound for forming a metal-containing film according to claim 9, wherein the Y_{A1} in the general formulae (A-1) to (A-4), the X in the general formula (3), or the X in the general formula (4) is a group represented by one of the following general formulae (1), 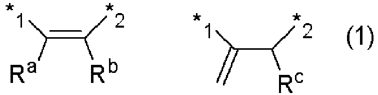 wherein R^{a}, R^{b}, and R^{c} each represent a hydrogen atom or a monovalent organic group having 1 to 20 carbon atoms, R^{a} and R^{b} optionally being bonded to each other to form a cyclic substituent; and "*1" and "*2" each represent an attachment point to the carbonyl group, "*1" and "*2" optionally being reversed.

11. A composition for forming a metal-containing film, the composition functioning as a resist underlayer film material used in manufacturing a semiconductor, the composition comprising: (a) the compound for forming a metal-containing film according to any one of claims 1 to 10; and (b) an organic solvent.

12. The composition for forming a metal-containing film according to claim 11, wherein the composition is usable as a resist underlayer film used in a multilayer resist method, the composition further comprising one or more of (c) a crosslinking agent, (d) a surfactant, (e) a flowability accelerator, and (f) an acid generator.

13. The composition for forming a metal-containing film according to claim 11 or claim 12, wherein the organic solvent (b) is a mixture of one or more kinds of organic solvent having a boiling point of lower than 180°C and one or more kinds of organic solvent having a boiling point of 180°C or higher.

14. A patterning process for forming a pattern in a substrate to be processed, comprising the steps of: 14A)
(I-1) applying the composition for forming a metal-containing film according to any one of claims 11 to 13 onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed; or 14B)
(II-1) applying the composition for forming a metal-containing film according to any one of claims 11 to 13 onto a substrate to be processed, followed by heating to form a metal-containing film;
(II-2) forming a resist middle layer film on the metal-containing film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal-containing film by dry etching while using the resist middle layer film having the transferred pattern as a mask; and
(II-7) processing the substrate to be processed while using the metal-containing film having the formed pattern as a mask to form the pattern in the substrate to be processed; or 14C)
(III-1) applying the composition for forming a metal-containing film according to any one of claims 11 to 13 onto a substrate to be processed, followed by heating to form a metal-containing film;
(III-2) forming an inorganic hard mask middle layer film selected from a silicon oxide film, a silicon nitride film, and a silicon oxynitride film on the metal-containing film, optionally the inorganic hard mask middle layer film being formed by a CVD method or an ALD method;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed; or
14D)
(IV-1) forming a resist underlayer film on a substrate to be processed;
(IV-2) applying the composition for forming a metal-containing film according to any one of claims 11 to 13 onto the resist underlayer film, followed by heating to form a metal-containing film;
(IV-3) forming a resist upper layer film on the metal-containing film by using a photoresist material or forming an organic adhesive film on the metal-containing film by spin-coating and forming a resist upper layer film on the organic adhesive film by using a photoresist material;
(IV-4) subjecting the resist upper layer film to pattern exposure and then development with a developer to form a pattern in the resist upper layer film;
(IV-5) transferring the pattern to the metal-containing film or the organic adhesive film and the metal-containing film by dry etching while using the resist upper layer film having the formed pattern as a mask;
(IV-6) transferring the pattern to the resist underlayer film by dry etching while using the metal-containing film having the transferred pattern as a mask; and
(IV-7) processing the substrate to be processed while using the resist underlayer film having the formed pattern as a mask to form the pattern in the substrate to be processed.

15. A patterning process for forming a pattern in a substrate to be processed, comprising the steps of:
(V-1) forming a resist underlayer film on a substrate to be processed;
(V-2) forming a resist middle layer film or a combination of an organic thin film and an inorganic hard mask middle layer film selected from a silicon oxide film, a silicon nitride film, and a silicon oxynitride film on the resist underlayer film, optionally the inorganic hard mask middle layer film being formed by a CVD method or an ALD method;
(V-3) forming a resist upper layer film on the resist middle layer film or the combination of the organic thin film and the inorganic hard mask middle layer film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the composition for forming a metal-containing film according to any one of claims 11 to 13 onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing, by dry etching, the resist underlayer film having the formed pattern with an exposed surface to form a reverse pattern of an original pattern on the metal-containing film; and
(V-11) processing the substrate to be processed while using the metal-containing film having the formed reverse pattern as a mask to form the reverse pattern in the substrate to be processed.
